(19) Europäisches Patentamt
European Patent Office
Office européen des brevets

(11) EP 2 009 801 A2

(12) # DEMANDE DE BREVET EUROPEEN

(43) Date de publication:
**31.12.2008 Bulletin 2009/01**

(51) Int Cl.:
***H03M 7/30*** *(2006.01)*

(21) Numéro de dépôt: **08165511.0**

(22) Date de dépôt: **13.02.2007**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK RS**

(30) Priorité: **17.02.2006 FR 0601435**

(62) Numéro(s) de document de la (des) demande(s) initiale(s) en application de l'article 76 CBE:
**07731603.2 / 2 002 546**

(71) Demandeur: **France Télécom**
**75015 Paris Cedex 15 (FR)**

(72) Inventeurs:
- **Ragot, Stéphane**
  **22700 Perros-Guirec (FR)**
- **Lamblin, Claude**
  **22700 Perros-Guirec (FR)**

(74) Mandataire: **Cabinet Plasseraud**
**52 rue de la Victoire**
**75440 Paris Cedex 09 (FR)**

Remarques:
Cette demande a été déposée le 30-09-2008 comme demande divisionnaire de la demande mentionnée sous le code INID 62.

(54) **Codage/décodage perfectionnés de signaux numériques, en particulier en quantification vectorielle avec codes à permutation**

(57) L'invention concerne le codage/décodage de signaux numériques, utilisant en particulier des codes à permutation faisant intervenir un calcul d'expressions combinatoires. Selon l'invention, ces expressions combinatoires sont représentées par des décompositions en puissances de facteurs premiers, et déterminées par une lecture mémoire de représentations préenregistrées de décompositions de nombres entiers choisis.

EP 2 009 801 A2

## Description

La présente invention concerne le codage/décodage de signaux numériques tels que des signaux audio, vidéo, et plus généralement les signaux multimédia pour leur stockage ou leur transmission. Elle propose en particulier une solution aux problèmes que posent le codage et le décodage de codes à permutations.

Typiquement, la présente invention s'applique aussi au dual du codage de source : le codage canal ou "modulation".

Le codage/décodage en compression de signaux numériques au sens de l'invention peut être très utile pour la quantification des coefficients de transformée des codeurs fréquentiels des signaux de parole et/ou audio.

## Quantification vectorielle

Une solution très répandue en compression des signaux numériques est la quantification vectorielle. La quantification vectorielle représente un vecteur d'entrée par un vecteur de même dimension choisi dans un ensemble fini. Un quantificateur à *M* niveaux (ou "vecteurs-codes") est une application non bijective de l'ensemble des vecteurs d'entrée, généralement l'espace réel euclidien à n dimensions $R^n$ ou un sous-ensemble de $R^n$ dans un sous-ensemble fini Y de $R^n$ à *M* éléments distincts: $Y = \{y_0, y_1, \dots y_{M-1}\}$.

Y est appelé alphabet de reproduction ou "dictionnaire" ou encore "répertoire", et ses éléments des vecteurs-codes, des "mots de code" (ou "points de sortie" ou encore "représentants").

Le débit par dimension *r* du quantificateur (ou sa "résolution") est défini par la relation :

$$r = \frac{1}{n}\log_2 M$$

En quantification vectorielle, un bloc de n échantillons est traité comme un vecteur de dimension n. Selon la théorie du codage de source, quand la dimension devient très grande, la performance de la quantification vectorielle approche la borne de débit-distorsion de la source. Les dictionnaires de quantificateurs vectoriels peuvent être conçus à partir de méthodes statistiques telles que l'algorithme de Lloyd généralisé (ou "GLA" pour "Generalized Lloyd Algorithm"), basé sur les conditions nécessaires d'optimalité d'un quantificateur vectoriel. Les quantificateurs vectoriels statistiques ainsi obtenus ne possèdent aucune structure, ce qui rend leur exploration coûteuse en ressources de calculs et de stockage, car la complexité tant du codage que du stockage est proportionnelle à $n2^{nr}$.

En référence à la figure 1A, trois opérations majeures mettent en oeuvre un quantificateur vectoriel : deux au codage et une au décodage. Un vecteur d'entrée est codé (étape COD) en choisissant d'abord un vecteur-code dans un dictionnaire. Il s'agit du vecteur-code qui lui "ressemble" le plus (opération OP1 de la figure 1A). Puis, l'indice de ce vecteur-code est déterminé (étape IND) pour être transmis ou stocké (opération OP2 de la figure 1A). Au décodeur (étape DEC), le vecteur-code est déterminé à partir de son indice (opération OP3 de la figure 1A).

En modulation, on retrouve les trois opérations OP1, OP2 et OP3 de la figure 1A mais dans un ordre différent. En référence à la figure 1B qui illustre cette dualité modulation/quantification, on prévoit le passage d'un index à un vecteur code (étape COD' de la figure 1B correspondant à l'opération OP3 de la figure 1A). Puis, après transmission sur un canal bruité, on recherche le vecteur-code le plus proche du vecteur reçu (étape DEC' de la figure 1B correspondant à l'opération OP1 de la figure 1A). Finalement, le décodage de l'index du vecteur code est la troisième étape (étape IND' de la figure 1B correspondant à l'opération OP2 de la figure 1A).

La croissance exponentielle de la complexité, en fonction de la dimension des vecteurs et du débit, limite l'emploi des quantificateurs vectoriels non structurés à de faibles dimensions et/ou des bas débits pour pouvoir les mettre en oeuvre en temps réel. Pour un quantificateur vectoriel non structuré, la recherche du plus proche voisin (opération OP1) requiert une recherche exhaustive parmi tous les éléments du dictionnaire pour sélectionner l'élément du dictionnaire qui minimise une mesure de distance entre lui et le vecteur d'entrée. Les deux dernières opérations (indexation OP2 et opération inverse OP3) s'effectuent en général par de simples lectures de tables mais sont néanmoins coûteuses en espace mémoire. Pour s'affranchir des contraintes de taille et de dimension, plusieurs variantes de la quantification vectorielle de base ont été étudiées. Elles tentent de remédier à l'absence de structure du dictionnaire et parviennent ainsi à réduire la complexité, mais au détriment de la qualité. Cependant, le compromis performance/complexité est amélioré, ce qui permet d'accroître la plage des résolutions et/ou des dimensions sur laquelle la quantification vectorielle peut être appliquée efficacement en coût. Beaucoup de schémas de quantificateurs vectoriels structurés ont été proposés et, en particulier, le quantificateur vectoriel mettant en oeuvre un "code à permutation" présenté ci-après.

**Codes à permutation**

Dans le quantificateur vectoriel "code à permutation", les vecteurs-codes sont obtenus par permutations des composantes du premier vecteur-code (au sens de l'ordre lexicographique) appelé "leader" (ou encore "vecteur-directeur"). Ces composantes prennent leurs valeurs dans un alphabet $A = \{a_0, a_1, ..., a_{q-1}\}$ de taille $q$ (alphabet $A$ $q$-aire tel que $a_i \neq a_j$ pour $i \neq j$). Les composantes $a_i$ sont des réels (ou entiers). Le poids $w^i$ (où $i$ est un indice allant de 0 à $q$-1) est le nombre de répétitions de la lettre $a_i$ de l'alphabet. Les poids $w^i$ sont des entiers positifs tels que $\sum_{i=0}^{q-1} w^i = n$. Par convention, les valeurs de l'alphabet satisfont $a_0 > a_1 > ... > a_{q-1}$. Les $n$ composantes du leader vont en décroissant de la position 0 à la position ($n$-1). Le vecteur-leader $y_0$ est donc un vecteur de dimension $n$ de la forme :

$$y_0 = \big(\overbrace{a_0,\ldots,a_0}^{w^0},\overbrace{a_1,\ldots,a_1}^{w^1},\ldots,\overbrace{a_{q-1},\ldots,a_{q-1}}^{w^{q-1}}\big) \quad (1)$$

On comprend qu'un ordre différent des composantes pourrait être choisi, par exemple $a_0 < a_1 <... < a_{q-1}$.

Le vecteur leader est appelé "leader signé" et le code à permutation est dit "de type I". Les autres vecteurs-codes sont obtenus par permutations des composantes de $y_0$. Le nombre total $M$ de permutations est :

$$M = \frac{n!}{\prod_{i=0}^{q-1} w^i!} \quad (2)$$

Il existe un autre type de code à permutation (type II). Le vecteur leader a encore la même forme que précédemment mais ses composantes doivent être positives ($a_0 > a_1 >...> a_{q-1} \geq 0$). Les autres vecteurs-codes sont aussi obtenus par permutations des composantes de $y_0$ en leur assignant toutes les combinaisons de signes possibles. Le nombre total $M$ de permutations est :

$$M = 2^h \frac{n!}{\prod_{i=0}^{q-1} w^i!} \quad (3)$$

avec $h=n$ si $a_{q-1}>0$ et $h = n-w^{q-1}$ sinon.

Dans ce cas, le vecteur-leader est aussi appelé leader absolu.

Le quantificateur vectoriel "code à permutation" a été étendu à la composée (ou l'union) de codes à permutation et récemment, cette structure en union de codes à permutation a été généralisée à la quantification vectorielle à dimension et résolution variables (dans le document WO-04/00219 au nom de la Demanderesse). Les codes à permutation ne sont pas seulement utilisés en quantification vectorielle statistique. On les retrouve aussi en quantification vectorielle algébrique, laquelle utilise des dictionnaires fortement structurés, issus de réseaux réguliers de points ou des codes correcteurs d'erreur. Les codes à permutation sont aussi employés en modulation.

L'exploitation de la structure à code permutation permet le développement d'algorithmes de recherche du plus proche voisin (opération OP1 sur la figure 1A) optimaux et rapides. Cependant l'indexation (ou numérotage) des vecteurs-codes (opération OP2 de la figure 1A) et l'opération inverse de décodage (opération OP3 de la figure 1A) nécessitent plus de calculs que dans le cas des quantificateurs vectoriels non structurés.

Il existe plusieurs façons d'énumérer les permutations. L'algorithme de Schalkwijk constitue l'une de ces façons:

"An algorithm for source coding", par Schalkwijk J.P.M, dans IEEE Trans. on Information Theory, vol. IT-18, N°3, pp 395-399, mai 1972.

Utilisant l'analyse combinatoire, ces techniques permettent d'indexer un vecteur-code d'un code à permutation (opération OP2) et aussi d'effectuer l'opération inverse-décodage de l'indice (opération OP3). Parmi les algorithmes d'indexation des permutations, on rappelle ci-dessous l'algorithme de Schalkwijk communément utilisé, par exemple dans les normes :

- [3GPP TS 26.273] (ANSI-C code for the Fixed-point Extended AMR - Wideband (AMR-WB+) codec; V6.1.0 (2005-06) (Release 6)),
- et [3GPP TS 26.304] (Extended Adaptive Multi-Rate - Wideband (AMR-WB+) codec; Floating-point ANSI-C code; V6.3.0 (2005-06) (Release 6), juin 2005).

Calcul du rang d'une permutation au codage (opération OP2 de la figure 1A)

On cherche à ordonner et indexer toutes les permutations possibles des composantes du vecteur y = ($y_0$, $y_1 ..., y_{n-1}$). L'ordre est lexicographique et l'indice est appelé ici "rang". Calculer le rang du vecteur y revient à calculer le rang du vecteur D =($d_0, d_1 ..., d_{n-1}$) associé à y, et tel que $d_k$ vaut une valeur d'indice d si et seulement si $y_k = a_d$.
Par exemple, un vecteur **y**, de dimension n=8, a les composantes suivantes :

$$\mathbf{y} = (4, 2, 4, 0, 0, 4, 4, 2)$$

L'alphabet à $q$ = 3 lettres (composantes de valeurs différentes) est donné par $A$ = {4, 2, 0} avec $a_0 = 4$, $a_1 = 2$ et $a_2 = 0$.
On associe alors au vecteur **y** le vecteur ***D*** = (0, 1, 0, 2, 2, 0, 0, 1) dont les composantes sont simplement les indices des $q$ lettres de l'alphabet $A$.
Les rangs de y et ***D*** sont identiques, mais la définition du vecteur ***D*** permet de se ramener au calcul du rang d'une séquence $D$ ayant ses valeurs dans un ensemble {0, 1, ..., $q$-1} (comportant le même nombre d'éléments que l'alphabet {$a_0$, $a_1$, ..., a$q$-1}).
Les poids des vecteurs y et ***D*** sont identiques puisque les occurrences de leurs composantes respectives sont identiques. On définit également le poids intermédiaire $(w_k^0, w_k^1, \ldots, w_k^{q-1})$ comme le poids du vecteur de composantes ($y_k, y_{k+1} \cdots, y_{n-1}$) et qui correspond donc au vecteur y tronqué en laissant les positions $k$ à $n$-1. Ainsi :

$$w_k^d = \sum_{i=k}^{n-1} \delta(y_i, a_d) = \sum_{i=k}^{n-1} \delta(d_i, d) \qquad (4)$$

où δ($x,y$) est l'opérateur de Kronecker (δ($x,y$)=1 si $x$=$y$ et 0 sinon).

On a : $(w_0^0, w_0^1, \ldots, w_0^{q-1}) = (w^0, w^1, \ldots, w^{q-1})$.

Le rang $t$ du vecteur y peut être calculé, en analyse combinatoire, par la formule :

$$t = \sum_{k=0}^{n-1} \sum_{d=0}^{d_k-1} \frac{(n-1-k)!}{(w_k^d - 1)! \prod_{\substack{i=0 \\ i \neq d}}^{q-1} (w_k^i!)} \text{, avec } \sum_{d=0}^{-1} = 0 \text{ et } (-1)! = \infty \qquad (5)$$

Cette formule peut être simplifiée ainsi :

$$t = \sum_{k=0}^{n-1} \frac{(n-1-k)!}{\prod_{i=0}^{q-1}(w_k^i!)} \left( \sum_{d=0}^{d_k-1} w_k^d \right) = \sum_{k=0}^{n-1} I_k^{d_k} \quad (6)$$

C'est cette dernière formulation qui est souvent utilisée et que l'on adoptera donc ici. Dans la suite, $I_k^{d_k}$ sera appelé "rang partiel d'ordre *k*", avec :

$$I_k^{d_k} = \frac{(n-1-k)!}{\prod_{i=0}^{q-1}(w_k^i!)} \left( \sum_{d=0}^{d_k-1} w_k^d \right) \quad (7)$$

<u>Décodage du rang (opération OP3) : Détermination de la permutation à partir de son index</u>

Le décodage du rang *t* consiste à retrouver le vecteur $\boldsymbol{D} = (d_0, d_1, ..., d_{n-1})$ associé à y. Une méthode de recherche séquentielle des $d_k$ est décrite ci-après. On détermine d'abord la composante $d_0$, puis la composante $d_1$, ... jusqu'à la composante $d_{n-1}$.

* *Détermination de $d_0$ :*

Pour trouver $d_0$ on exploite la formule comportant les inégalités :

$$\frac{(n-1)!}{\prod_{i=0}^{q-1}(w_0^i!)} \left( \sum_{d=0}^{d_0-1} w_0^d \right) \le t < \frac{(n-1)!}{\prod_{i=0}^{q-1}(w_0^i!)} \left( \sum_{d=0}^{d_0} w_0^d \right) \quad (8)$$

Les termes $(n-1)!$, $t$, $\prod_{i=0}^{q-1}(w_0^i!)$ et les valeurs $w_0^d$ pour $d=0,...,q-1$ sont connus.

Pour trouver la valeur de $d_0$, on part de $d_0 = 0$, on incrémente successivement $d_0$ de 1 jusqu'à ce que la formule (8) soit vérifiée. En écrivant la formule (8) avec les rangs partiels, la valeur $d_0$ est telle que :

$$I_0^{d_0} \le t < I_0^{d_0+1} \text{ avec } I_0^{d_0} = \frac{(n-1)!}{\prod_{i=0}^{q-1}(w_0^i!)} \left( \sum_{d=0}^{d_0-1} w_0{}^d \right)$$

* *Détermination de $d_1$:*

Pour trouver $d_1$, on exploite la relation :

$$\frac{(n-2)!}{\prod_{i=0}^{q-1}(w_1^i!)}\left(\sum_{d=0}^{d_1-1} w_1^d\right) \leq t - I_0^{d_0} < \frac{(n-2)!}{\prod_{i=0}^{q-1}(w_1^i!)}\left(\sum_{d=0}^{d_1} w_1^d\right) \quad (9)$$

Les valeurs de $w_1^d$ pour $d$=0,...,$q$-1 se déduisent de celles de $w_0^d$ comme suit :

- $w_1^d = w_0^d - 1$ si $d = d_0$
- et $w_1^d = w_0^d$ si $d \neq d_0$ (on répète alors $w_0^d$ tant que $d$ est différent de $d_0$).

On se ramène au même problème que la détermination de la composante $d_0$. Pour trouver la valeur de $d_1$, on part de $d_1$ = 0 et on incrémente successivement $d_1$ de 1 jusqu'à ce que l'inégalité (9) soit vérifiée $(I_1^{d_1} \leq (t - I_0^{d_0}) < I_1^{d_1+1})$.

** Détermination des autres $d_k$:*

Le calcul des $d_k$ suivants se déduit des cas traités ci-dessus. Pour trouver la valeur de $d_k$, on part de $d_k$ = 0 et on incrémente successivement $d_k$ de 1 jusqu'à ce que l'inégalité $I_k^{d_k} \leq (t - \sum_{k=0}^{k-1} I_k^{d_k}) < I_k^{d_k+1}$ soit vérifiée.

Une fois le vecteur $\boldsymbol{D} = (d_0, ..., d_{n-1})$ décodé, on en déduit le vecteur y par simple transposition d'alphabet.

**ETAT DE LA TECHNIQUE ET PROBLEMES POSES**

L'indexation d'un code à permutation et l'opération inverse sont des opérations complexes. Les algorithmes utilisés exploitent l'analyse combinatoire. L'indexation des combinaisons et l'opération inverse requièrent des divisions de produits de factorielles.

**Complexité de la division**

En dépit des progrès en circuits intégrés et des processeurs de traitement de signal, la division reste une opération complexe. Typiquement, la division d'un nombre entier représenté sur 16 bits par un nombre entier représenté sur 16 bits coûte 18 fois plus que leur multiplication. Le poids de la division d'un nombre entier de 32 bits par un nombre entier de 16 bits est de 32 alors que le poids de leur multiplication est de 5.

**Cadrage des variables**

Le coût de la division n'est pas le seul problème. Le cadrage des variables en est un autre comme l'illustre la table 1 ci-après.

Seules les factorielles des nombres entiers inférieurs ou égaux à 8 peuvent être représentées sur des mots entiers de 16 bits. Pour des nombres plus grands que 12, la représentation des factorielles sur des mots entiers de 32 bits n'est plus possible.

De plus, la complexité des opérations augmente aussi avec le nombre de bits utilisé pour représenter les variables. Ainsi, la division par un entier de 16 bits d'un entier de 32 bits est presque deux fois plus complexe (poids 32) que la division d'un entier de 16 bits (poids 18).

**Table 1: Factorielles des nombres entiers**

| $n$ | $n!$ | $\mathrm{Log}_2(n!)$ |
|---|---|---|
| 0 | 1 | 0 |
| 1 | 1 | 0 |
| 2 | 2 | 1 |
| 3 | 6 | 2.5849625 |
| 4 | 24 | 4.5849625 |
| 5 | 120 | 6.9068906 |
| 6 | 720 | 9.4918531 |
| 7 | 5040 | 12.299208 |
| 8 | 40320 | 15.299208 |
| 9 | 362880 | 18.469133 |
| 10 | 3628800 | 21.7910611 |
| 11 | 39916800 | 25.2504927 |
| 12 | 479001600 | 28.8354552 |
| 13 | 6227020800 | 32.535895 |
| 14 | 87178291200 | 36.3432499 |
| 15 | 1307674368000 | 40.2501405 |
| 16 | 20922789888000 | 44.2501405 |

Des solutions pour réduire la complexité de l'opération OP1 ont été proposées. Le problème de la complexité des opérations OP2 et OP3 est peu traité. Cependant, notamment dans le codeur/décodeur TDAC de la Demanderesse ou dans le codeur 3GPP-AMR-WB+, des simplifications ont été apportées aux algorithmes de codage et de décodage par la formule de Schalkwijk.

**Simplifications de l'énumération des permutations et de l'opération inverse (opérations OP2 et OP3)**

Le calcul du rang $t$ d'une permutation et l'opération inverse ont été accélérés grâce à des simplifications décrites ci-après du calcul des $n$ termes $I_k^{d_k}$, dont on rappelle ci-dessous la définition :

$$I_k^{d_k} = \frac{(n-1-k)!}{\prod_{i=0}^{q-1}(w_k^i!)}\left(\sum_{d=0}^{d_k-1} w_k^d\right),\ (0 \le k \le n-1)$$

Les deux premières servent à réduire la complexité tant du codage que du décodage. La troisième est utilisée au codage et les deux dernières au décodage.

La technique de codage est illustrée sur les figures 2 et 3. En particulier, la figure 3 vise le calcul du rang par la formule de Schalkwijk au sens de l'art antérieur, tandis que la figure 2 illustre des étapes préliminaires (référencées "EP-n", pour $n^{\text{ième}}$ étape préliminaire de la figure 2).

En référence à la figure 2, le traitement commence par l'étape EP-1 à laquelle on récupère les composantes du vecteur $\mathbf{y} = (y_0, ..., y_{n-1})$. L'étape générale EP-2 suivante vise le calcul des éléments de l'alphabet intervenant pour ce vecteur $\boldsymbol{A} = (a_0, ..., a_{q-1})$, ainsi que la détermination de l'indice maximum $q$. Pour ce faire, après une étape d'initialisation EP-21 où l'on fixe $q = 1$, $a_0 = y_0$, on mène une boucle sur l'indice $k$ compris entre 1 et $n$-1 (test de fin EP-26 et incrémentation sinon EP-27) visant à rechercher les éléments $a_q$ comme suit :

- si la composante $y_k$ d'indice courant $k$ n'est pas déjà parmi les éléments $\{a_0, ..., a_{q-1}\}$ (test EP-22), il faut attribuer un nouvel élément $a_q$ tel que $a_q = y_k$ (étape EP-23) à l'ensemble $\{a_0, ..., a_{q-1}\}$ et incrémenter q de 1 (étape EP-25).

L'étape préliminaire générale suivante EP-3 est un calcul du vecteur **D** = $(d_0, ..., d_{n-1})$ comme suit :

- pour $k$ allant de 0 à $n$-1 (étape EP-31 d'initialisation de $k$ à 0, test de fin EP-37 sur $k$ et incrémentation EP-38 sinon), on trouve la valeur $d$ dans l'ensemble des indices (0, ..., $q-1$) tel que $y_k = a_d$ (test EP-33 dans la boucle sur $d$ et incrémentation EP-36 avec $d$=$d$+1 sinon).

En référence à la figure 3, on décrit maintenant les étapes de calcul du rang $t$ qui suivent le traitement préliminaire illustré sur la figure 2. Les étapes illustrées sur la figure 3 sont référencées "CA-n" pour désigner une n[ième] étape de codage au sens de l'art antérieur.

L'étape CA-1 est une initialisation du rang $t$ à 0, de la variable P à 1 (dénominateur intervenant dans le calcul du rang à l'étape CA-13) et des $q$ poids $w_0, ..., w_{q-1}$ à 0.

Ici, on décrémente la valeur de $k$ de $n$-1 à 0 (étape CA-2 d'initialisation de $k$ à n-1, test de fin CA-14 et décrémentation CA-15 sinon). L'intérêt d'un tel choix est décrit plus loin. On utilise ensuite les composantes $d_k$ du vecteur **D** obtenu à l'étape préliminaire EP-3 et on fixe, pour un $k$ courant, d= $d_k$ (étape CA-3). On met à jour le poids associé $w_d$ ($w_d$=$w_d$+1 à l'étape CA-4) pour estimer le terme P (P=Px $w_d$ à l'étape CA-5). On initialise à 0 (étape CA-6) la somme S intervenant au numérateur dans le calcul du rang correspondant à l'étape CA-13 et l'on fait courir ensuite une boucle sur l'indice i des poids $w_i$ (test de fin CA-9 et incrémentation CA-10 sinon, jusqu'à $d$-1) pour mettre à jour la somme S (S=S+$w_i$ à l'étape CA-8). Avant de calculer le rang $t$ à l'étape CA-13, on vérifie que la somme S est non nulle (test CA-11). L'intérêt de cette réalisation est décrit plus loin.

Le calcul du rang $t$ (étape CA-13) fait intervenir le terme factoriel ($n$-$k$-1)! comme suit :

$$t = t + (S/P)\,(n-k-1)!$$

Au lieu de calculer le terme ($n$-$k$-1)! à chaque mise à jour du rang $t$, on préfère pré-enregistrer en mémoire ces valeurs et avoir recours à un simple accès mémoire (étape CA-12) pour obtenir la valeur courante de ($n$-$k$-1)!

Ainsi, certains des avantages du traitement illustré sur la figure 3 seront repris dans la mise en oeuvre de la présente invention. On précise ces avantages ci-après.

* *Stockage des factorielles*

Pour éviter de calculer les termes ($n$-1-$k$)! et $w_k^i!$ en temps réel, les valeurs des $n$+1 factorielles (0!, 1!, ..., $n$!) sont pré-calculées et stockées. Si la dimension $n$ varie de façon bornée ($n \le n_{max}$) on pré-calcule et on stocke les valeurs 0!, 1!, ..., $n_{max}$!

* *Test sur le cumul des poids intermédiaires pour éviter la division*

Il ne sert à rien de calculer $I_k^{d_k} = \frac{(n-1-k)!}{\prod_{i=0}^{q-1}(w_k^i!)}\left(\sum_{d=0}^{d_k-1} w_k^d\right)$ si le terme $S_k = \sum_{d=0}^{d_k-1} w_k^d$ est nul. Or, ce terme est souvent nul en particulier pour les dernières positions ($k$ proche de $n$-1). En ajoutant un test sur la nullité de ce terme (test CA-11 de la figure 3), on peut éviter une division (et une multiplication). Le calcul d'une division étant nettement plus complexe qu'un test, le gain en complexité est important.

* *Inversion de la boucle sur les positions au codage*

Les poids $w_k^d$ (avec $d$=0,1,..,$q$-1) se déduisent des poids $w_{k+1}^d$ en incrémentant $w_{k+1}^{d_k}$ de 1 et en répétant les autres valeurs $w_{k+1}^d$ pour $d \ne d_k$. On peut alors réaliser une boucle (étapes CA-2, CA-14, CA-15 de la figure 3)

partant de la dernière position ($k = n$-1) du vecteur jusqu'à la première ($k = 0$). Cette boucle "inversée" permet de calculer, après une initialisation à 1, le terme $P_k$ tel que :

$$P_k = \prod_{i=0}^{q-1} (w_k^i!),$$

avec seulement une incrémentation et une multiplication par itération, soit :

$$w_k^{d_k} = w_{k+1}^{d_k} + 1$$

$$\text{et } P_k = w_k^{d_k} \times P_{k+1} \qquad \left(\prod_{i=0}^{q-1} (w_k^i!) = w_k^{d_k} \times \prod_{i=0}^{q-1} (w_{k+1}^i!)\right)$$

On peut, de plus, traiter les deux dernières positions à part ($k = n$-1 et $k = n$-2). En effet,

■ pour la dernière position ($k = n$-1),

$$\sum_{d=0}^{d_{n-1}-1} w_{n-1}^d = 0 \text{ donc } I_{n-1}^{d_{n-1}} = 0$$

■ pour l'avant-dernière position ($k = n$-2),
si

$$d_{n-2} > d_{n-1}, \ \sum_{d=0}^{d_{n-2}-1} w_{n-2}^d = 1 \text{ et } P_{n-2} = \prod_{i=0}^{q-1} (w_{n-1}^i!) = 1! \cdot 1! \cdot \prod_{i=0}^{q-3} (0!) = 1 \text{ et (n-1-k)!=1!,}$$

donc

$$I_{n-2}^{d_{n-2}} = 1,$$

sinon

$$(d_{n-2} \le d_{n-1}), \ \sum_{d=0}^{d_{n-2}-1} w_{n-2}^d = 0 \text{ donc } I_{n-2}^{d_{n-2}} = 0 \text{ avec } P_{n-2} = 2 \text{ si } d_{n-2} = d_{n-1}$$

et

$$P_{n-2} = 1$$

sinon.

D'autres détails de réalisation avantageux, décrits ci-après, peuvent aussi être prévus.

* *Suppression d'une division au décodage*

Afin d'éviter des divisions au décodage lors de la recherche de $d_0$, l'inégalité (8) peut être reformulée sous la forme :

$$(n-1)!\times\left(\sum_{d=0}^{d_0-1} w_0^d\right)\leq t\times\prod_{i=0}^{q-1}(w_0^i!)<(n-1)!\times\left(\sum_{d=0}^{d_0} w_0^d\right)$$

De même, on supprime les divisions lors de la recherche de $d_1$ en reformulant l'inégalité (9) sous la forme :

$$(n-2)!\times\left(\sum_{d=0}^{d_1-1} w_1^d\right)\leq(t-I_0^{d_0})\times\prod_{i=0}^{q-1}(w_1^i!)<(n-2)!\times\left(\sum_{d=0}^{d_1} w_1^d\right)$$

ou encore :

$$0\leq(t-I_0^{d_0})\times\prod_{i=0}^{q-1}(w_1^i!)-(n-2)!\times\left(\sum_{d=0}^{d_1-1} w_1^d\right)<(n-2)!\times w_1^{d_1}$$

Il faut noter que s'il est ainsi possible de supprimer les divisions lors de la recherche des $d_k$ ($0\leq k\leq n-1$), il faut toujours effectuer ($n$-1) divisions pour calculer les $I_k^{d_k}$ ($0\leq k\leq n-3$).

* *Test sur les poids au décodage*

Dans les dernières positions, pour certaines valeurs de $d$, $w_k^d=0$ (pour les $w_0^d$ composantes de valeur $d$ occupant des positions précédant la position $k$). Il est donc inutile de calculer les termes des inégalités (8) et (9) pour ces valeurs de $d$.

**Autre problème de l'art antérieur : le cadrage des variables**

Le problème du cadrage des variables a été abordé dans le codeur TDAC de la Demanderesse.

Une première solution a consisté à distinguer les traitements des dimensions supérieures à 12 de ceux des plus petites dimensions. Pour les petites dimensions ($n$<12), les calculs sont effectués sur des entiers non signés sur 32 bits. Pour les plus grandes dimensions, des variables flottantes en double précision sont utilisées au prix d'un accroissement de la complexité de calcul (les opérations en double précision flottante coûtent plus cher que leurs équivalents en précision entière) et de la capacité mémoire requise.

De plus, si la précision maximale est limitée à des entiers 32 bits non signés (mise en oeuvre par un processeur en virgule fixe), les factorielles d'entiers supérieurs à 12 ne peuvent pas être pré-stockées directement et les vecteurs de dimension supérieure à 12 doivent être codés à part. Pour résoudre ce problème, une solution plus élaborée utilise une représentation à virgule pseudo flottante par mantisse et exposant des factorielles $n!$ sous la forme $2^j\times r$. Cette décomposition est détaillée dans la table 2 ci-après. Le stockage de $n!$ (pour $n$ inférieur ou égal à 16) se réduit à stocker $r$ avec une précision de 30 bits au maximum ainsi que l'exposant $j$ qui correspond à un simple décalage de bits.

**Table 2: Factorisation des factorielles**

| $n$ | $\log_2 (n!)$ | $2^j$ | $r$ | $\log_2 r$ |
|---|---|---|---|---|
| 0 | 0 | 1 | 1 | 0 |
| 1 | 0 | 1 | 1 | 0 |
| 2 | 1.0000 | 2 | 1 | 0 |
| 3 | 2.5849625 | 2 | 3 | 1.5849625 |
| 4 | 4.5849625 | 8 | 3 | 1.5849625 |
| 5 | 6.9068906 | 8 | 15 | 3.9068906 |
| 6 | 9.4918531 | 16 | 45 | 5.4918531 |
| 7 | 12.299208 | 16 | 315 | 8.29920802 |
| 8 | 15.299208 | 128 | 315 | 8.29920802 |
| 9 | 18.469133 | 128 | 2835 | 11.469133 |
| 10 | 21.7910611 | 256 | 14175 | 13.7910611 |
| 11 | 25.2504927 | 256 | 155925 | 17.2504927 |
| 12 | 28.8354552 | 1024 | 467775 | 18.8354552 |
| 13 | 32.535895 | 1024 | 6081075 | 22.535895 |
| 14 | 36.3432499 | 2048 | 42567525 | 25.3432499 |
| 15 | 40.2501405 | 2048 | 638512875 | 29.2501405 |
| 16 | 44.2501405 | 32768 | 638512875 | 29.2501405 |

Ainsi, les techniques de l'art antérieur, pour la plupart, ne résolvent pas le problème du cadrage des variables en précision limitée, en particulier en virgule fixe. La mise en oeuvre dans le codeur TDAC, même si elle permet de régler le problème de cadrage, n'évite pas de coûteuses divisions de deux entiers. De plus, pour des dimensions élevées, les calculs intermédiaires (par exemple le numérateur et le dénominateur des rangs partiels $I_k^{d_k}$ ) peuvent approcher de la saturation. Dans ce cas, les simplifications présentées ci-avant ne peuvent être utilisées dans le traitement de décodage et il est nécessaire de revenir aux formulations des inégalités (8) et (9), et donc de réintroduire de nombreuses divisions.

Les techniques d'énumération autres que celle de Schalkwijk souffrent des mêmes problèmes. Dès lors qu'elles utilisent aussi l'analyse combinatoire, elles nécessitent le calcul de produits de factorielles ainsi que leurs divisions.

La présente invention vient améliorer la situation.

Elle propose tout d'abord à cet effet un procédé de codage/décodage de signaux numériques, utilisant des codes à permutation faisant intervenir un calcul d'expressions combinatoires, dans lequel ces expressions combinatoires sont représentées par des décompositions en puissances de facteurs premiers, et déterminées par une lecture mémoire de représentations préenregistrées de décompositions de nombres entiers choisis.

La présente invention fournit alors une solution efficace aux problèmes liés aussi bien à l'indexation d'un code à permutation qu'à l'opération inverse. Elle résout, conjointement, les deux problèmes de cadrage des variables et de divisions.

En effet, dans une réalisation avantageuse, les représentations préenregistrées comportent des valeurs représentatives d'exposants, stockées respectivement en correspondance de valeurs représentatives de nombres premiers successifs, pour chacun desdits entiers choisis.

On résout déjà ainsi le problème lié au cadrage des variables de l'art antérieur.

Ce problème de cadrage des variables est d'autant accru lorsqu'il s'agit de manipuler des termes factoriels.

Dans une réalisation avantageuse, pour manipuler les expressions combinatoires lorsqu'elles comportent des valeurs factorielles d'entiers, les représentations préenregistrées comportent au moins des représentations de décompositions de valeurs factorielles.

Cette réalisation permet alors de lever la contrainte de cadrage des variables et, de là, repousser les limites habituellement fixées quant à la dimension $n$ des codes à permutation considérés.

Selon une autre caractéristique avantageuse, l'une au moins desdites expressions combinatoires comporte

un quotient d'un numérateur entier par un dénominateur entier, et ce quotient est représenté par une décomposition de puissances de facteurs premiers, dont chaque puissance est une différence d'exposants respectivement associés au numérateur et au dénominateur et affectés à un même nombre premier.

On résout ainsi le problème lié au calcul de divisions de l'art antérieur, en remplaçant ce calcul par un simple calcul de soustractions.

Dans un premier mode de réalisation, on prévoit un adressage mémoire pour retrouver une décomposition préenregistrée de l'un des entiers choisis précités. A cet effet, la représentation préenregistrée d'un nombre entier choisi est stockée dans une mémoire adressable, un adressage de ladite mémoire donnant une succession d'exposants à affecter à des nombres premiers respectifs pour recomposer l'entier choisi.

Préférentiellement, la représentation préenregistrée d'un nombre entier choisi sera stockée sous la forme d'une succession d'adresses donnant chacune, pour un nombre premier, un exposant à affecter à ce nombre premier pour recomposer l'entier choisi.

On dénommera ci-après cette réalisation selon le premier mode par les termes "représentation éclatée des décompositions".

En variante, dans un second mode de réalisation, les représentations préenregistrées sont stockées sous la forme de mots comportant une succession de groupes de bits, chaque groupe ayant :

- un poids fonction d'un nombre premier, et
- une valeur fonction d'un exposant à associer à ce nombre premier.

Préférentiellement, la détermination des puissances de facteurs premiers s'effectue alors par applications successives d'au moins un masque partiel au mot de bits, avec décalages successifs en fonction des poids des bits et lectures des bits restants.

On dénommera ci-après cette réalisation selon le second mode par les termes "représentation compacte des décompositions".

Le déroulement même du procédé, pour le calcul d'une expression combinatoire, peut de façon générale être mené selon les étapes :

- identification, parmi lesdits nombres entiers choisis, de termes apparaissant dans un produit et/ou un quotient formant ladite expression combinatoire,
- lecture mémoire des exposants intervenant dans les décompositions en facteurs premiers desdits termes,
- addition et/ou respectivement soustraction des exposants lus pour déterminer les exposants intervenant dans la décomposition en puissances de facteurs premiers de ladite expression combinatoire, et, de là, calculer ladite expression combinatoire à partir de sa décomposition en puissances de facteurs premiers.

Pour ce qui concerne le calcul d'un produit à effectuer de façon récurrente et faisant intervenir à chaque récurrence un nouveau terme, il peut être avantageux de stocker temporairement la décomposition d'un calcul de produit effectué pour une récurrence antérieure. Ainsi, si le procédé comporte une étape récurrente de calcul d'un produit faisant intervenir à chaque récurrence un terme se multipliant à un produit déterminé à une récurrence antérieure :

- ledit produit déterminé à une récurrence antérieure est avantageusement conservé en mémoire sous la forme d'une décomposition en puissances de facteurs premiers,
- ledit terme se multipliant au produit est préférentiellement l'un des entiers choisis dont la décomposition est préenregistrée, et
- pour déterminer ledit produit à une récurrence courante, il suffit d'additionner, un à un par nombre premier, les exposants issus des décompositions respectives dudit produit déterminé à une récurrence antérieure et dudit terme se multipliant au produit.

De même, si le procédé comporte une étape récurrente de calcul d'une division faisant intervenir à chaque récurrence un terme divisant un quotient déterminé à une récurrence antérieure :

- ledit quotient déterminé à une récurrence antérieure est avantageusement conservé en mémoire sous la forme d'une décomposition en puissances de facteurs premiers,

- ledit terme divisant le quotient est préférentiellement l'un des entiers choisis dont la décomposition est préenregistrée, et

- pour déterminer ladite division à une récurrence courante, on soustrait, un à un par nombre premier, les exposants issus de la décomposition dudit terme aux exposants issus de la décomposition dudit quotient déterminé à une récurrence antérieure.

Ce stockage temporaire des décompositions intermédiaires des produits et/ou des quotients calculés de façon récurrente s'avèrera particulièrement avantageux pour la détermination de rangs partiels récurrents dont le cumul est représentatif d'un rang d'une permutation.

Ainsi, dans une réalisation avantageuse de l'invention, les codes à permutation font intervenir le calcul d'une quantité représentative d'un rang d'une permutation comportant un cumul de rangs partiels, chaque rang partiel correspondant alors à l'une desdites expressions combinatoires.

Le calcul du rang d'une permutation peut alors intervenir, au codage de signaux numériques en quantification vectorielle, pour indexer les permutations des composantes d'un vecteur directeur (opération OP2 de la figure 1A), ces permutations ayant été effectuées à une étape préalable (opération OP1) pour déterminer un vecteur-code le plus proche d'un vecteur d'entrée.

De même, au décodage de signaux numériques en quantification vectorielle, l'estimation d'un rang d'une permutation intervient dès lors qu'à partir d'une valeur donnée d'un rang de permutation :

- on calcule au moins une quantité représentative d'un rang de permutation (opération OP3 de la figure 1A) approchant ladite valeur donnée, en fonction d'au moins une composante présumée d'un vecteur-code à construire,

- on valide le choix de la composante présumée si cette quantité vérifie une condition de proximité avec la valeur donnée du rang.

Dans un exemple de réalisation, cette condition de proximité est vérifiée si la valeur donnée du rang peut être encadrée par des cumuls de rangs partiels jusqu'au rang partiel associé à la composante présumée, d'une part, et jusqu'au rang partiel associé à une composante correspondant à une incrémentation de la composante présumée, d'autre part.

Cette condition de proximité peut donc correspondre à une formulation générale des inégalités (8) décrites ci-avant dans le cas d'une énumération de Schalkwijk.

Ainsi, la présente invention peut s'appliquer avantageusement au codage/décodage de source avec quantification vectorielle au sens de la figure 1A.

Toutefois, le codage/décodage peut aussi être de type codage/décodage de canal, en modulation, au sens de la figure 1B, dès lors qu'il comporte :

- avant transmission, la détermination d'un vecteur-code à partir du rang d'une permutation (même opération OP3 de la figure 1A et de la figure 1B), et

- en réception, le calcul du rang d'une permutation à partir d'un vecteur-code correspondant à un vecteur reçu (même opération OP2 de la figure 1A et de la figure 1B).

Le calcul d'un rang partiel fait intervenir des termes (dans un produit ou un quotient) qui, en règle générale comme on le verra plus loin, restent inférieurs ou égaux à la dimension maximale n des codes à permutation. Ainsi, dans une réalisation avantageuse, les nombres entiers choisis dont les décompositions sont préenregistrées comportent au moins :

- les entiers compris entre 1 et la dimension maximale *n*,

- la valeur factorielle de l'entier 0,

- et, de préférence, les valeurs factorielles des entiers compris entre 1 et la dimension maximale *n*.

Dans une réalisation particulière facultative, les nombres entiers choisis peuvent comporter en outre la valeur de 0.

Ainsi, si le code de permutation utilise une énumération de Schalkwijk, un rang partiel $I_k^{d_k}$ associé à la

troncature $(y_k,...,y_{n-1})$ d'un vecteur-code $(y_0,...,y_{n-1})$ s'écrit :

$$I_k^{d_k} = \frac{(n-1-k)!}{\prod_{i=0}^{q-1}(w_k^i!)}\left(\sum_{d=0}^{d_k-1} w_k^d\right),$$

où:

- la notation $\prod_{i=0}^{m}$ représente un produit pour un indice entier i allant de 0 à m,
- la notation $\sum_{i=0}^{m}$ représente une somme pour un indice i allant de 0 à m,
- la notation $l!$ est la valeur factorielle de l'entier $l$ avec $l! = 1 \times 2 \times 3 \times ... \times (l-1) \times l$, pour $l>0$ et $0!=1$,
- l'entier $n$ est la dimension du code de permutation, correspondant au nombre total de composantes que comporte un vecteur-code,
- l'entier $k$, compris entre 0 et $n$-1, est l'indice de la k[ième] composante $y_k$ du vecteur-code, recherchée à partir d'une valeur de rang en décodage de source (respectivement en codage de canal) ou dont on cherche à indexer les permutations en codage de source (respectivement en décodage de canal),
- l'entier $q$ est le nombre de composantes distinctes que comporte le vecteur-code, et
- un terme $w_k^d$ (dénommé "poids intermédiaire") représente le nombre de composantes d'indices compris entre $k$ et $n$-1 et qui ont une valeur égale à celle d'une même composante d'indice $d$.

Dans ce cas, les nombres entiers choisis dont les décompositions sont préenregistrées et que l'on cherchera alors à identifier dans l'expression du rang partiel $I_k^{d_k}$, dans un produit et/ou un quotient, sont préférentiellement :

- les termes factoriels $(n-1-k)!$, pour tous les entiers $k$ et compris entre 0 et $n$-1, (c'est-à-dire les valeurs des factorielles pour tous les entiers entre 0 et $(n-1)$),
- la valeur de chaque terme $w_k^i$ et/ou sa valeur factorielle, intervenant dans le produit $P_k = \prod_{i=0}^{q-1}(w_k^i!)$, chaque terme $w_k^i$ étant compris entre 0 et $n$, et
- les termes $S_k = \sum_{d=0}^{d_k-1} w_k^d$, chacun compris entre 1 et $n$-1, pour tous les entiers $k$ compris entre 0 et $n$-1.

Toujours dans le cas particulier de l'énumération de Schalkwijk, le stockage temporaire des décompositions intermédiaires s'applique avantageusement comme suit : la somme des exposants dans la décomposition du terme $P_k = \prod_{i=0}^{q-1}(w_k^i!)$ est stockée temporairement en mémoire pour un indice $k$ précédent, pour lui ajouter ou lui soustraire les exposants de la décomposition d'un terme $w_k^i$ pour un indice $k$ courant.

D'autres caractéristiques et avantages de l'invention apparaîtront à l'examen de la description détaillée ci-après, et des dessins annexés sur lesquels, outre les figures 1 A, 1 B, 2 et 3 décrites ci-avant :

- la figure 4 illustre les principes du codage/décodage du rang d'une permutation en exploitant l'invention,
- la figure 5 illustre un traitement pour le codage d'un rang d'une permutation en exploitant l'invention selon un premier mode de réalisation, dans lequel on prévoit une représentation éclatée des exposants de la décomposition en puissances de nombres premiers de termes intervenant dans ce calcul,
- la figure 6 illustre un traitement pour le codage d'un rang d'une permutation en exploitant l'invention selon un second mode de réalisation, dans lequel on prévoit une représentation compacte des exposants de la décomposition,
- la figure 7 illustre un traitement pour le décodage d'un rang d'une permutation en exploitant l'invention selon un premier mode de réalisation, dans lequel on prévoit une représentation éclatée des exposants de la décomposition, et
- la figure 8 illustre un traitement pour le décodage d'un rang d'une permutation en exploitant l'invention selon un second mode de réalisation, dans lequel on prévoit une représentation compacte des exposants de la décomposition,
- la figure 9 représente schématiquement un dispositif de codage/décodage mettant en oeuvre la présente invention.

Il convient d'insister pour rappeler (en particulier en référence aux figures 4 à 8 ci-après) que :

- le terme "codage" vise le calcul du rang *t* d'une permutation (opération OP2 des figures 1A et 1B), et
- le terme "décodage" vise la détermination de la permutation à partir de ce rang *t* (opération OP3 des figures 1A et 1B).

Ces opérations seront ainsi nommées en référence au codage/décodage de source avec quantification vectorielle. On rappelle que ces opérations peuvent être menées aussi en codage/décodage de canal, en modulation.

Pour illustrer d'emblée le principe de l'invention, on décrit ci-après la factorisation en puissances de nombres premiers.

La décomposition d'un nombre entier positif *K* non nul, en puissances de nombres premiers, s'écrit ainsi :

$$K = \prod_{i=0}^{m_K} (p_i)^{e_K^i}$$

$p_i$ étant un i$^{éme}$ nombre premier ($p_0 = 1$, $p_1 = 2$, $p_2 = 3$, $p_3 = 5$, $p_4 = 7$, $p_5 = 11$, $p_6 = 13$, $p_7 = 17$, etc.).

On note $e^i_K$ l'exposant de $p_i$ dans la décomposition du nombre entier *K* et $m_K$ l'indice du plus grand facteur premier intervenant dans la décomposition de *K* d'exposant non nul.

Par exemple, le nombre K=120 (soit 5!) s'écrit :
$120 = 1.2^3.3^1.5^1$ et $m_k$=3 ici puisque le plus grand facteur "5" est d'indice 3 ($p_3 = 5$). On a donc :

$$e_{5!}^0 = 1,\ e_{5!}^1 = 3,\ e_{5!}^2 = 1 \text{ et } e_{5!}^3 = 1.$$

En pratique, le nombre "1" étant l'élément neutre de la multiplication, on peut supprimer $p_0$ de la décomposition, soit :

$$K = \prod_{i=1}^{m_K} (p_i)^{e_K^i}$$

Bien entendu, *K*=0 n'est pas décomposable en puissances de facteurs premiers.

La décomposition en produits de puissances de nombres premiers des entiers positifs inférieurs ou égaux à 16 est donnée dans la table 3a, la décomposition de leurs factorielles dans la table 3b. Cette décomposition fait intervenir 6 nombres premiers (2, 3, 5, 7, 11 et 13). Les colonnes étant indexées par le nombre premier $p_i$ et les lignes par *n,* l'élément de la table 3a (respectivement 3b) à l'intersection de la colonne $p_i$ et de la ligne *n* est l'exposant $e_n^i$ (respectivement $e_{n!}^i$) du nombre premier $p_i$ dans la décomposition en produit de puissances de nombres premiers du nombre *n* (respectivement *n*!).

Pour tout nombre entier positif *n*>1, le nombre $m_{n!}$ de facteurs premiers de *n*! est tel que : $p_{m_{n!}} \le n \le p_{m_{n!}+1}$. On a indiqué le nombre $m_{n!}$ (respectivement le nombre $m_n$) dans la dernière (respectivement avant-dernière) colonne de la table 3b (respectivement 3a). On note l'inégalité suivante : $m_n \le m_{n!}$

Comme le montre la table 3a, de nombreux exposants de la décomposition d'un nombre *n* sont nuls. Dans la dernière colonne de la table 3a, on a noté le nombre $m'_n$ d'exposants non nuls dans la décomposition de *n*. L'absence de décomposition (et donc d'exposants) pour *n*=0 est indiquée dans la ligne *n*=0 de la table 3a par le signe "-".

| $n$ \ $p_i$ | 2 | 3 | 5 | 7 | 11 | 13 | $m_n$ | $m'_n$ |
|---|---|---|---|---|---|---|---|---|
| 0 | - | - | - | - | - | - | 0 | - |
| 1 | 0 | 0 | 0 | 0 | 0 | 0 | 1 | 0 |
| 2 | 1 | 0 | 0 | 0 | 0 | 0 | 1 | 1 |
| 3 | 0 | 1 | 0 | 0 | 0 | 0 | 2 | 1 |
| 4 | 2 | 0 | 0 | 0 | 0 | 0 | 1 | 1 |
| 5 | 0 | 0 | 1 | 0 | 0 | 0 | 3 | 1 |
| 6 | 1 | 1 | 0 | 0 | 0 | 0 | 2 | 2 |
| 7 | 0 | 0 | 0 | 1 | 0 | 0 | 4 | 1 |
| 8 | 3 | 0 | 0 | 0 | 0 | 0 | 1 | 1 |
| 9 | 0 | 2 | 0 | 0 | 0 | 0 | 2 | 1 |
| 10 | 1 | 0 | 1 | 0 | 0 | 0 | 3 | 2 |
| 11 | 0 | 0 | 0 | 0 | 1 | 0 | 5 | 1 |
| 12 | 2 | 1 | 0 | 0 | 0 | 0 | 2 | 2 |
| 13 | 0 | 0 | 0 | 0 | 0 | 1 | 6 | 1 |
| 14 | 1 | 0 | 0 | 1 | 0 | 0 | 4 | 2 |
| 15 | 0 | 1 | 1 | 0 | 0 | 0 | 3 | 2 |
| 16 | 4 | 0 | 0 | 0 | 0 | 0 | 1 | 1 |

**Table 3a : Décomposition en puissances de nombres premiers d'un entier positif *n* (*n*<17)**

| *n* | *n*! \ $p_i$ | 2 | 3 | 5 | 7 | 11 | 13 | $m_{n!}$ |
|---|---|---|---|---|---|---|---|---|
| 0 | 1 | 0 | 0 | 0 | 0 | 0 | 0 | 1 |
| 1 | 1 | 0 | 0 | 0 | 0 | 0 | 0 | 1 |
| 2 | 2 | 1 | 0 | 0 | 0 | 0 | 0 | 1 |
| 3 | 6 | 1 | 1 | 0 | 0 | 0 | 0 | 2 |
| 4 | 24 | 3 | 1 | 0 | 0 | 0 | 0 | 2 |
| 5 | 120 | 3 | 1 | 1 | 0 | 0 | 0 | 3 |
| 6 | 720 | 4 | 2 | 1 | 0 | 0 | 0 | 3 |
| 7 | 5040 | 4 | 2 | 1 | 1 | 0 | 0 | 4 |
| 8 | 40320 | 7 | 2 | 1 | 1 | 0 | 0 | 4 |
| 9 | 362880 | 7 | 4 | 1 | 1 | 0 | 0 | 4 |
| 10 | 3628800 | 8 | 4 | 2 | 1 | 0 | 0 | 4 |
| 11 | 39916800 | 8 | 4 | 2 | 1 | 1 | 0 | 5 |
| 12 | 479001600 | 10 | 5 | 2 | 1 | 1 | 0 | 5 |
| 13 | 6227020800 | 10 | 5 | 2 | 1 | 1 | 1 | 6 |
| 14 | 87178291200 | 11 | 5 | 2 | 2 | 1 | 1 | 6 |
| 15 | 1307674368000 | 11 | 6 | 3 | 2 | 1 | 1 | 6 |
| 16 | 20922789888000 | 15 | 6 | 3 | 2 | 1 | 1 | 6 |

**Table 3b : Décomposition en puissances de nombres premiers de *n!* *(n<17)***

On décrit ci-après l'application d'une telle décomposition pour le calcul d'un rang partiel d'un code de permutation, dans le cas de la formule de Schalkwijk dans un premier temps, puis dans le cas général.

On rappelle que le rang partiel, noté $I_k^{d_k}$, est donné par la relation (7) ci-avant :

$$I_k^{d_k} = \frac{(n-1-k)!}{\prod_{i=0}^{q-1}(w_k^i!)}\left(\sum_{d=0}^{d_k-1} w_k^d\right) \quad (7),$$

de sorte que trois termes peuvent être décomposés en puissances de nombres premiers. Il s'agit des termes :

$$(n-1-k)!\ ,\ \ P_k = \prod_{i=0}^{q-1} w_k^i! \ \text{ et } \ S_k = \sum_{d=0}^{d_k-1} w_k^d \ .$$

A partir des exposants des décompositions de ($n$-1-k)!, de $P_k$ et de $S_k$, on calcule par de simples additions et soustractions, les exposants de la décomposition de $I_k^{d_k}$ **.**

En effet, l'exposant $e_{I_k^{d_k}}^i$ d'un facteur premier $p_i$ dans la décomposition de $I_k^{d_k}$ se calcule à partir des trois exposants de $p_i$ dans les décompositions des trois termes ($n$-1-$k$)!, $S_k$ et $P_k$. L'exposant $e_{I_k^{d_k}}^i$ est égal à la somme des exposants de $p_i$ des deux premiers termes (numérateur de $I_k^{d_k}$) à laquelle on soustrait l'exposant de $p_i$ du dernier terme (dénominateur de $I_k^{d_k}$). Cette observation, une fois formalisée, s'écrit :

$$e_{I_k^{d_k}}^i = e_{(n-1-k)!}^i + e_{S_k}^i - e_{P_k}^i \quad (10)$$

On a représenté sur la figure 4 les étapes générales (référencées "G-n" pour $n^{ième}$ étape générale) pouvant intervenir dans un traitement au sens de l'invention aussi bien pour le codage que pour le décodage.

Ainsi, en référence à la figure 4, à partir d'un indice courant $k$ (étape G-1) et via quelques étapes intermédiaires qui seront décrites en détail plus loin, on retiendra surtout que l'on prévoit de se référer à des tables pré-enregistrées (notées $D_l$ et $D_{l!}$ à l'étape G-2 illustrée à titre d'exemple sur la figure 4) pour calculer l'exposant $e_{I_k^{d_k}}$ global selon la relation (10) ci-avant (étape G-3), cet exposant étant propre à la décomposition du rang intermédiaire $I_k^{d_k}$ en puissances de facteurs premiers. On en déduit alors la valeur du rang intermédiaire $I_k^{d_k}$ (étape G-4), éventuellement en menant une boucle sur l'indice $i$ propre aux facteurs premiers. Le calcul de ce rang intermédiaire peut alors se poursuivre par une mise à jour du rang total $t$ de la permutation (étape G-5) :

- avec une relation du type $t=t+I_k^{d_k}$ pour le codage du rang avec décrémentation de l'indice $k$ (étape G-6),
- ou avec une relation du type $t=t-I_k^{d_k}$ pour le décodage du rang avec incrémentation de l'indice $k$ (étape G-6), comme on le verra plus loin.

Finalement, on obtient le rang $t$ de la permutation, en codage à l'étape G-7, ou, en décodage (traits pointillés de la figure 4), on déduit des inégalités de la formule (8) ci-avant les composantes $d_k$ du vecteur ***D*** à l'étape G-8 et, de là, celles du vecteur **Y** par la relation $y_k=a_d$ ci-avant.

Dans le cas général et indépendamment de l'énumération de Schalkwijk, si un rang partiel $t'$ ($t'$ >0) d'une permutation est sous la forme d'un numérateur de $N_{t'}$ termes $\nu_j$ ($1 \leq j \leq N_{t'}$) et d'un dénominateur de $D_{t'}$ termes $\rho_j$ ($1 \leq$

$j \leq D_{t'}$) , de sorte que :

$$t' = \frac{\prod_{j=1}^{N_{t'}} \nu_j}{\prod_{j=1}^{D_{t'}} \rho_j} \quad ,$$

alors les exposants $e_{t'}^i$ de la décomposition du rang partiel $t'$ sont déterminés à partir des décompositions intermédiaires que sont les décompositions des $N_{t'}$ $\nu_j$ et des $D_{t'}$ $\rho_j$, ce qui s'écrit :

$$e_{t'}^i = \sum_{j=1}^{N_{t'}} e_{\nu_j}^i - \sum_{j=1}^{D_{t'}} e_{\rho_j}^i$$

On utilisera aussi par la suite la décomposition en facteurs de nombres premiers pour une formulation en produits de quotients de nombres entiers d'un rang partiel $t'$.

De manière générale encore, si

$$t' = \prod_{j=1}^{Q_{t'}} \frac{\nu_j}{\rho_j} = \prod_{j=1}^{Q_{t'}} \tau_j \quad \text{, alors } e_{t'}^i = \sum_{j=1}^{N_{t'}} e_{\tau_j}^i \quad .$$

En revenant au cas particulier de l'énumération de Schalkwijk, pour calculer alors un rang partiel $I_k^{d_k}$ à partir de sa décomposition, une fois cette décomposition déterminée, il peut être procédé comme suit.

En gardant à l'esprit la relation $e_{t'}^i = e_{I_k^{d_k}}^i = e_{(n-1-k)!}^i + e_{S_k}^i - e_{P_k}^i$ , le rang partiel $I_k^{d_k}$ est calculé simplement en multipliant les puissances correspondantes :

$$I_k^{d_k} = \prod_{i=1}^{m_{I_k^{d_k}}} (p_i)^{e_{I_k^{d_k}}^i}$$

On indique ici que les termes $(n-1-k)!$ et $P_k$ sont des entiers strictement positifs mais le terme $S_k$ peut être nul et donc non décomposable. Dans ce cas, le rang partiel $I_k^{d_k}$ est nul. On prévoira alors un test sur la valeur du terme $S_k$ ( $S_k = 0$?) pour ne calculer le rang partiel $I_k^{d_k}$ que si $S_k \neq 0$, comme décrit ci-avant (étape CA-11 de la figure 3).

Plus généralement, si

$$e_{t'}^{i}=\sum_{j=1}^{N_{t'}}e_{\nu_j}^{i}-\sum_{j=1}^{D_{t'}}e_{\rho_j}^{i} \quad \text{alors} \quad t'=\prod_{i=1}^{m_{t'}}p_i^{e_{t'}^{i}}=\prod_{i=1}^{m_{t'}}p_i^{\sum_{j=1}^{N_{t'}}e_{\nu_j}^{i}-\sum_{j=1}^{D_{t'}}e_{\rho_j}^{i}} \quad ,$$

et si

$$e_{t'}^{i}=\sum_{j=1}^{Q_{t'}}e_{\tau_j}^{i} \quad \text{alors} \quad t'=\prod_{i=1}^{m_{t'}}p_i^{e_{t'}^{i}}=\prod_{i=1}^{m_{t'}}p_i^{\sum_{j=1}^{Q_{t'}}e_{\tau_j}^{i}} \quad (t'>0)$$

On retiendra alors que la factorisation en facteurs premiers des termes composant un rang partiel permet de supprimer les divisions en les remplaçant par des multiplications de puissances de facteurs premiers, avec, en particulier, de simples additions et soustractions des exposants associés à ces nombres premiers.

Ainsi, au sens de la présente invention, on prévoit les étapes suivantes, à partir d'un nombre restreint de décompositions en facteurs premiers de nombres entiers, stockées en mémoire (dites ci-après "décompositions de base") :

- détermination des décompositions en facteurs premiers de termes (tels que $(n\text{-}1\text{-}k)!$ , $P_k=\prod_{i=0}^{q-1}w_k^i!$ et $S_k=\sum_{d=0}^{d_k-1}w_k^d$ ) apparaissant dans le rang d'une permutation (dites ci-après "décompositions intermédiaires"), au sens de l'étape G-2 de la figure 4,
- détermination, à partir de ces décompositions intermédiaires, de la décomposition en facteurs premiers d'un rang partiel $t'(I_k^{d_k})$ d'une permutation, notamment par le calcul des exposants intervenant dans la décomposition de ce rang partiel (avec par exemple une relation du type $e_{I_k^{d_k}}^{i}=e_{(n-1-k)!}^{i}+e_{S_k}^{i}-e_{P_k}^{i}$ ), au sens de l'étape G-3 de la figure 4, et
- calcul du rang partiel $t'(I_k^{d_k})$ à partir de sa décomposition (par exemple en utilisant une relation du type $I_k^{d_k}=\prod_{i=0}^{m_{I_k^{d_k}}}(p_i)^{e_{I_k^{d_k}}^{i}}$ ), au sens de l'étape G-4 de la figure 4.

Bien entendu, les décompositions de base à stocker font préférentiellement l'objet d'une sélection avantageuse. Dans une réalisation préférée mais non limitative, les décompositions de base à stocker seront choisies en fonction de la dimension maximale des codes à permutation considérés (cette dimension maximale étant notée *n*). Ainsi, les décompositions de base sont préférentiellement :

- les décompositions des factorielles d'un entier *l* (notées *l*!), l'entier *l* étant tel que $0\leq l\leq n$,
- et les décomposition de l'entier *l* lui-même, avec cette fois $1\leq l\leq n$ ,

où on rappelle que n est la dimension maximale des codes à permutation considérés.

On peut alors identifier une décomposition de base par un nombre m donnant :

- le nombre m de facteurs premiers à considérer,

- ces m facteurs premiers, eux-mêmes,
- et leurs exposants respectifs.

Des exemples de cette mise en oeuvre seront décrits plus loin en référence aux tables 4a à 4d, dans le cadre d'une représentation dite "éclatée" des décompositions. On indique qu'une représentation dite "compacte", décrite en détail plus loin, consiste à stocker un simple mot dont les bits donnent tous les exposants intervenant dans une décomposition.

On peut définir alors différents jeux de décompositions de base, ainsi que des procédures de représentation et de stockage de ces décompositions de base.

Par ailleurs, la sélection des termes dont on détermine les décompositions intermédiaires, ainsi que la détermination proprement dite de ces décompositions intermédiaires, font l'objet de réalisations avantageuses qui seront décrites plus loin. La décomposition d'un rang partiel et le calcul d'un rang partiel à partir de sa décomposition font aussi l'objet de réalisations avantageuses décrites plus loin.

On décrit maintenant le choix des décompositions de base à stocker.

De manière générale et indépendamment de la technique d'énumération d'un code à permutation de dimension *n,* le calcul du rang d'une permutation utilise les nombres entiers $l$ ($0 \le l \le n$) et surtout leurs factorielles $l!$ ($0 \le l \le n$). Dans une réalisation préférée, les décompositions de base sont les décompositions des factorielles de $l!$ ($0 \le l \le n$) et de $l$ ($1 \le l \le n$) où $n$ est la dimension maximale des codes à permutation considérés, comme indiqué ci-avant. On prévoit donc dans cette réalisation préférée, ($2n+1$) décompositions de base.

Néanmoins, d'autres réalisations sont possibles.

Par exemple, il peut n'être prévu que ($n+1$) décompositions de base, à savoir celles de $l$ ($1 \le l \le n$) et de 0! . Ainsi, si une décomposition de $l!$ ($l > 0$) est nécessaire au calcul d'un rang partiel, elle est calculée à l'étape de détermination des décompositions intermédiaires à partir des / décompositions de base de $j$ ($1 \le j \le l$) avec $e_{l!}^{i} = \sum_{j=1}^{l} e_{j}^{i}$ .

Inversement, on peut ne prévoir que les ($n+1$) décompositions de $l!$ ($0 \le l \le n$). Si une décomposition de $l$ ($l > 0$) est nécessaire au calcul d'un rang partiel, elle est calculée à l'étape de détermination des décompositions intermédiaires à partir des deux décompositions de base de $l!$ et $(l-1)!$ et à partir de la relation :

$$e_{l}^{i} = e_{l!}^{i} - e_{(l-1)!}^{i}$$

On comprend donc que le choix du jeu de décompositions de base peut avantageusement résulter d'un compromis entre la minimisation de la mémoire nécessaire au stockage des représentations de ces décompositions de base et à la minimisation de la complexité de l'étape de détermination des décompositions intermédiaires.

On décrit ci-après une représentation des décompositions au sens de l'invention.

Comme indiqué plus haut, une décomposition (qu'elle soit de rang partiel, intermédiaire ou de base) est définie par un nombre m donnant le nombre de facteurs premiers à considérer, ces m facteurs premiers et leurs exposants respectifs. On propose ci-après différentes solutions pour représenter les décompositions et stocker les données pour les décompositions de base.

**Représentation éclatée des exposants**

** Représentation des factorielles l! (*$0 \le l \le n$*)*

Le nombre $m_{l!}$ de facteurs premiers intervenant dans la décomposition de la valeur *l!* croît avec le nombre *l.* Une première solution pour représenter la décomposition de $l!$ ($0 \le l \le n$) consiste à stocker pour chaque valeur de $l$ ($0 \le l \le n$) le nombre $m_{l!}$ et les $m_{l!}$ exposants des puissances de $p_i$ ($1 \le i \le m_{l!}$).

On notera que les $m_{l!}$ exposants de *l!* sont non nuls.

Dans une variante plus avantageuse, le jeu des décompositions de base partage le même nombre $m_{n!}$ de facteurs premiers et on stocke $m_{n!}$ exposants pour chaque décomposition de base, les exposants de la décomposition de base de $l!$ d'indice supérieur à $m_{l!}$ étant nuls. Cette solution permet d'avoir recours à un tableau des exposants en prévoyant un adressage régulier de ce tableau. Toutefois, une telle réalisation nécessite une taille mémoire conséquente.

Ce tableau comporte $m_{l!}\times(n+1)$ valeurs et l'exposant $e_{l!}^{i}$ est stocké à l'adresse ($m_{l!}$ , $l$+($i$-1)) de ce tableau, où la notation ($x$, $y$) vise la case de ce tableau à la ligne $x$ et à la colonne $y$. Bien entendu, on comprendra que d'autres conventions peuvent être considérées. Ainsi, au lieu de considérer un tableau à deux dimensions avec $m$ colonnes et $N$ lignes qui comporte donc $m \times N$ cases (ou éléments), on peut considérer un tableau à une dimension ayant $m \times N$ éléments, l'élément à l'adresse ($x$, $y$) du tableau à deux dimensions se retrouvant alors à l'adresse $m\times x+y$ du tableau à une dimension. L'exposant $e_{l!}^{i}$ stocké à l'adresse ($l$,($i$-1)) du tableau à deux dimensions est alors stocké à l'adresse ($m_{n!}\times l$+ ($i$-1)) du tableau à une dimension. Par exemple, les exposants des décompositions des factorielles des nombres 0 à 8 peuvent être stockés dans le tableau à deux dimensions comprenant 36 éléments, composé de 4 colonnes (colonnes $p_i$ =2, 3, 5, 7) de la table 3b et de 9 lignes (lignes n=0, ..8). Ces mêmes exposants peuvent être stockés dans un tableau monodimensionnel $\boldsymbol{D_{l!}}$ à 36 éléments, donné ci-après (annexe **A-11).** L'élément à l'adresse ($x$, $y$) du premier tableau étant égal l'élément à l'adresse $\boldsymbol{D_{l!}}$ : $4\times x+y$.

Il peut être prévu, en complément, de stocker les ($n$+1) valeurs de $m_{l!}$ pour pouvoir réduire les calculs des décompositions intermédiaires utilisant la décomposition de base de $l!$ .

** Représentation des entiers 1 (1≤l≤n)*

Pour représenter la décomposition de base $l$ ($1\leq l\leq n$), plusieurs solutions peuvent aussi être prévues. Une première solution consiste à stocker pour chaque valeur $l$ le nombre $m_l$ et les $m_l$ exposants des puissances de $p_i$ ($1\leq i\leq m_l$) de $l$. Dans une variante, on peut préférer stocker autant d'exposants que pour $l!$ ($m_{l!}$, ou $m_{n!}$) exposants. Les décompositions de base de $l$ et $l!$ partagent alors le même nombre m.

Dans une autre variante, on peut exploiter le fait que le nombre $m'_l$ d'exposants non nuls de la décomposition de $l$ soit faible. Par exemple, il apparaissait sur la table 3a que ce nombre $m'_l$ était au maximum de 2 (pour $l\leq 16$). Ainsi, il est possible de ne stocker que ce nombre et les valeurs correspondantes $p_i$ ou les indices i. Toutefois, il faut prévoir aussi de stocker les indices $i$ de ces facteurs premiers de puissance non nulle car ils ne sont plus implicitement reconnus par l'adresse de l'exposant correspondant dans le tableau.

* *Représentation d'une décomposition autre qu'une décomposition de base*

La représentation d'une décomposition intermédiaire dépend de la représentation des décompositions de base à partir desquelles elle est déterminée. De même, la représentation d'une décomposition d'un rang partiel dépend de la représentation des décompositions intermédiaires à partir desquelles elle est déterminée.

* *Stockage des décompositions de base*

Typiquement, quatre solutions possibles de stockage peuvent être illustrées à titre d'exemple par les tables 4a à 4d ci-après pour un code à permutation de dimension 8 ($n=8$) où quatre ($m_{8!}$ = 4) nombres premiers (2, 3, 5 et 7) sont considérés. Ces exemples peuvent être appliqués au codeur 3GPP AMR-WB+ (normes [3GPPTS26.273] et [3GPPTS26.304]). Ce codeur utilise une quantification vectorielle algébrique dont le dictionnaire est une union des codes à permutation du réseau de Gosset $RE_8$ de dimension 8.

Les trois premières solutions (tables 4a-4c) représentent et stockent les décompositions de base de $l!$ de la même manière. On prévoit en effet un stockage de $m_{l!}$ et des $m_{l!}$ exposants des puissances de $p_i$ ($1\leq i\leq m_{l!}$) de $l!$. Elles diffèrent dans la représentation et le stockage des décompositions de base de $l$. La table 4a montre une première solution visant le stockage de $m_l$ et des $m_l$ exposants des puissances de $p_i$ ($1\leq i\leq m_{l!}$) de $l$. La table 4b montre une deuxième solution visant le stockage des $m_{l!}$ exposants des puissances de $p_i$ ($1\leq i\leq m_{l!}$) de $l$.

| | $l!$ | | | | | $l$ | | | | |
|---|---|---|---|---|---|---|---|---|---|---|
| $p_i$ / $l$ | 2 | 3 | 5 | 7 | $m_{l!}$ | 2 | 3 | 5 | 7 | $m_l$ |
| 0 | 0 | - | - | - | 1 | - | - | - | - | 0 |
| 1 | 0 | - | - | - | 1 | 0 | - | - | - | 1 |
| 2 | 1 | - | - | - | 1 | 1 | - | - | - | 1 |
| 3 | 1 | 1 | - | - | 2 | 0 | 1 | - | - | 2 |
| 4 | 3 | 1 | - | - | 2 | 2 | - | - | - | 1 |
| 5 | 3 | 1 | 1 | - | 3 | 0 | 0 | 1 | - | 3 |
| 6 | 4 | 2 | 1 | - | 3 | 1 | 1 | - | - | 2 |
| 7 | 4 | 2 | 1 | 1 | 4 | 0 | 0 | 0 | 1 | 4 |
| 8 | 7 | 2 | 1 | 1 | 4 | 3 | - | - | - | 1 |

**Table 4a : Première solution pour un stockage de la décomposition en puissances de nombres premiers de *l* et *l*! et pour un code à permutation de dimension 8 (*l* allant de 0 à 8)**

| | $l!$ | | | | $l$ | | | | |
|---|---|---|---|---|---|---|---|---|---|
| $l$ \ $p_i$ | 2 | 3 | 5 | 7 | 2 | 3 | 5 | 7 | $m_{l!}$ |
| 0 | 0 | - | - | - | - | - | - | - | 1 |
| 1 | 0 | - | - | - | 0 | - | - | - | 1 |
| 2 | 1 | - | - | - | 1 | - | - | - | 1 |
| 3 | 1 | 1 | - | - | 0 | 1 | - | - | 2 |
| 4 | 3 | 1 | - | - | 2 | 0 | - | - | 2 |
| 5 | 3 | 1 | 1 | - | 0 | 0 | 1 | - | 3 |
| 6 | 4 | 2 | 1 | - | 1 | 1 | 0 | - | 3 |
| 7 | 4 | 2 | 1 | 1 | 0 | 0 | 0 | 1 | 4 |
| 8 | 7 | 2 | 1 | 1 | 3 | 0 | 0 | 0 | 4 |

**Table 4b : Deuxième solution pour le stockage de la décomposition en puissances de nombres premiers de *l* et *l*! et pour un code à permutation de dimension 8 (*l* allant de 0 à 8)**

La table 4c ci-après montre une troisième solution visant le stockage du nombre $m'_l$ d'exposants non nuls des puissances de $p_i$ de *l,* des indices *i* correspondants, ainsi que leurs exposants. Dans la table représentée, pour plus de clarté, ce sont les facteurs premiers $p_i$ qui sont indiqués.

| | $l!$ | | | | | $l$ | | | | |
|---|---|---|---|---|---|---|---|---|---|---|
| $p_i$ \ $l$ | 2 | 3 | 5 | 7 | $m_{l!}$ | $p_i$ | $e^l$ | $p_{i'}$ | $e^{l'}$ | $m'_l$ |
| 0 | 0 | - | - | - | 1 | - | - | - | - | 0 |
| 1 | 0 | - | - | - | 1 | 2 | 0 | - | - | 1 |
| 2 | 1 | - | - | - | 1 | 2 | 1 | - | - | 1 |
| 3 | 1 | 1 | - | - | 2 | 3 | 1 | - | - | 1 |
| 4 | 3 | 1 | - | - | 2 | 2 | 2 | - | - | 1 |
| 5 | 3 | 1 | 1 | - | 3 | 5 | 1 | - | - | 1 |
| 6 | 4 | 2 | 1 | - | 3 | 2 | 1 | 3 | 1 | 2 |
| 7 | 4 | 2 | 1 | 1 | 4 | 7 | 1 | - | - | 1 |
| 8 | 7 | 2 | 1 | 1 | 4 | 2 | 3 | - | - | 1 |

**Table 4c : Troisième solution pour le stockage de la décomposition en puissances de nombres premiers de $l$ et $l!$ et pour un code à permutation de dimension 8 ($l$ allant de 0 à 8)**

Dans une quatrième solution (illustrée par la table 4d ci-après), on représente le jeu des décompositions de base par le nombre $m_{n!}$ et, pour chaque décomposition de base ($l$ ou $l!$), on stocke $m_{n!}$ exposants. La table 4d est extraite des quatre colonnes ($p_i$=2, 3, 5 et 7) et des 9 lignes ($n$=0 à 8) des tables 3a et 3b données précédemment.

| | $l!$ | | | | $l$ | | | |
|---|---|---|---|---|---|---|---|---|
| $l$ \ $p_i$ | 2 | 3 | 5 | 7 | 2 | 3 | 5 | 7 |
| 0 | 0 | 0 | 0 | 0 | - | - | - | - |
| 1 | 0 | 0 | 0 | 0 | 0 | 0 | 0 | 0 |
| 2 | 1 | 0 | 0 | 0 | 1 | 0 | 0 | 0 |
| 3 | 1 | 1 | 0 | 0 | 0 | 1 | 0 | 0 |
| 4 | 3 | 1 | 0 | 0 | 2 | 0 | 0 | 0 |
| 5 | 3 | 1 | 1 | 0 | 0 | 0 | 1 | 0 |
| 6 | 4 | 2 | 1 | 0 | 1 | 1 | 0 | 0 |
| 7 | 4 | 2 | 1 | 1 | 0 | 0 | 0 | 1 |
| 8 | 7 | 2 | 1 | 1 | 3 | 0 | 0 | 0 |

**Table 4d : Quatrième solution pour le stockage de la décomposition en puissances de nombres premiers de *l* et *l*! et pour un code à permutation de dimension 8 (*l* allant de 0 à 8)**

Dans le codeur TDAC qui utilise une quantification vectorielle statistique à dimension et résolution variables de dimension maximale 15, six ($m_{15!}$ = 6) nombres premiers sont considérés: 2, 3, 5, 7, 11 et 13. Les 6 colonnes ($p_i$=2, 3, 5, 7, 11 et 13) et les 16 lignes ($n$=0 à 15) des tables 3a et 3b peuvent alors illustrer le stockage du jeu des représentations de base pour la quatrième solution.

**Représentation compacte des exposants**

On décrit ci-après une autre solution avantageuse minimisant le stockage et qui consiste à représenter de manière compacte les exposants d'une décomposition de base sur un nombre limité de mots. Dans cette variante de représentation des décompositions de base, les décompositions intermédiaires et celles des rangs partiels sont aussi représentées de façon compacte. Avantageusement, cette solution minimise aussi la complexité de la détermination de ces décompositions, comme on le verra.

* *Représentation compacte des décompositions*

On cherche à déterminer, pour chaque facteur premier $p_i$, une borne supérieure $\beta_i$ de la valeur maximale de son exposant dans le numérateur des rangs partiels. Cette borne donne le nombre maximum de valeurs possibles de l'exposant de $p_i$, soit $\beta_i$+1. En notant $b_n^i$ , le nombre entier de bits pour représenter de façon binaire la valeur ($\beta_i$ + 1), on a :

$$b_n^i = \lceil \log_2(\beta_i + 1) \rceil) \text{ et } B_n^i = \sum_{j=1}^{i-1} b_n^j \text{ (avec } B_n^1 = 0\text{ )}$$

où $\lceil x \rceil$ dénote l'entier immédiatement supérieur ou égal à $x$ ($\lceil x \rceil -1 < x \leq \lceil x \rceil$).

Les exposants de la décomposition en facteurs premiers d'un terme $K$ intervenant dans un rang partiel $t'$ peuvent être représentés de façon compacte par un mot $e_K$ de $B_n$ bits $\left(B_n = \sum_{i=1}^{m_{n!}} b_n^i\right)$, ce mot $e_K$ étant tel que :

$$e_K = \sum_{i=1}^{m_{n!}} (e_K^i << B_n^i)$$

La notation "<<$B$" représente un décalage à gauche de $B$ bits.

Il est à noter que si le nombre $n$ est grand, il se peut que $B_n$ soit supérieur au nombre de bits $B_0$ utilisés pour représenter des entiers (16, 32 ou 40 bits). Dans ce cas, les exposants de la décomposition en facteurs premiers d'un entier $K$ intervenant dans $t'$ sont représentés sous la forme de $M$ mots entiers $e_K(m)$, $0 \leq m < M$ (avec, bien entendu, $M>1$).

Avantageusement, les $M$ mots peuvent être formés de la façon suivante :

- $e_K(0)$ comprend les $i_0$ premiers exposants (exposants de $p_1$ à $p_{i_0}$ ):

$$e_K(0) = \sum_{i=1}^{i_0} e_K^i << B_n^i \text{ où } B_n^{i_0+1} < B_0 \leq B_n^{i_0+2}$$

- $e_K(1)$comprend les exposants de $p_{i_0+1}$ à $p_{i_1}$:

$$e_K(1) = \sum_{i=i_0+1}^{i_1} e_K^i << (B_n^i - B_n^{i_0+1}) \text{ où } (B_n^{i_1+1} - B_n^{i_0+1}) < B_0 \leq (B_n^{i_1+2} - B_n^{i_0+1})$$

- Cette dernière relation peut être généralisée pour tout m, jusqu'à composer le dernier mot qui comprend l'exposant de $p_{m_{n!}}$

Bien entendu, d'autres variantes peuvent être prévues. Par exemple, une variante consiste à stocker à part l'exposant de $p_1$, et appliquer le traitement ci-dessus à partir de l'exposant de $p_2$.

* *Détermination de la borne supérieure*

Les bornes $\beta_i$ peuvent être déterminées de plusieurs façons. En exploitant les informations sur le code à permutation (taille $q$ de l'alphabet, poids $w^i$ $0 \leq i < q$), la valeur maximale de chaque exposant du numérateur d'un rang partiel peut être explicitement déterminée. Si plusieurs codes à permutation (éventuellement de dimensions différentes) sont utilisés, on choisit préférentiellement, pour chaque exposant, la plus grande des valeurs maximales.

La présente invention propose avantageusement un traitement général pour la détermination de la borne supérieure dans le cadre de l'énumération de Schalkwijk. Le traitement n'exploite aucune information a priori sur les codes à permutation utilisés autre que la dimension maximale. Il exploite simplement la relation :

$$\max_{0 \leq k < n}(e_{(n-1-k)!}^i + e_{S_k}^i) \leq \max_{0 \leq k < n}(e_{(n-1-k)!}^i) + \max_{1 \leq l < n}(e_l^i) = e_{(n-1)!}^i + \max_{1 \leq l < n}(e_l^i)$$

pour choisir alors

$$\beta_i = e^i_{(n-1)!} + \max_{1\le l<n}(e^i_l).$$

Ce traitement très général est particulièrement bien adapté lorsqu'une grande variété de codes à permutation est utilisée.

La table 5a donne les bornes supérieures des valeurs maximales des exposants dans les numérateurs de $I_k^{d_k}$ pour les dimensions 8 et 15. La table 5b donne le nombre de bits $b_n^i$ pour représenter ces exposants pour les dimensions 8 et 15 ainsi que leur somme $B_n$ (dernière colonne). En dimension 8, l'exposant du facteur premier 2 est représenté sur 3 bits, les exposants des autres facteurs premiers (3, 5 et 7) étant représentés sur 2 bits. En dimension 15, l'exposant du facteur premier 2 est représenté sur 4 bits, l'exposant du facteur premier 3 sur 3 bits, les exposants des autres facteurs premiers (5, 7, 11 et 13) étant représentés sur 2 bits.

| $n$ \ $p_i$ | 2 | 3 | 5 | 7 | 11 | 13 |
|---|---|---|---|---|---|---|
| 8 | 6 | 3 | 2 | 2 | - | - |
| 15 | 14 | 7 | 3 | 3 | 2 | 2 |

**Table 5a : bornes supérieures des exposants des numérateurs pour les codes à permutation de dimensions 8 et 15**

| $n$ \ $p_i$ | 2 | 3 | 5 | 7 | 11 | 13 | $B_n$ |
|---|---|---|---|---|---|---|---|
| 8 | 3 | 2 | 2 | 2 | - | - | 9 |
| 15 | 4 | 3 | 2 | 2 | 2 | 2 | 15 |

**Table 5b : Nombre de bits pour représenter les exposants pour les codes à permutation de dimensions 8 et 15**

La table 6a (respectivement 6b) donne la représentation compacte des exposants de *l* et *l!* pour la dimension *n* égale à 8 (respectivement 15).

**Table 6a : Représentation compacte des exposants pour les codes à permutation de dimension 8**

| $l$ | 0 | 1 | 2 | 3 | 4 | 5 | 6 | 7 | 8 |
|---|---|---|---|---|---|---|---|---|---|
| $e_l$ | - | 0 | 1 | 8 | 2 | 32 | 9 | 128 | 3 |
| $e_{l!}$ | 0 | 0 | 1 | 9 | 11 | 43 | 52 | 180 | 183 |

**Table 6b : Représentation compacte des exposants pour les codes à permutation de dimension 15**

| $l$ | **0** | **1** | **2** | **3** | **4** | **5** | **6** | **7** |
|---|---|---|---|---|---|---|---|---|
| $e_l$ | - | 0 | 1 | 16 | 2 | 128 | 17 | 512 |
| $e_{l!}$ | 0 | 0 | 1 | 17 | 19 | 147 | 164 | 676 |
| $l$ | **8** | **9** | **10** | **11** | **12** | **13** | **14** | **15** |
| $e_l$ | 3 | 32 | 129 | 2048 | 18 | 8192 | 513 | 144 |
| $e_{l!}$ | 679 | 711 | 840 | 2888 | 2906 | 11098 | 11611 | 11755 |

A titre d'exemple purement illustratif, on cherche à déterminer la décomposition de l'entier $l$=12 à l'aide de la table 6b.

Préférentiellement, dans la table 6b, comme la dimension maximale des codes est n=15, l'exposant de "2" est représenté sur 4 bits, celui de "3" sur 3 bits, et les autres facteurs premiers 5, 7, 11, 13 sur 2 bits. Dans la table, à la colonne $l$ =12, on lit son exposant compact $e_{12}$ = 18.

En s'appuyant sur la lecture du tableau ci-après, la représentation binaire de 18 (=16+2) sur $B_{15}$ =15 bits est :

000 0000 0001 0010, soit 00 00 00 00 001 0010 en regroupant les bits associés à un même nombre premier.

| i | 15 ... 7 | 6 | 5 | 4 | 3 | 2 | 1 | 0 |
|---|---|---|---|---|---|---|---|---|
| $2^i$ | ... | 64 | 32 | 16 | 8 | 4 | 2 | 1 |
| En représentation binaire, 18 s'écrit : | 0 ... 0 | 0 | 0 | 1 | 0 | 0 | 1 | 0 |

Les 4 bits de poids faibles (poids i=0 à 3) sont l'exposant du facteur premier 2, soit: 0010 = 2, ce qui signifie que 2 est l'exposant à affecter au nombre premier 2.

Les 3 bits suivants (poids i=4 à 6) sont l'exposant du facteur premier 3, soit :

001 = 1, ce qui signifie que 1 est l'exposant à affecter au nombre premier 3.
Les 2 bits suivants (poids i=7 à 8) sont l'exposant du facteur premier 5, soit : 00 = 0
Les 2 bits suivants (poids i=9 à 10) sont l'exposant du facteur premier 7, soit : 00 = 0
Les 2 bits suivants (poids i=7 à 12) sont l'exposant du facteur premier 11, soit : 00 = 0
Les 2 bits suivants (poids i=13 à 14) sont l'exposant du facteur premier 13, soit : 00 = 0

La procédure d'extraction consiste à masquer les bits de poids forts pour récupérer l'exposant du facteur premier contenu dans les bits de poids faible, puis à décaler l'exposant compact du nombre de bits récupérés pour passer à l'exposant du facteur premier suivant.
Ainsi en dimension 15, il y a 6 exposants à extraire en commençant par l'exposant de 2.

La représentation binaire de l'exposant de 2 correspond aux 4 bits de poids faible de 18, soit 0 0 1 0 qui correspond à 2. Pour les récupérer, on masque les bits de poids fort de 18 avec 15 (noté 18 & 15), ce qui équivaut à :

$2^4$ - 1 = 1 1 1 1.

On obtient $e_{12}$ = 18 & (2<<4 - 1) = 2, ce qui signifie que 2 est l'exposant à affecter au nombre premier 2.
Puis on décale 18 de 4 bits vers la droite, on obtient : 000 0000 0001 = 1

La représentation binaire de l'exposant de 3 correspond aux 3 bits de poids faible de 1, soit 0 0 1 (=1). Pour les récupérer, on masque les bits de poids fort de 1 avec 7 (noté 1 & 7 et valant $2^3$ - 1 = 1 1 1).

On obtient $e^1_{12}$ = 1 & (2<<3 - 1) = 1, ce qui signifie que 1 est l'exposant à affecter au nombre premier 3.

Puis on décale 1 de 2 bits vers la droite, on obtient ensuite : 0000 0000 = 0 pour tous les autres bits de poids fort.

On retient donc que les puissances de $l$=12 sont :

- 2 pour le nombre premier 2, et
- 1 pour le nombre premier 3,

soit $l$=12 = $2^2$x$3^1$

** Borne supérieure pour le dénominateur*

On suppose ici que, pour chaque facteur premier, son exposant dans le dénominateur d'un rang partiel *t'* est inférieur ou égal à son exposant dans le numérateur de *t'*. Tel est le cas si *t'* est strictement positif car on a bien $e^i_{t'} = (e^i_{(Num(t')} - e^i_{Den(t')}) \geq 0$, soit donc $e^i_{(Num(t')} \geq e^i_{Den(t')}$.

En pratique, avec la formule de Schalkwijk et si $q$>1, la valeur $e^i_{(n-1)!}$ est une borne supérieure de la valeur maximale $\beta'_i$ de l'exposant du dénominateur $P_k$ ( $P_k \leq (n-1)!$ si $q>1$).

Il suffit donc de vérifier l'inégalité $e^i_{(n-1)!} < 2^{b^i_n}$, ce qui est déjà fait par le traitement déterminant la valeur de $\beta_i$ exposé ci-avant.

Dans les autres cas, on pourra rechercher explicitement $\beta'_i$ et calculer $b^i_n$ grâce au maximum de $\beta_i$ et $\beta'_i$.

Dans le cas où $q$=1, on comprendra qu'un seul mot de code de rang connu ($t$=0) intervient dans le code à permutation et il est donc inutile a priori d'effectuer les calculs de rang et les opérations inverses correspondantes. Cependant, s'il n'est pas souhaité de traiter à part ce cas particulier, il peut toujours être prévu de calculer la valeur $b^i_n$ par le maximum de $\beta_i$ et $e^i_{n!}$. La table 7 ci-après illustre ce cas pour $n$=16.

**Table 7 : Calcul de la borne supérieure du numérateur $\beta_i$ et de $b^i_{16}$ ($1 \leq i \leq 6$) pour les codes à permutation de dimension 16**

| $p_i$ | 2 | 3 | 5 | 7 | 11 | 13 |
|---|---|---|---|---|---|---|
| $\max_{1 \leq l < 16}(e^i_l)$ $1 \leq l < 16$ | 3 | 2 | 1 | 1 | 1 | 1 |
| $e^i_{15!}$ | 11 | 6 | 3 | 2 | 1 | 1 |
| $\beta_i = e^i_{15!} + \max_{1 \leq l < 16}(e^i_l)$ $1 \leq l < 16$ | 14 | 8 | 4 | 3 | 2 | 2 |
| $e^i_{16!}$ | 15 | 6 | 3 | 2 | 1 | 1 |
| $b^i_{16}$ | 4 | 4 | 3 | 2 | 2 | 2 |

On décrit brièvement maintenant les capacités mémoires requises pour le stockage des décompositions de base.

Indépendamment de la solution choisie pour la représentation des décompositions de base, le stockage des décompositions de base s'effectue dans des tableaux et l'on a alors recours à un adressage de ces tableaux lors des opérations de codage et de décodage du rang. Bien que la décomposition de 0 ne soit pas possible (et, d'ailleurs, pas utilisée), il peut être préférable de stocker des exposants "factices" pour la décomposition de 0 (par exemple des 0 ou des 1), et ce, pour simplifier le calcul d'adresse. La table 8 ci-après résume la taille mémoire nécessaire pour le stockage des données relatives aux décompositions de base pour les cinq solutions présentées pour ces deux cas (stockage ou non de la décomposition factice de 0).

**Table 8 : Mémoire nécessaire au stockage des décompositions de base**

| Solution | Pas de stockage de 0 | Avec stockage factice de 0 |
|---|---|---|
| 1 | $\sum_{l=1}^{n} m_l + \sum_{l=0}^{n} m_{l!} + 2n + 1$ | $\sum_{l=0}^{n} m_l + \sum_{l=0}^{n} m_{l!} + 2(n+1)$ |

(suite)

| Solution | Pas de stockage de 0 | Avec stockage factice de 0 |
|---|---|---|
| 2 | $2\sum_{l=1}^{n} m_{l!} + 1 + (n+1)$ | $2\sum_{l=0}^{n} m_{l!} + (n+1)$ |
| 3 | $\sum_{l=0}^{n} m_{l!} + 2\sum_{l=1}^{n} m'_l + 2n + 1$ | $\sum_{l=0}^{n} m_{l!} + 2\sum_{l=0}^{n} m'_l + 2(n+1)$ |
| 4 | $m^{nl}$x(2$n$+1) | 2$m^{nl}$x($n$+1) |
| 5 | 2$n$+1+$m^{nl}$ | 2x($n$+1)+$m^{nl}$ |

Dans la cinquième solution, on a tenu compte du stockage (+$m_{n!}$) des nombres de bits $b_n^i$. Cependant, en pratique, plutôt que de les lire dans une mémoire, ceux-ci seront "câblés en dur" (leur valeur étant fixe dans un programme de calcul sans être déclarée en tant que variable), comme on le verra dans les modes de réalisation plus loin. Il est donc apparu inutile de les stocker en pratique.

La table 9 donne la mémoire nécessaire pour le stockage des données relatives aux exposants de la décomposition de ces cinq solutions pour $n_{max}$ = 8 et 15 (avec stockage factice de 0).

**Table 9 : Mémoire requise pour le stockage des décompositions de base pour les codes à permutation de dimensions 8 et 15**

| $n$ | $\sum_{l=0}^{n}(m_{l!} + m_l) + 2(n+1)$ | $\sum_{l=0}^{n} 2m_{l!} + (n+1)$ | $\sum_{l=0}^{n} m_{l!} + \sum_{l=0}^{n} 2m'_l + 2(n+1)$ | 2$m_{nl}$ x ($n$+1) | 2 x ($n$+1) + $m_{nl}$ |
|---|---|---|---|---|---|
| 8 | 54 | 51 | 57 | 72 | 22 |
| 15 | 129 | 130 | 129 | 192 | 38 |

On décrit maintenant le stockage des puissances de facteurs premiers.

En dehors des décompositions de base, la présente invention utilise les puissances des facteurs premiers pour calculer le rang partiel à partir de sa décomposition. On peut, à partir d'une table de ces facteurs premiers, calculer leurs puissances en temps réel ("*en ligne*"). Préférentiellement, les puissances des nombres premiers autres que 2 sont pré-calculées et stockées et seules les puissances de 2 sont calculées en temps réel. La table 10a ci-après donne les puissances de 3, 5 et 7 nécessaires pour un code à permutation de dimension 8 (comme ceux utilisés dans le codeur AMR-WB+). La table 10b donne les puissances de 3, 5, 7, 11 et 13 nécessaires pour les codes à permutation de dimension maximale 15 (comme ceux utilisés dans le codeur TDAC).

| $e^i$ / $p_i$ | 0 | 1 | 2 | 3 |
|---|---|---|---|---|
| 3 | 1 | 3 | 9 | 27 |
| 5 | 1 | 5 | 25 | - |
| 7 | 1 | 7 | 49 | - |

**Table 10a : Puissances des facteurs premiers pour les codes à permutation de dimension 8**

| $p_i$ / $e_i$ | 0 | 1 | 2 | 3 | 4 | 5 | 6 | 7 | Npfp |
|---|---|---|---|---|---|---|---|---|---|
| 3 | 1 | 3 | 9 | 27 | 81 | 243 | 729 | 2187 | 8 |
| 5 | 1 | 5 | 25 | 125 | - | - | - | - | 4 |
| 7 | 1 | 7 | 49 | 343 | - | - | - | - | 4 |
| 11 | 1 | 11 | 121 | - | - | - | - | - | 3 |
| 13 | 1 | 13 | 169 | - | - | - | - | - | 3 |

**Table 10b : Puissances des facteurs premiers pour les codes à permutation de dimension 15. La variable Npfp désigne ici le nombre de puissances de facteurs premiers à stocker.**

Là, encore, on pourra ne stocker que le nombre nécessaire de puissances pour chaque facteur premier. En variante, s'il est préféré de ne disposer que d'un seul tableau de puissances adressable régulièrement, il peut être prévu de stocker, pour chaque facteur premier, autant de valeurs que le nombre de puissances de $p_2$ nécessaires ($p_2$=3). Pour les puissances non utilisées, on peut, bien entendu, utiliser un stockage de valeurs factices telles que des 1 ou des 0.

On décrit maintenant le calcul du rang d'une permutation pour réaliser un **codage** en exploitant l'invention.

Il existe plusieurs variantes selon le jeu des décompositions de base choisi et leur représentation. Par souci de concision, l'exposé des réalisations possibles ci-après est limité au cas du mode de réalisation préféré pour le jeu des décompositions de base, avec décompositions des factorielles de *l*! et de *l*.

Ci-après, la solution de représentation éclatée des exposants avec $m_{n!}$ exposants par décomposition de base, qui est le cas le plus général, est d'abord exposée. Des variantes de représentation éclatée des exposants sont ensuite décrites. Enfin, la solution de représentation compacte des exposants des décompositions de base est exposée, ainsi que quelques unes de ses variantes. Il apparaîtra alors que l'invention s'applique parfaitement à un traitement de codage du rang d'une permutation.

L'algorithme de Schalkwijk est repris ci-après, comme exemple de traitement d'énumération.

**Représentation éclatée des exposants de la décomposition**

Soit *n* la dimension maximale des codes à permutation utilisés, et $m_{n!}$ le nombre de facteurs premiers intervenant dans la décomposition de la grandeur *n*!

On décrit ci-après un premier mode de réalisation d'un codage utilisant une représentation éclatée des exposants de la décomposition.

Codage selon un premier mode de réalisation

Ici, les exposants des décompositions de base de *l* et *l*! sont stockés préférentiellement selon la "quatrième" solution de la table 4d ci-avant, avec stockage factice pour *l*=0 dans deux tableaux monodimensionnels notés respectivement $\boldsymbol{D_l}$ et $\boldsymbol{D_{l!}}$ ayant $m_{n!} \times (n+1)$ éléments. Comme mentionné ci-avant, on pourrait considérer aussi des tableaux bidimensionnels ayant $m_{n!}$ colonnes et $(n+1)$ lignes. Les exposants de *l* (respectivement *l*!) étant stockés régulièrement (chacun sur $m_{n!}$ valeurs), les opérations de lecture des exposants d'une décomposition de base nécessitent un calcul d'adresse dans le tableau $\boldsymbol{D_l}$ (respectivement $\boldsymbol{D_{l!}}$). Pour lire les exposants de la décomposition de *l*! (respectivement *l*), il faut pointer à l'adresse $(l \times m_{n!})$ du tableau $\boldsymbol{D_{l!}}$ (respectivement $\boldsymbol{D_l}$), et viser ainsi l'adresse de l'exposant $e_{l!}^1$ (respectivement $e_l^1$), l'exposant $e_{l!}^2$ (respectivement $e_l^2$) étant à l'adresse suivante $(l \times m_{n!}+1)$ et plus généralement l'exposant $e_{l!}^i$ (respectivement $e_l^i$) étant à l'adresse $(l \times m_{n!}+i-1)$. Comme mentionné ci-avant, dans des tableaux bidimensionnels, l'exposant $e_{l!}^i$ **(ou** $e_l^i$) est à l'adresse $((l;(i-1))$ (colonne $(i$-1) et ligne*l*).

Il est à noter que s'il n'est pas prévu de stockage factice pour *l*=0, le calcul d'adresse dans le tableau $\boldsymbol{D_l}$ des *n* décompositions de base de *l* (*l* >0) est: $(l-1) \times m_{n!}$.

*Initialisation*

- On initialise à zéro les $m_{n!}$ exposants de la décomposition intermédiaire de $P_k$ (stockés dans un tableau *P* ayant $m_{n!}$ éléments qui est préférentiellement mis à jour à chaque position, comme on le verra en référence à l'étape C-3 ci-après). Ainsi, les instructions sont les suivantes :

  ○ $P[i]=0\ ,\ 1 \le i \le m_{n!}$

- On initialise aussi à zéro le rang *t* et les q poids $w_k^d$ (stockés dans un tableau *w* ayant *q* éléments qui sera mis à jour à chaque position (étape C-2 ci-après)). Les instructions sont les suivantes :

  ○ $t$=0

  ○ $w[i] = 0,\ 0 \le i < q$

  ○ $k$=$n$-1

*Itérations sur l'indice k*

On se réfère à la figure 5 pour suivre l'itération sur les n positions (avec une boucle sur la variable k). La lettre "C" dans les notations des étapes C-n de la figure 5 désigne le mot "codage".

A l'étape C-1, on lit la variable $d_k$ . L'étape C-2 consiste en une mise à jour de l'élément $d_k$ du tableau *w* : $w[d_k] = w[d_k]+1$.

L'étape C-3 est une mise à jour des exposants de la décomposition de $P_k$ (tableau *P*), avec, en particulier :

- une lecture des $m_{n!}$ exposants $e_{w[d_k]}^i$ de la décomposition de base $w[d_k]$ dans le tableau $\boldsymbol{D_l}$ à partir de l'adresse $m_{n!} \times w[d_k]$ (étape C-31), et
- une mise à jour : $P[i]=P[i]+e_{w[d_k]}^i$ , pour $1 \le i \le m_{n!}$ (étape C-32).

Ainsi, pour la mise en oeuvre de l'étape C-31, le premier exposant de la décomposition de base $w[d_k]$ dans le

tableau $D_l$, noté $e^{1}_{w[d_k]}$, est à l'adresse $m_{n!}\times w[d_k]$, le deuxième, noté $e^{2}_{w[d_k]}$, à l'adresse ($m_{n!}\times w[d_k]$+1), et ainsi de suite. Plus généralement, l'exposant $e^{i}_{w[d_k]}$ sera à l'adresse $m_{n!}\times w[d_k]$ + i-1.

Parallèlement, à l'étape C-4, on calcule $S_k$ à partir de la relation habituelle

$$S_k = \sum_{d=0}^{d_k-1} w[d]$$

L'étape C-5 est un test sur la valeur de $S_k$. Si $S_k$ est nulle (flèche O), ce qui implique que le rang partiel $I_k^{d_k}$ est nul (formule (7) ci-avant) et que le rang *t* n'est pas modifié, le traitement se poursuit par l'étape C-11 plus loin. Sinon (flèche N avec $S_k\neq 0$), le traitement se poursuit par l'étape C-6, à laquelle on lit les $m_{n!}$ exposants $e^{i}_{S_k}$ de la décomposition de base $S_k$ dans le tableau $\boldsymbol{D_l}$ à l'adresse $m_{n!}\times S_k$.

Parallèlement, l'étape C-7 consiste à lire les $m_{n!}$ exposants $e^{i}_{(n-1-k)!}$ de la décomposition de base (*n*-1-*k*)! dans le tableau $\boldsymbol{D_{l!}}$ à l'adresse $m_{n!}\times(n\text{-}1\text{-}k)$. On relèvera que l'étape C-7 est effectuée si la somme $S_k$ est non nulle (sortie N du test C-5) de manière à éviter la lecture inutile dans le tableau $\boldsymbol{D_{l!}}$ si, de toutes façons, le rang partiel $I_k^{d_k}$ est nul.

A l'étape C-8, les résultats des différentes lectures des tables peuvent être regroupés pour calculer d'abord les $m_{n!}$ exposants de la décomposition du rang partiel $I_k^{d_k}$, selon la relation : $e^{i}_{I_k^{d_k}} = e^{i}_{(n-1-k)!} + e^{i}_{S_k} - P[i]$, pour 1 $\leq i \leq m_{n!}$

Enfin, à l'étape C-9, on calcule le rang partiel $I_k^{d_k}$ lui-même par la relation :

$$I_k^{d_k} = \prod_{i=1}^{m_{n!}} (p_i)^{e^{i}_{I_k^{d_k}}}$$

On rappelle que le terme $w[d_k]$ est un poids nécessairement inférieur ou égal à la dimension maximale *n* du code à permutation considéré. De même, la somme $S_k$ de tels poids reste inférieure à la dimension maximale *n* et il en est de même, bien entendu, pour (n-1-k). Les décompositions de $w[d_k]$, $S_k$ et (n-1-k)! sont bien répertoriées dans les tables de décompositions des entiers ou des factorielles d'entiers allant jusqu'à la dimension maximale *n*, telles que la table 4d. A partir de la décomposition $w[d_k]$ répertoriée dans une table et de la décomposition de $P_{k-1}$ déterminée à la boucle précédente (k-1) et gardée en mémoire, la décomposition de $P_k$ est déterminée.

A titre d'exemple purement illustratif des étapes de calcul de rang partiel de la figure 5, on considère un code à permutation de dimension n= 8 et q= 4. Dans cet exemple, les exposants sont stockés dans un tableau bidimensionnel à quatre colonnes et neuf lignes, comportant donc 36 éléments. Il peut donc être extrait de la table 4d donnée ci-avant où on a $p_i$ = 2, 3, 5, 7 en colonnes et *l* = 0, ..., 8 en lignes.

Dans cet exemple, on suppose qu'à une position précédente k=3, le tableau des poids *w* est {1, 1, 0, 3} et donc $P_3$= 1! 1 0! 3! = 6. Le tableau P des exposants de la décomposition de $P_3$ (=$2^1\times3^1\times5^0$x$7^0$) est donc {1, 1, 0, 0}.

A la position k=2, pour l'étape C-1, on suppose qu'on a lu $d_2$= 2.

Dans cet exemple, à l'étape C-2, on met à jour l'élément *w*[2] en l'incrémentant de 1 ( *w*[2] = 0 + 1 = 1).

A l'étape C-31, on lit les quatre exposants de la décomposition de 1 (=w[2]), soit 0, 0, 0, 0 (voir dans la table 4d, 6ème à 9ème colonnes et 3ème ligne *l*=1).

Puis (étape C-32), on met à jour le tableau P, on obtient donc P= {1, 1, 0, 0}. A l'étape C-4, on calcule $S_k$ : $S_k$ = *w*[0] + *w*[1] = 1 + 1 = 2. $S_k$ n'est donc pas nul (test C-5).

○ On lit (étape C-6) les quatre exposants de la décomposition de $S_k$ (en se référant toujours à la table 4d, 6ème à 9ème colonnes mais 4ème ligne *l*=2): pour $p_1$ =2 (6ème colonne), l'exposant est 1, et pour $p_i$ =3, 5, 7 (7ème à 9ème colonnes), l'exposant est nul.

○ On lit (étape C-7), les quatre exposants de la décomposition de 5! (correspondant à (n-1-k)!) en se référant toujours à la table 4d, mais cette fois aux 2ème à 5ème colonnes et 7ème ligne $l$=5. Pour $p_1$ =2 (2ème colonne), l'exposant est 3. Pour $p_2$ =3 (3ème colonne), l'exposant est 1 et pour $p_3$ =5 (4ème colonne), l'exposant est aussi 1. En revanche, pour $p_4$ =7 (5ème colonne), l'exposant est nul.

○ A l'étape C-8, les quatre exposants de la décomposition du rang partiel $I_k^{d_k}$ sont calculés:

o pour $p_1$ =2, $e^1_{I_k^{d_k}} = e^1_{(n-1-k)!} + e^1_{S_k} - P[1]$ = 3 + 1 -1 = 3

o pour $p_2$ =3, $e^2_{I_k^{d_k}} = e^2_{(n-1-k)!} + e^2_{S_k} - P[2]$ = 1 + 0 -1 = 0

o pour $p_3$ =5, $e^3_{I_k^{d_k}} = e^3_{(n-1-k)!} + e^3_{S_k} - P[3]$ = 1 + 0 -0 =1

o pour $p_4$ =7, $e^4_{I_k^{d_k}} = e^4_{(n-1-k)!} + e^4_{S_k} - P[4]$ = 0 + 0 -0 = 0

A l'étape C-9, le rang partiel $I_k^{d_k}$ est calculé à partir des exposants de sa décomposition: $2^3 \times 3^0 \times 5^1 \times 7^0 = 40$.

En référence à nouveau à la figure 5, le rang $t$ global de la permutation est lui-même déterminé par mise à jour (avec addition du rang partiel $I_k^{d_k}$ trouvé à l'étape C-9) selon la relation $t = t + I_k^{d_k}$, à l'étape C-10.

L'étape C-11 vise ensuite la décrémentation de la variable $k$ ($k$=$k$-1) et l'étape C-12 est un test sur la valeur de $k$ pour poursuivre ou non le traitement. Ainsi, si $k \geq 0$ (flèche O en sortie du test C-12), on réitère les étapes du traitement à partir de la première étape C-1, avec une valeur de $k$ décrémentée d'une unité. Sinon (flèche N en sortie du test C-12), le traitement est terminé à l'étape C-13 de fin ("END").

Ainsi, on comprendra que l'étape C-9 ci-avant calcule un rang partiel à partir de sa décomposition déterminée à l'étape C-8, elle-même déterminée à partir de trois décompositions intermédiaires :

- $(n\text{-}1\text{-}k)!$
- $S_k$ , et
- $P_k$.

La détermination de deux d'entre elles, $(n\text{-}1\text{-}k)!$ et $S_k$, effectuée aux étapes C-6 et C-7, consiste en une simple lecture dans les tableaux respectifs des décompositions de base $\boldsymbol{D_l}$ et $\boldsymbol{D_{l!}}$. La détermination de la troisième décomposition intermédiaire (celle de $P_k$) peut aussi être effectuée simplement à partir des q décompositions de base de $w[d]!$ lues dans le tableau $\boldsymbol{D_{l!}}$ selon une relation du type $P[i] = \sum_{d=0}^{q-1} e^i_{w[d]!}$, $1 \leq i \leq m_{n!}$

Variantes immédiates

L'étape C-3 présente une variante plutôt avantageuse de détermination de cette décomposition intermédiaire. La décomposition intermédiaire de $P_k$ peut en effet être déterminée à partir d'une décomposition de base lue dans le tableau $\boldsymbol{D_l}$ et d'une autre décomposition intermédiaire (celle de $P_{k+1}$) calculée pour un autre rang partiel $(I_{k+1}^{d_k})$, par exemple le rang partiel $I_{k+1}^{d_k}$ précédent dans l'itération de $k$. Plus généralement, dans une variante de l'invention, une décomposition intermédiaire peut aussi se déduire d'au moins une décomposition intermédiaire précédemment déterminée pour au moins un autre rang partiel.

Ci-avant, on a effectué le calcul du rang par une boucle de la dernière position ($k$=$n$-1) à la première position ($k$=0). Toutefois, l'invention s'applique aussi, bien entendu, à une boucle de la première à la dernière position. Il suffit de changer la phase d'initialisation et d'adapter les étapes C-2 et C-3 et leur ordre. A cet effet, le tableau des poids $w$

peut être initialisé avec les $q$ poids $w_0^d$. Puis, pour $d$ allant de 0 à $q$-1, on lit les $m_{n!}$ exposants de la décomposition de $w[d]!$ dans le tableau $\boldsymbol{D_{l!}}$, pour calculer par addition cumulative les $m_{n!}$ valeurs du tableau de la décomposition intermédiaire (exposants de la décomposition de $P_0$).

L'étape C-3 intervient alors après l'étape C-10 et avant l'étape C-2. La décomposition intermédiaire de $P$ est mise à jour par soustraction à $P[i]$ de l'exposant $e^i_{w[d_k]}$ de la décomposition de base de $w[d_k]$ ($P[i] = P[i] - e^i_{w[d_k]}$, pour $1 \leq i \leq m_{n!}$). Ensuite, l'étape C-2 peut être menée en décrémentant de 1 la valeur de $w[d_k]$($w[d_k]$=$w[d_k]$-1). L'étape C-11 peut viser l'incrémentation de la variable $k$ de 1 et l'étape C-12 teste simplement si $k$=$n$.

On indique brièvement que, pour les codes à permutation de dimension $n$ variable, plutôt que d'effectuer $m_{n_{\max}!}$ opérations, il peut être préférable de lire $m_{n!}$ à l'initialisation pour n'effectuer les opérations que $m_{n!}$ fois.

<u>Variantes générales du premier mode de réalisation</u>

Plus généralement, la mise en oeuvre représentée sur la figure 5 pour un codage au sens de l'invention admet de nombreuses variantes.

Ainsi, dans une première variante, chaque décomposition de base (de $l$ ou $l!$) contient aussi le nombre $m_{l!}$. La lecture du nombre $m_{l!}$ ($0 \leq l \leq n$) présente des avantages. En effet, les étapes C-3 et C-6 à C-10 ne sont plus effectuées $m_{n!}$ fois chacune, mais seulement :

o $m_{w[d_k]!}$ fois pour l'étape C-3,

o $m_{S_k!}$ fois pour l'étape C-6 et pour l'addition $e^i_{(n-1-k)!} + e^i_{S_k}$ de l'étape C-8, et

o $m_{(n-1-k)!}$ fois pour les étapes C-7 et C-9 et pour la soustraction $e^i_{I_k^{d_k}} = e^i_{(n-1-k)!} + e^i_{S_k} - P[i]$ de l'étape C-8.

Si, en outre, on a stocké aussi les valeurs $m_l$ , il n'y a plus qu'à effectuer :

o $m_{w[d_k]}$ fois l'étape C-3, et

o $m_{S_k}$ fois l'étape C-6 et l'addition de l'étape C-8.

Dans une autre variante du codage, si on utilise en plus le stockage des exposants de la décomposition de base de $l$ selon la troisième solution (table 4c ci-avant), l'étape C-3 peut être effectuée pour $m'_{w[d_k]}$ valeurs. De même, l'étape C-6 est effectuée pour $m'_{S_k}$ valeurs. A l'étape C-8, au lieu de prévoir $m_{(n-1-k)!}$ additions et $m_{(n-1-k)!}$ soustractions, le nombre de soustractions à effectuer reste $m_{(n-1-k)!}$ mais seulement $m'_{S_k}$ additions sont nécessaires. En particulier :

- $e^i_{I_k^{d_k}} = e^i_{(n-1-k)!} - e^i_{P_k}$, pour $1 \leq i \leq m_{(n-1-k)!}$
- et $e^{i(j)}_{I_k^{d_k}} = e^{i(j)}_{I_k^{d_k}} + e^{i(j)}_{S_k}$, pour $1 \leq j \leq m'_{S_k}$

Dans une troisième variante, au lieu de décomposer un rang partiel en trois termes (deux au numérateur et un au dénominateur), on le décompose en deux termes dont l'un est un quotient. Ainsi, le rang partiel $I_k^{d_k}$ est décomposé en deux termes :

- la somme $S_k$
- et un quotient

$$R_k = \frac{(n-1-k)!}{\prod_{i=0}^{q-1}(w_k^i!)}.$$

Ce quotient peut être mis à jour par la relation suivante :

$$R_k = \frac{(n-1-k))!}{\prod_{i=0}^{q-1}(w_k^i!)} = \frac{(n-1-(k+1))!\times(n-1-k)}{\prod_{i=0}^{q-1}(w_{k+1}^i!)\times w_k^{d_k}} = R_{k+1}\times\frac{(n-1-k)}{w_k^{d_k}}$$

Ainsi, plutôt que déterminer la décomposition de $R_k$ à partir des q+1 décompositions de base (celles de ($n$-1-$k$)! et des $q$ $w[d_k]$! lues dans le tableau $\boldsymbol{D_{l!}}$), une décomposition intermédiaire de $R_k$ est déterminée à partir de la décomposition intermédiaire de $R_{k+1}$ et des décompositions de base de ($n$-1-$k$) et de $w[d_k]$ (ces deux décompositions de base étant lues dans le tableau $\boldsymbol{D_l}$), ce qui s'écrit : $e^i_{R_k} = e^i_{R_{k+1}} + e^i_{n-1-k} - e^i_{w_k^{d_k}}$

Par rapport aux variantes précédentes, au lieu de déterminer et de stocker la décomposition intermédiaire du dénominateur de $I_k^{d_k}$ (tableau $P$), on détermine puis on stocke la décomposition intermédiaire du quotient $R_k$ (en prévoyant à cet effet un tableau $R$). On remplace l'initialisation à zéro du tableau $P$ par celle du tableau $R$ des exposants de ce rapport. L'étape C-3 devient une étape de simple mise à jour du tableau $R$ (avec une lecture des exposants des décompositions de base de ($n$-1-$k$) et $w[d_k]$)), ce qui s'écrit :

$$R[i] = R[i] + e^i_{n-1-k} - e^i_{w_k^{d_k}}$$

Selon l'option de stockage, cette mise à jour peut être faite avec $m_{n!}$ additions et soustractions ou $m_{(n-1-k)!}$ additions (respectivement $m_{w[d_k]!}$ soustractions), ou encore $m_{(n-1-k)}$ additions (respectivement $m_{w[d_k]}$ soustractions), ou seulement pour les exposants non nuls de $w[d_k]$ et ($n$-1-$k$) : $m'_{(n-1-k)}$ additions et $m'_{w[d_k]}$ soustractions. L'étape C-8 ne comporte plus que des additions du type :

$$e^i_{I_k^{d_k}} = R[i] + e^i_{S_k}$$

Selon l'option de stockage, on compte alors $m_{n!}$ additions ou $m_{S_k!}$ additions, ou encore $m_{S_k}$ additions, ou seulement pour les exposants non nuls de $S_k$ : $m'_{S_k}$ additions.

On notera que ce rapport $R_k$ n'est pas forcément entier, ce qui signifie que les exposants $R[i]$ peuvent être négatifs. Dans cette variante, la décomposition des factorielles au codage (donc le tableau $\boldsymbol{D_{l!}}$) n'est plus utile, de sorte qu'un simple jeu de ($n$+1) décompositions de base des entiers $l$ ($l \leq n$) peut être utilisé en ne stockant que le tableau $\boldsymbol{D_l}$.

**Représentation compacte des exposants de la décomposition**

On décrit maintenant un second mode de réalisation d'un codage, basé sur une représentation **compacte** des exposants de la décomposition.

Les exposants des décompositions de base sont représentés de façon compacte et non plus sous forme éclatée comme décrit ci-avant en référence au premier mode de réalisation. Par souci de concision, on n'expose que le cas où la représentation compacte des exposants tient sur un seul mot. Ces mots sont donc stockés comme décrit ci-avant, avec stockage d'un mot factice pour $l$=0 dans deux tableaux notés respectivement $\boldsymbol{D'_l}$ et $\boldsymbol{D'_{l!}}$ à ($n$+1) éléments. Le calcul de l'adresse dans ces deux tableaux d'un mot contenant les exposants d'une décomposition de base est direct

car, pour lire le mot de la décomposition de *l*! (respectivement *l*), il suffit de pointer à l'adresse *l* du tableau $D'_{l!}$ (respectivement $D'_l$).

On remarquera que sans stockage d'un mot factice pour *l*=0, le mot correspondant à une décomposition de base *l* (avec *l*>0) est à l'adresse (*l*-1) dans le tableau $D'_l$.

Codage selon un second mode de réalisation

*Initialisation*

- On initialise à zéro le mot $e_P$ contenant la représentation compacte des $m_{n!}$ exposants de la décomposition intermédiaire de $P_k$ : $e_P = 0$
  Le mot $e_P$ sera mis à jour à chaque position (étape CC-3 ci-après).
- Comme précédemment, on initialise aussi à la valeur zéro le rang t et les *q* poids $w_k^d$ stockés dans un tableau *w* ayant *q* éléments qui sera mis à jour à chaque position (étape CC-2 ci-après). Les instructions correspondantes sont :
  - $t$=0
  - $w[i] = 0$ , $0 \le i < q$
  - $k=n-1$

*Itération sur les n positions (boucle sur k)*

On se réfère maintenant à la figure 6 pour suivre les étapes principales du codage dans ce second mode de réalisation. Les lettres "CC" dans les notations des étapes CC-n de la figure 6 désignent le mot "codage" avec une "représentation compacte".

A l'étape CC-1, on lit la variable $d_k$. L'étape CC-2 consiste en une mise à jour de la variable *w* : $w[d_k]=w[d_k]+1$.

L'étape CC-3 est une mise à jour du mot $e_P$ avec, en particulier :

- à l'étape CC-31, la lecture du mot $e_{w[d_k]}$ contenant la représentation compacte des exposants de la décomposition de $w[d_k]$ dans le tableau $D'_l$ puis,
- à l'étape CC-32, la mise à jour proprement dite du mot $e_P = e_P + e_{w[d_k]}$

Parallèlement, à l'étape CC-4, on calcule la somme $S_k$ : $S_k = \sum_{d=0}^{d_k-1} w[d]$. L'étape suivante CC-5 est un test sur la valeur de $S_k$ . Si la somme $S_k$ est nulle (flèche N), on décrémente directement l'indice *k*. Sinon (flèche O en sortie du test CC-5), le traitement se poursuit par la lecture du mot $e_{S_k}$ contenant la représentation compacte des exposants de la décomposition de $S_k$ dans le tableau $D'_l$ à l'étape CC-6.

Parallèlement (et avantageusement selon le résultat du test CC-5), on lit le mot $e_{(n-1-k)!}$ contenant la représentation compacte des exposants de $(n-1-k)!$ dans le tableau $D'_{l!}$, à l'étape CC-7.

A l'étape CC-8, Les résultats issus des différentes étapes CC-3, CC-6, CC-7 sont regroupés pour calculer le mot $e_{I_k^{d_k}}$ contenant la représentation compacte de la décomposition du rang partiel $I_k^{d_k}$ , par deux opérations simples (préférentiellement une addition suivie d'une soustraction) :

$$e_{I_k^{d_k}} = e_{(n-1-k)!} + e_{S_k} \text{ puis } e_{I_k^{d_k}} = e_{I_k^{d_k}} - e_P$$

L'étape CC-9 vise l'extraction des $m_{n!}$ exposants $e^i_{I_k^{d_k}}$ de la décomposition du rang partiel $I_k^{d_k}$ et contenus

dans le mot $e_{I_k^{d_k}}$, par décalage approprié des bits du mot comme décrit précédemment. A cet effet, il est prévu une boucle sur un indice *i* allant de 1 à $m_{n!}$ (initialisation CC-91 de *i* à 1, test CC-93 sur la valeur de *i* et incrémentation CC-94 tant que *i* n'atteint pas la valeur de $m_{n!}$). On applique alors sur chaque boucle de *i* des instructions CC-92 du type :

$$\text{i'1)} \quad e^i_{I_k^{d_k}} = e_{I_k^{d_k}} \;\&\; ((1 << b_n^i) - 1)$$

$$\text{i'2)} \quad e_{I_k^{d_k}} = e_{I_k^{d_k}} >> b_n^i$$

On rappelle que les notations "<<b" et ">>b" désignent respectivement un décalage à gauche et un décalage à droite de b bits. Par ailleurs, la notation "&" désigne l'opérateur logique bit à bit "ET". L'instruction i'1) consiste à récupérer les $b_n^i$ bits de poids faible de $e^i_{I_k^{d_k}}$. En pratique, les masques correspondant à l'instruction "$((1 << b_n^i) - 1)$" sont câblés en dur.

En d'autres termes, on applique au départ (pour l'indice de boucle *i* égal à 1) un masque $((1 << b_n^1) - 1)$ des bits de poids fort de manière à ne récupérer d'abord que les $b_n^1$ bits de poids faible de $e_{I_k^{d_k}}$ donnant l'exposant $e^1_{I_k^{d_k}}$ associé au premier facteur premier $p_1$.

Puis :

- on décale les bits de $e_{I_k^{d_k}}$ de $b_n^1$ "à droite" pour récupérer les bits de poids plus fort donnant les exposants associés au facteur premier suivant $p_2$ (masque $((1 << b_n^2) - 1)$ des bits de poids fort,
- on extrait alors l'exposant $e^2_{I_k^{d_k}}$,
- puis, on applique un décalage à droite de $b_n^2$ bits,

et ainsi de suite jusqu'à i=$m_{n!}$.

L'étape suivante CC-10 consiste à calculer le rang partiel $I_k^{d_k}$ comme suit :

$$I_k^{d_k} = \prod_{i=1}^{m_{n!}} (p_i)^{e^i_{I_k^{d_k}}}$$

Puis, on additionne le rang partiel $I_k^{d_k}$ au rang total *t* $(t = t + I_k^{d_k}$ à l'étape CC-11).

La valeur de l'indice *k* est décrémentée à l'étape suivante CC-12 (*k*=*k*-1) et, avant de recommencer les étapes CC-4, CC-1, CC-7 et suivantes avec cette valeur décrémentée, on vérifie au test CC-13 si la valeur de *k* n'a pas atteint -1 (*k*<0), auquel cas le traitement est terminé (étape CC-14).

Ainsi, indépendamment de la représentation des décompositions, la présente invention permet de calculer efficacement des rangs partiels. L'étape CC-10 vise le calcul d'un rang partiel à partir de sa décomposition déterminée aux étapes précédentes CC-8 et CC-9. Trois décompositions intermédiaires (des termes (*n*-1-*k*)!, $S_k$ et $P_k$) sont utilisées. La détermination de deux d'entre elles ((*n*-1-*k*)! et $S_k$) effectuées aux étapes CC-6 et CC-7 consiste en une simple lecture de leur représentation compacte dans les tableaux ***D'$_{l!}$*** et ***D'$_l$***. La détermination de la troisième décomposition intermédiaire ($P_k$) effectuée à l'étape CC-3 nécessite aussi une lecture du tableau ***D'$_l$*** suivie d'une mise à jour de la

représentation compacte de cette décomposition intermédiaire par addition de la représentation compacte de la décomposition de base qui a été lue.

Comme indiqué précédemment en référence au premier mode de réalisation, le stockage des valeurs $m_{l!}$ ($0 \leq l \leq n$) permet de réduire la complexité des étapes CC-9 et CC-10. La boucle d'extraction des exposants de la décomposition d'un rang partiel $I_k^{d_k}$ est effectuée $m_{(n-1-k)!}$ fois au lieu de $m_{n!}$ fois. De même, l'étape CC-10 ne comporte plus $m_{n!}$ multiplications mais $m_{(n-1-k)!}$ multiplications.

On décrit maintenant le **décodage** du rang d'une permutation en exploitant l'invention.

Il existe, là encore, plusieurs variantes selon la solution de représentation des décompositions de base (éclatée ou compacte). On décrit ci-après un premier mode de réalisation du décodage, homologue du premier mode de réalisation décrit ci-avant pour le codage utilisant la représentation éclatée des décompositions et leur stockage selon la quatrième solution relative à la table 4d donnée plus haut. Il apparaîtra que l'invention s'applique parfaitement à un décodage du rang d'une permutation en prenant comme exemple l'algorithme de Schalkwijk.

Décodage selon un premier mode de réalisation

Le décodage utilisant une représentation éclatée des exposants de la décomposition commence préférentiellement par une initialisation des données comme suit.

*Initialisation*

- On initialise le tableau des valeurs *w* avec les *q* poids $w_0^d$ (*w* est mis à jour en fin de boucle sur chaque position de l'étape D-19 qui sera décrite ci-après). Une instruction appropriée peut être du type :

  ○

$$w[i] = w_0^i,\ 0 \leq i < q$$

- On calcule les $m_{n!}$ exposants de la décomposition du terme $P_0$ (stockés dans un tableau *P* ayant $m_{n!}$ éléments aussi mis à jour à chaque position en fin de boucle sur chaque position à l'étape D-18 décrite ci-après). Les instructions appropriées peuvent être du type :

  ○

$$P[i] = 0 \text{ pour } 1 \leq i \leq m_{n!}$$

  ○ Boucle de *d*=0 à q-1

    ■ lecture des $m_{n!}$ exposants $e^i_{w_0^d!}$ de la décomposition de $w_0^d!$ dans le tableau $\mathbf{D}_{l!}$

    ■ puis

$$P[i] = P[i] + e^i_{w_0^d!},\text{ avec } 1 \leq i \leq m_{n!}$$

- On initialise enfin *k*=0

On se réfère maintenant à la figure 7 pour suivre les étapes principales du décodage selon le premier mode de réalisation. La lettre "D" dans les notations des étapes D-n de la figure 7 désigne le mot "décodage".

*Itération sur les n positions (boucle sur l'indice k)*

La première étape D-1 consiste en une lecture des $m_{n!}$ exposants $e^i_{(n-1-k)!}$ de la décomposition de (*n*-1-*k*)! dans le tableau $\boldsymbol{D_{l!}}$

L'étape suivante D-2 fixe les valeurs $d_k$= 0 et $I_k^{d_k} = 0$.

On procède ensuite à la recherche de la première valeur $d_k$ de l'alphabet telle que $w[d_k]\neq 0$. On prévoit à cet effet un test D-3 vérifiant si $w[d_k]=0$, auquel cas (flèche O) on incrémente la valeur de $d_k$ ($d_k= d_k+1$) et on réitère le test D-3 jusqu'à trouver une valeur $w[d_k]$ non nulle. Si une telle valeur a été trouvée (flèche N pour $w[d_k]\neq 0$), l'étape suivante est un test D-5 sur la valeur du rang *t*. Si le rang est nul (flèche O en sortie du test D-5), la mise en oeuvre des étapes suivantes est inutile jusqu'à la mise à jour des exposants de $P_k$ (étape D-18). Si le rang n'est pas nul (flèche N en sortie du test D-5), le traitement se poursuit par les étapes suivantes D-6 et D-7 auxquelles on fixe respectivement $S_k$ = 0 et une valeur intermédiaire $I_k$ à $I_k = I_k^{d_k}$.

L'étape suivante D-8 est un calcul de mise à jour de la somme $S_k = S_k + w[d_k]$. Elle est suivie par la lecture du tableau $\boldsymbol{D_l}$ (étape D-9) des $m_{n!}$ exposants $e^i_{S_k}$ de la décomposition de la somme trouvée $S_k$.

L'étape D-10 vise le calcul des $m_{n!}$ exposants $e^i_{I_k^{d_k}}$ de la décomposition du rang partiel, à partir de la relation : $e^i_{I_k^{d_k}} = e^i_{(n-1-k)!} + e^i_{S_k} - P[i]$, avec $1\leq i\leq m_{n!}$. Les exposants *P*[*i*], initialisés comme décrit ci-avant, sont mis à jour à l'étape D-18 qui sera décrite plus loin, à la fin de la boucle courante et pour une boucle suivante.

L'étape D-11 vise le calcul du rang partiel :

$$I_k^{d_k} = \prod_{i=1}^{m_{n!}} (p_i)^{e^i_{I_k^{d_k}}}$$

Les trois étapes suivantes visent un test sur la valeur du rang total t, en le comparant à la valeur du rang partiel. Pour ce faire, à l'étape D-12, on incrémente la valeur de $d_k$ ($d_k= d_k+1$) et le test D-13 est le suivant : $t - I_k^{d_k} \geq 0$ ?

Si l'inégalité est vérifiée (flèche O), on réitère les étapes D-7 à D-13 avec la nouvelle valeur de $d_k$ incrémentée. Sinon (flèche N), le traitement se poursuit par l'étape D-14 de décrémentation de la valeur de $d_k$ ($d_k= d_k-1$) pour revenir à la valeur de $d_k$ avant l'étape D-12. Pour cette valeur de $d_k$, le rang partiel $I_k^{d_k}$ prend la valeur intermédiaire $I_k$ précitée (étape D-15 : $I_k^{d_k} = I_k$). Ensuite, on met à jour le rang t, lequel devient $t = t - I_k^{d_k}$ (étape D-16), et on met à jour les exposants de $P_k$ (dans le tableau P) grâce à la lecture des $m_{n!}$ exposants $e^i_{w[d_k]}$ de la décomposition de $w[d_k]$ dans le tableau $\boldsymbol{D_l}$ (étape D-17), suivie de la mise à jour proprement dite des exposants $P[i] = P[i] - e^i_{w[d_k]}$ pour $1 \leq i \leq m_{n!}$ (étape D-18). On décrémente ensuite la valeur de $w[d_k]$ ($w[d_k]=w2[d_k]-1$ :
étape D-19) et on incrémente celle de l'indice k ($k=k+1$ : étape D-20) pour préparer la boucle suivante.

Avant de reboucler sur la première étape D-1, on vérifie que les *n* composantes n'ont pas toutes été traitées. Pour ce faire, on prévoit le test D-21 sur la valeur de *k,* en la comparant à *n* ($k < n$). Tant que l'indice *k* n'a pas atteint la valeur *n* (flèche O en sortie du test D-21), on recommence le traitement à l'étape D-1 pour une valeur suivante de *k.* Sinon (flèche N en sortie du test D-21), le traitement est terminé à l'étape de fin D-22.

On retiendra que l'étape D-11 vise le calcul d'un rang partiel en utilisant sa décomposition déterminée à l'étape D-10 à partir de trois décompositions intermédiaires des termes respectifs (*n*-1-*k*)!, $S_k$ et $P_k$. Les déterminations de deux d'entre elles ((*n*-1-*k*)! et $S_k$) effectuées aux étapes D-1 et D-9 consistent en une simple lecture dans les tableaux respectifs $\boldsymbol{D_{l!}}$ et $\boldsymbol{D_l}$. La détermination de la troisième décomposition intermédiaire ($P_k$) effectuée à l'étape D-18 s'effectue aussi par une lecture du tableau $\boldsymbol{D_l}$ (étape D-17) suivie d'une mise à jour par des exposants de cette décomposition intermédiaire

par soustraction des exposants de la décomposition de base lue (étape D-18). L'initialisation décrite ci-avant de cette décomposition intermédiaire nécessite $q$ lectures du tableau $\boldsymbol{D_{l!}}$ suivie d'une mise à jour par des exposants de cette décomposition intermédiaire par addition des exposants des $q$ décompositions de base lues.

Comme pour le codage décrit ci-avant, le traitement de la figure 7 admet des variantes qui permettent, le cas échéant, de réduire la complexité de certaines étapes.

Une variante consistant à utiliser les exposants du rapport $R_k$ (comme décrit précédemment) est particulièrement intéressante. En effet, dans le traitement de décodage décrit ci-avant en référence à la figure 7, on calcule pour une position donnée $k$, les exposants $e^i_{I_k^{d_k}}$ pour plusieurs valeurs de d. Pour chaque valeur de d testée, les autres variantes nécessitent pour chaque exposant une soustraction et une addition $(e^i_{I_k^{d_k}} = e^i_{(n-1-k)!} - e^i_{P_k} + e^i_{S_k})$. Cependant, la variante utilisant les exposants du rapport $R_k$ ne requiert qu'une addition $(e^i_{I_k^{d_k}} = R[i] + e^i_{S_k})$ car seuls la somme $S_k$ et ses exposants $e^i_{S_k}$ varient en fonction de d pour une position k donnée.

Décodage selon un second mode de réalisation

On décrit ci-après, en référence maintenant à la figure 8, un exemple de réalisation d'un décodage utilisant la représentation compacte des décompositions.

Au préalable, on prévoit une initialisation des données comme suit.

*Initialisation*

- On se réfère d'abord au tableau w de ayant q éléments pour déterminer les termes $w[i] = w_0^i$ pour $0 \leq i < q$ .
- On calcule le mot $e_P$ contenant la représentation compacte des $m_{n!}$ exposants de la décomposition de $P_k$. Pour ce faire :
  - ■ on fixe $e_P = 0$
  - ■ et on prévoit une boucle de $d$=0 à $q$-1:
    - ○ avec lecture du mot $e_{w_0^d!}$ contenant la représentation compacte des $m_{n!}$ exposants de $w_0^d!$ dans le tableau $\boldsymbol{D'_{l!}}$
    - ○ et mise à jour de $e_P = e_P + e_{w_0^d!}$
- On fixe ensuite $k$=0

*Itération sur les n positions (boucle sur k)*

Les lettres "DC" dans les notations des étapes DC-n de la figure 8 désignent le mot "décodage" avec une "représentation compacte".

L'étape DC-1 consiste à lire le mot $e_{(n-1-k)!}$ contenant la représentation compacte des $m_{n!}$ exposants du terme ($n$-1-$k$)! dans le tableau $\boldsymbol{D'_{l!}}$

Les étapes DC-2 à DC-8 sont similaires aux étapes D-2 à D-8 décrites ci-avant en référence à la figure 7.

En revanche, à l'étape DC-9, on lit le mot $e_{S_k}$ contenant la représentation compacte des $m_{n!}$ exposants de la somme $S_k$ dans le tableau $\boldsymbol{D'_l}$. Puis, à l'étape DC-10, on calcule le mot contenant la représentation compacte des exposants du rang partiel $I_k^{d_k}$, préférentiellement comme suit :

$$e_{I_k^{d_k}} = e_{(n-1-k)!} + e_{S_k} \text{ puis } e_{I_k^{d_k}} = e_{I_k^{d_k}} - e_P$$

L'étape générale DC-11 consiste globalement en une extraction des exposants du rang partiel $I_k^{d_k}$. A cet effet, on prévoit :

- une boucle sur $i$ ($1 \le i \le m_{l!}$) (initialisation de i=1 à l'étape DC-111 et après l'extraction de l'exposant $e^i_{I_k^{d_k}}$ décrite ci-après (étape DC-112), comparaison (test DC-113) de l'indice de boucle i à la valeur $m_{n!}$, avec incrémentation de l'indice i (étape DC-114) tant que la valeur $m_{n!}$ n'a pas été atteinte) ;
- extraction de l'exposant $e^i_{I_k^{d_k}}$ (étape DC-112) :

  représenté dans les bits de poids faible de l'exposant compact $e_{I_k^{d_k}}$ par masquage des bits de poids forts de $e_{I_k^{d_k}}$ par le masque $((1 << b_n^i) - 1)$ : :

$$e^i_{I_k^{d_k}} = e_{I_k^{d_k}} \; \& \; ((1 << b_n^i) - 1)$$

  ce masquage étant suivi d'un décalage à droite de $b_n^i$ bits de l'exposant compact $e_{I_k^{d_k}}$ :

$$e_{I_k^{d_k}} = e_{I_k^{d_k}} >> b_n^i$$

Cette étape générale DC-11 est similaire à l'étape générale CC-9 de la figure 6 pour le codage.

Les étapes DC-12 à DC-17 sont, quant à elles, similaires aux étapes D-11 à D-16 décrites ci-avant en référence à la figure 7 propre au décodage en représentation éclatée.

La mise à jour des exposants de $P_k$ (tableau $P$) à l'étape générale DC-18 se fait, en revanche, à l'étape DC-181, en lisant le mot $e_{w[d_k]}$ contenant la représentation compacte des $m_{n!}$ exposants de $w[d_k]$ dans le tableau $\boldsymbol{D'_l}$ et la mise à jour proprement dite des exposants de $P_k$ ($e_P = e_P - e_{w[d_k]}$) s'effectue ensuite à l'étape DC-182.

Ensuite, les étapes DC-19 à DC-22 sont similaires aux étapes D-19 à D-22 de la figure 7 propre au décodage utilisant une décomposition éclatée.

On décrit maintenant les différents avantages qu'offrent les variantes exposées ci-avant.
Les variantes du premier mode de réalisation avec représentation éclatée, utilisant les tables de $m_{l!}$ (et/ou $m_l$ ou $m'_l$), comportent moins d'opérations d'additions/soustractions que le mode de réalisation principal qui n'utilise que la table des valeurs $m_{n!}$.

Dans ce cas, le gain en complexité est important surtout pour les dernières positions (c'est-à-dire lorsque $m_{(n-k)!}$, $m'_l$ ou $m_l$ sont bien inférieurs à $m_{n!}$). Néanmoins, ce gain en complexité s'accompagne d'un accroissement de la complexité des étapes de lecture en mémoire (étapes C-31, C-6 et C-7). Si le nombre de valeurs à lire est moindre, le calcul d'adresse est en revanche plus compliqué.

Un compromis intéressant consiste alors à stocker régulièrement les décompositions de base (avec $m_{n!}$ exposants) pour faciliter l'adressage des tableaux $\boldsymbol{D_l}$ et $\boldsymbol{D_{l!}}$ et de stocker alors les valeurs $m_{l!}$ dans un tableau $\boldsymbol{D_m}$ à ($n$+1) éléments. Il convient alors de stocker aussi les valeurs $m_l$ pour réduire efficacement le nombre d'additions/soustractions. Toutefois, cette mesure s'accompagne nécessairement d'une lecture des valeurs $m_{S_k}$ (respectivement $m_{w[d_k]}$), avant les étapes C-6 et D-9 (respectivement C-3 et D-19) tandis que la valeur $m_{(n-k)!}$ ne doit être lue qu'au début de chaque itération sur $k$.

Par ailleurs, les avantages apportés par la représentation compacte par rapport à la représentation éclatée sont les suivants :

- l'étape de mise à jour du tableau *P* ne comporte plus maintenant qu'une seule addition (respectivement soustraction) au codage (respectivement au décodage),
- le calcul de l'exposant $e_{I_k^{d_k}}$ ne nécessite aussi qu'une seule addition et qu'une seule soustraction,
- les calculs d'adresse pour la lecture des mots $e_K$ sont directs et ne nécessitent, pour chaque valeur *K*, qu'un seul accès et lecture mémoire.

Par contre, la représentation compacte nécessite une extraction des exposants du rang partiel $I_k^{d_k}$ contenus dans le mot $e_{I_k^{d_k}}$ (étapes CC-9 et DC-11). Toutefois, cette opération n'est pas forcément un inconvénient pour le calcul du rang partiel à partir de sa décomposition en facteurs premiers, comme on le verra ci-après.

On décrit ci-après les avantages de telles variantes pour le calcul du rang partiel à partir de sa décomposition en facteurs premiers.

La complexité de l'étape de calcul du produit des puissances des facteurs premiers, au sens des étapes C-9 et CC-10 (respectivement D-11 et DC-12) au codage (respectivement au décodage) croît de façon importante avec le nombre de facteurs, même si elle reste bien inférieure à la complexité de la division au sens de l'art antérieur. Or, en pratique, beaucoup des exposants de la décomposition d'un rang partiel sont nuls et donc les puissances correspondantes sont égales à 1. Souvent, tous les exposants sont nuls ou les premiers exposants seulement ne sont pas nuls. Il est donc utile de pouvoir détecter et ne garder que les puissances d'exposants non nuls. Dans la représentation détaillée, cette détection ne peut s'effectuer que par $m_{n!}$ tests ou $m_{(n-1-k)!}$ tests (un par facteur premier).

Avantageusement, la représentation compacte permet de tester avec un seul test si tous les exposants sont nuls (si $e_{I_k^{d_k}} = 0$) et dans ce cas, le rang $t'$=1.

En outre, la détection du bit de poids fort de $e_{t'}$ permet d'obtenir l'indice du plus grand facteur premier d'exposant non nul dans le rang *t'* et de réduire le nombre de répétitions de la boucle de l'étape CC-9 (respectivement DC-11) au codage (respectivement au décodage).

Il est à noter néanmoins que la détection des exposants non nuls, en représentation détaillée comme en représentation compacte, augmente la complexité. Si tous les exposants sont non nuls, la complexité de la multiplication des puissances des facteurs premiers reste la même et s'ajoute alors à cette complexité celle de la procédure de détection des exposants non nuls.

Ainsi, dans une autre variante, la détection des exposants nuls peut être menée uniquement si le nombre possible de facteurs premiers devient grand (*k* bien inférieur à *n*) et que la complexité de la multiplication de leurs puissances est supérieure à la complexité de la procédure de détection. Pour ce faire, des boucles différentes selon les positions peuvent être prévues, même si cette implémentation s'effectue au détriment d'un accroissement des lignes d'instruction.

Il est aussi possible de combiner les représentations éclatée et compacte. Pour les dernières positions (la valeur $m_{l!}$ étant faible), le calcul des décompositions intermédiaires nécessite peu d'opérations. On favorisera alors l'utilisation d'une représentation éclatée qui ne nécessite pas d'extraction des exposants d'un rang partiel. En revanche, pour les premières positions, on favorisera plutôt l'utilisation d'une représentation compacte.

On décrit maintenant quelques exemples de réalisation dans des codeurs/décodeurs existants.

### Codeur 3GPP AMR-WB+

Le codeur 3GPP AMR-WB+ (norme [3GPPTS26.304]) utilise une quantification vectorielle algébrique dont le dictionnaire est une union des codes à permutation du réseau de Gosset $RE_8$ de dimension 8.

La technique TCX correspond à un codage prédictif par transformée. Plus précisément, il s'agit d'une méthode de codage par transformée FFT appliquée après filtrage de pondération perceptuelle. Dans la norme [3GPPTS26.304], le spectre FFT obtenu est découpé en sous-bandes (ou sous-vecteurs) de dimension n=8 et ces sous-vecteurs sont codés séparément. La quantification des sous-vecteurs utilise le réseau régulier de points $RE_8$. Les dictionnaires de quantification en dimension 8 sont composés d'une union de codes à permutations de type I issus du réseau de points $RE_8$.

Dans le codeur TCX selon la norme [3GPPTS26.304], chaque code à permutation correspond à un vecteur leader signé donné en dimension *n*=8. L'indice de quantification d'un point du réseau $RE_8$ est calculé par une formule du type :

indice = offset de cardinalité + rang de la permutation

Le rang est calculé par la formule de Schalkwijk tandis que l'offset de cardinalité est tabulé. Néanmoins, ces leaders signés sont représentés par l'intermédiaire de leurs leaders absolus afin d'optimiser le stockage et la recherche dans les codes à permutations. On trouve la liste des leaders absolus associés dans la référence :

"Low-complexity multi-rate lattice vector quantization with application to wideband TCX speech coding at 32 kbit/s" par Ragot S., Bessette B., Lefebvre R., dans Proc. ICASSP, vol. 1, mai 2004 pp. 501-4.

Pour illustrer les différentes variantes de l'invention, trois exemples de réalisation sont présentés ci-après. Les deux premiers exemples de réalisation concernent le calcul du rang d'une permutation (codage), l'un utilisant une représentation éclatée des décompositions et l'autre une représentation compacte.

Dans ces exemples de réalisation ci-après et les annexes correspondantes, les tableaux *R* et *P* sont indexés de *R*[0] à *R*[$m_{n!}$-1] et de *P*[0] à *P*[$m_{n!}$-1] (et non de 1 à $m_{n!}$ comme décrit à titre d'exemple ci-avant), et ce, sans aucune incidence particulière sur le traitement pour le calcul du rang.

<u>Premier exemple de réalisation (codage)</u>

Dans ce mode de réalisation, on utilise une représentation éclatée des décompositions de base.

On stocke leurs exposants dans deux tableaux à 36 éléments (=(8+1)x4). Il s'agit des tableaux donnés en annexe A-11 et notés $\boldsymbol{D_l}$ [36] (contenant les exposants des décompositions des entiers *l* (0≤*l*≤8) donc avec stockage d'une décomposition factice pour 0) et $\boldsymbol{D_{l!}}$ [36] (contenant les exposants des décompositions de leurs factorielles).

On stocke aussi les trois tableaux des puissances de 3, 5 et 7 :

Pow3[4] = { 1, 3, 9, 27 } ; Pow5[3] = { 1, 5, 25 } ; Pow7[3] = { 1, 7, 49 }

Dans ce mode de réalisation, la décomposition d'un rang partiel est déterminée à partir de deux décompositions intermédiaires, l'une étant la décomposition de base de l'entier $S_k$ et l'autre étant la décomposition intermédiaire du quotient :

$$R_k = \frac{(7-k)!}{\prod_{i=0}^{q-1}(w_k^i!)}$$

Comme indiqué plus haut, plutôt que de déterminer la décomposition intermédiaire de $R_k$ à partir de décompositions de base correspondant aux (*q*+1) décompositions de base de (7-*k*)! et $(w_k^i!)_{i=0,\ldots,q-1}$, on détermine cette décomposition intermédiaire à partir de la décomposition intermédiaire de $R_{k+1}$ et des deux décompositions de base de (7-*k*) et de $w_k^{d(k)}$. Les quatre exposants de cette décomposition intermédiaire sont stockés dans un tableau *R*.

**Table 11 : Maximum de $m_l$ ou de $m_{l!}$ pour les décompositions des termes d'un rang partiel à la position k et pour les codes à permutation de dimension 8**

| k | (7-k)! | $m_{(7-k)!}$ | max($w_k^i$) | max($m_{w_k^i}$) | max($S_k$) | max($m_{S_k}$) |
|---|---|---|---|---|---|---|
| 7 | 0 | 1 | 1 | 1 | 0 | 0 |
| 6 | 1 | 1 | 2 | 1 | 1 | 1 |
| 5 | 2 | 1 | 3 | 2 | 2 | 1 |

(suite)

| k | (7-k)! | $m_{(7-k)!}$ | max( $w_k^i$ ) | max( $m_{w_k^i}$ ) | max($S_k$) | max($m_{S_k}$) |
|---|---|---|---|---|---|---|
| 4 | 3 | 2 | 4 | 2 | 3 | 2 |
| 3 | 4 | 2 | 5 | 3 | 4 | 2 |
| 2 | 5 | 3 | 6 | 3 | 5 | 3 |
| 1 | 6 | 3 | 7 | 4 | 6 | 3 |
| 0 | 7 | 4 | 8 | 4 | 7 | 4 |

L'invention exploite la connaissance de $m_{(7-k)!}$ et des maxima de $m_{w_k^i}$ et de $m_{S_k}$ indiqués pour chaque position dans la table 11 ci-dessus pour ne pas calculer les exposants des facteurs premiers d'indices plus grands que ces bornes.
Le traitement correspondant est donné en annexe A-12. On note que la boucle sur les positions est éclatée. On note aussi que l'exposant du facteur premier $p_i$ du quotient est stocké dans l'élément *R*[i-1] du tableau *R* à 4 éléments.

Deuxième exemple de réalisation (codage)

Dans une variante avec le codeur 3GPP AMR-WB+, les décompositions de base sont représentées de façon compacte. On stocke les mots contenant leurs exposants dans deux tableaux à 9 éléments (=(8+1)). En se référant à l'annexe A-21, le tableau ***D'$_l$*** contient les mots pour les décompositions des entiers *l* ($0 \leq l \leq 8$ ) (donc avec stockage factice de la décomposition pour *l*=0) et le tableau ***D'$_{l!}$*** contient les mots pour les décompositions de leurs factorielles.
On stocke aussi les puissances de 3, 5 et 7 dans un tableau Pow[12] à 12 éléments (avec stockage factice de 0 pour les puissances non utilisées).
La décomposition d'un rang partiel est déterminée à partir de trois décompositions intermédiaires, deux étant les décompositions de base de l'entier $S_k$ et de la factorielle (7-*k*)! et la troisième étant une décomposition intermédiaire du dénominateur du rang partiel :

$$P_k = \prod_{i=0}^{q-1} (w_k^i!)$$

Comme indiqué précédemment, plutôt que de déterminer la décomposition intermédiaire de $P_k$ à partir des *q* décompositions de base de $(w_k^i!)_{i=0,\ldots,q-1}$ , on détermine cette décomposition à partir de la décomposition intermédiaire de $P_{k+1}$ et de la décomposition de base de $w_k^{d(k)}$ . Le mot compact contenant les quatre exposants de cette décomposition intermédiaire est noté "eP" dans l'annexe A-22. En outre, on note "el" le mot compact contenant les quatre exposants de la décomposition d'un rang partiel.
Ici encore, on exploite la connaissance de $m_{(7-k)!}$ pour n'extraire que $m_{(7-k)!}$ exposants du mot compact représentant la décomposition d'un rang partiel.
Le traitement correspondant fait l'objet de l'annexe A-22. Là encore, la boucle sur les positions est éclatée.

Troisième exemple de réalisation (décodage)

Le troisième exemple de réalisation traite du décodage du rang d'une permutation, en codage 3GPP AMR-WB+.
On utilise préférentiellement une représentation éclatée des décompositions de base comme dans le premier exemple de réalisation et une décomposition du rang partiel en trois termes comme dans le second exemple de réalisation. La boucle sur les positions n'est pas éclatée toutefois.
Comme indiqué précédemment, plutôt que de déterminer la décomposition intermédiaire de $P_k$ à partir de décompositions de base, on la détermine à partir d'une décomposition intermédiaire de $P_{k-1}$ et de la décomposition de base de $w_k^{d_k}$ . Les quatre exposants de cette décomposition intermédiaire sont stockés dans un tableau *P*. De même,

à partir de la décomposition intermédiaire de $P_k$ et de la décomposition de base de (7-k)!, on calcule une autre décomposition intermédiaire (celle du quotient) dont les exposants sont stockés dans un tableau *R*.

Le traitement correspondant fait l'objet de l'annexe A-3. On note que l'exposant du facteur premier $p_i$ du quotient (respectivement du produit) est stocké dans l'élément *R*[i-1] (resp. *P*[i-1]) du tableau *R* (resp. *P*) à quatre éléments.

Ainsi, le premier exemple ci-avant utilise une décomposition du rang partiel en deux termes (dont un quotient), les deux autres exemples utilisent une décomposition en trois termes (deux pour le numérateur et un pour le dénominateur). Le mode pour le décodage n'utilise que $m_{8!}$(=4) termes tandis que les deux modes pour le codage utilisent un traitement séparé des positions pour exploiter les $m_{l!}$ ou $m_l$ termes qui ne sont pas lus mais inscrits "en dur" dans l'algorithme en éclatant la boucle sur les 8 positions d'un point du réseau de Gosset.

### Exemple de réalisation pour le codeur TDAC

Un dernier exemple de réalisation concerne le codeur fréquentiel perceptuel TDAC de la Demanderesse utilisé pour coder des signaux audio numériques échantillonnés à 16 kHz (bande élargie), dont le principe est décrit ci-après.

Le codeur TDAC utilise une quantification vectorielle statistique à dimension et résolution variables de dimension maximale 15.

Dans le cas des codes à permutation du réseau régulier de points $RE_8$ de dimension 8, l'invention permet essentiellement de réduire la complexité. Par contre, dans le cas du codeur TDAC, qui utilise des codes à permutations de dimension supérieure à 12, l'invention s'avère très avantageuse car elle permet non seulement une réduction de complexité mais aussi une réalisation du codeur sur des processeurs en virgule fixe dont la précision maximale est limitée à des entiers de 32 bits non signés. Sans l'invention, une telle réalisation serait extrêmement complexe.

Le principe de ce codeur est le suivant.

Un signal audio limité en bande à 7 kHz et échantillonné à 16 kHz est découpé en trames de 320 échantillons (20 ms). Une transformée en cosinus discrète modifiée (ou "MDCT") est appliquée sur des blocs du signal d'entrée de 640 échantillons avec un recouvrement de 50 % (ce qui correspond à un rafraîchissement de l'analyse MDCT toutes les 20 ms). On limite le spectre à 7225 Hz en fixant à zéro les 31 derniers coefficients (seuls alors les 289 premiers coefficients étant différents de 0). Une courbe de masquage est déterminée à partir de ce spectre et tous les coefficients masqués sont mis à zéro. Le spectre est divisé en 32 bandes de largeurs inégales. Les éventuelles bandes masquées sont déterminées en fonction des coefficients transformés des signaux. Pour chaque bande du spectre, l'énergie des coefficients MDCT est calculée (pour évaluer des facteurs d'échelle). Les 32 facteurs d'échelle constituent l'enveloppe spectrale du signal qui est ensuite quantifiée, codée et transmise dans la trame. L'allocation dynamique des bits se base sur une courbe de masquage par bande calculée à partir de la version déquantifiée de l'enveloppe spectrale, de manière à obtenir une compatibilité entre l'allocation binaire du codeur et du décodeur. Les coefficients MDCT normalisés dans chaque bande sont ensuite quantifiés par des quantificateurs vectoriels utilisant des dictionnaires imbriqués en taille, les dictionnaires étant composés d'une union de codes à permutation de type II. Finalement, les informations sur la tonalité et le voisement ainsi que l'enveloppe spectrale et les coefficients codés sont multiplexés et transmis en trame.

L'exemple de réalisation pour le calcul du rang d'une permutation (codage) utilise ici une représentation compacte des décompositions. La dimension des codes à permutation utilisée étant variable, la boucle sur les positions n'est pas éclatée. Ce mode de réalisation illustre une procédure de détection des exposants non nuls de la décomposition d'un rang partiel.

Ici, les décompositions de base sont représentées de façon compacte. On stocke les mots contenant leurs exposants dans deux tableaux à seize éléments (=(15+1)). Dans l'annexe B-1, Le tableau $\boldsymbol{D'_l}$ contient les mots pour les décompositions des entiers $l$ ( $0 \leq l \leq 15$ ) et le tableau $\boldsymbol{D'_{l!}}$ contient les mots pour les décompositions de leurs factorielles.

On stocke aussi les puissances de 3 dans un tableau à huit éléments (noté Pow3) et les puissances de 5, 7, 11 et 13 dans un tableau (noté Pow) à vingt éléments (avec stockage factice de 0 pour les puissances non utilisées).

Le traitement correspondant est retranscrit en annexe B-2.

Bien entendu, la présente invention ne se limite pas aux formes de réalisation décrites ci-avant à titre d'exemple ; elle s'étend à d'autres variantes.

A la connaissance de la Demanderesse, la présente invention consiste en la première utilisation des décompositions en puissances de facteurs premiers dans les codes à permutation. Cette utilisation est pourtant particulièrement avantageuse dès lors que des calculs d'expressions combinatoires sont prévus, comme dans la quantification vectorielle avec codes à permutation. Ainsi, de manière générale, la présente invention vise cette utilisation des décompositions en puissances de facteurs premiers pour toute expression combinatoire, même différente d'un rang d'une permutation, en codage/décodage par un ou des codes à permutation.

La présente invention trouve une application avantageuse en codage/décodage de signaux de parole, par exemple dans des terminaux de téléphonie notamment cellulaire. Toutefois, elle s'applique au codage/décodage de signaux de tout autre type, notamment de signaux d'image ou vidéo ainsi qu'en modulation codée.

La présente invention vise aussi un programme informatique destiné à être stocké en mémoire d'un dispositif de codage/décodage de signaux numériques, utilisant des codes à permutations. Ce programme comporte alors des instructions pour la mise en oeuvre des étapes du procédé au sens de l'invention. Typiquement, les figures 4 à 8 décrites ci-avant peuvent correspondre à des organigrammes d'algorithmes que peut comporter un tel programme.

La présente invention vise aussi un dispositif de codage/décodage de signaux numériques, utilisant des codes à permutations, et comprenant, en référence à la figure 9 :

- une unité mémoire MEM pour stocker les instructions d'un programme informatique du type précité, ainsi que des représentations préenregistrées de décompositions de nombres entiers choisis, et
- un module de calcul PROC accédant à cette unité mémoire MEM pour la mise en oeuvre du procédé au sens de l'invention.

Ces moyens MEM, PROC peuvent être prévus :

- pour donner le rang *t* d'une permutation à partir du vecteur-code y choisi (flèches en traits pleins de la figure 9) :
  - o dans un module d'indexation d'un codeur de source ou
  - o dans un module d'indexation d'un décodeur de canal,
- ou pour donner le vecteur-code y à reconstruire à partir du rang *t* d'une permutation (flèches en traits pointillés de la figure 9) :
  - o dans un module de décodage d'un décodeur de source ou
  - o dans un module codage d'un codeur de canal.

Bien entendu, les représentations préenregistrées dans la mémoire MEM peuvent être sous forme de contenus d'adresses (représentation éclatée) ou sous la forme de mots de bits (représentation compacte).

**ANNEXES**

**A-11**

$\boldsymbol{D_l}$ [36] = {
0, 0, 0, 0,
0, 0, 0, 0,
1, 0, 0, 0,
0, 1, 0, 0,
2, 0, 0, 0,
0, 0, 1, 0,
1, 1, 0, 0,
0, 0, 0, 1,
3, 0, 0, 0};

$D_{l!}$ [36] = {

0, 0, 0, 0, /* 0! */

0, 0, 0, 0, /* 1! */

1, 0, 0, 0, /* 2! */

1, 1, 0, 0, /* 3! */

3, 1, 0, 0, /* 4! */

3, 1, 1, 0, /* 5! */

4, 2, 1, 0, /* 6! */

4, 2, 1, 1, /* 7! */

7, 2, 1, 1, /* 8! */

};

**A-12**

*Initialisation :*

- *t*=0
- *w*[*i*] = 0, $0 \le i < q$
- *R*[0] = 0

*Traitement des positions*

- Position k=7 :

  o d7=d[7]; *w*[d7] = 1

- Position k=6 :

  o d=d[6]; *w*[d] = *w*[d] +1
  o Si (d= d7) alors *R*[0] = 1

  sinon si (d > d7) *t*= 1

- Position k=5 :

  o d=d[5]; *w*[d] = *w*[d] +1
  ○ *R*[0] = R[0]+$D_l$[4*2]- $D_l$[4**w*[*d*]]
  o *R*[1] = -$D_l$[4**w*[d]+1]
  o *S*=0; boucle de *j*=0 à *d*-1: *S* = *S* + *w*[*j*]
  o Test si S>0 ; si oui :

- ■ i2= *R*[0]+ $\boldsymbol{D}_l$[4*S]
- ■ *t*= *t* + (1<<i2)

- Positions k=4 puis 3 :
  - ○ d=d[k]; *w*[d] = *w*[d] +1
  - o *R*[0] = *R*[0]+$\boldsymbol{D}_l$[4*(7-k)]- $\boldsymbol{D}_l$[4**w*[*d*]]
  - o *R*[1] = *R*[1]+$\boldsymbol{D}_l$[4*(7-k)+1]- $\boldsymbol{D}_l$[4**w*[d]+1]
  - o *S*=0; boucle de *j*=0 à *d*-1: *S* = *S* + *w*[*j*]
  - o Test si *S*>0; si oui :
    - ■ i2= *R*[0]+ $\boldsymbol{D}_l$[4*S]
    - ■ i3= *R*[1]+ $\boldsymbol{D}_l$[4*S+1]
    - ■ *t*= *t*+ pow3[i3] *(1<<i2)
- *R*[2] = -$\boldsymbol{D}_l$[4**w*[d]+2]
- Positions k=2 puis 1 :
  - ○ d=d[k]; *w*[d] = *w*[d] +1
  - ○ *R*[0] = *R*[0]+$\boldsymbol{D}_l$[4*(7-k)]- $\boldsymbol{D}_l$[4**w*[*d*]]
  - o *R*[1] = *R*[1]+$\boldsymbol{D}_l$[4*(7-k)+1]- $\boldsymbol{D}_l$[4**w*[d]+1]
  - o *R*[2] = *R*[2]+$\boldsymbol{D}_l$[4*(7-k)+2]- $\boldsymbol{D}_l$[4**w*[d]+2]
  - o *S*=0 ; boucle de *j*=0 à *d*-1 : *S* = *S* + *w*[*j*]
  - o Test si *S*>0; si oui :
    - ■ i2= *R*[0]+ $\boldsymbol{D}_l$[4*S]
    - ■ i3= *R*[1]+ $\boldsymbol{D}_l$[4*S+1]
    - ■ i5= *R*[2]+ $\boldsymbol{D}_l$[4*S+2]
    - ■ *t*= *t* + pow5[!5]*pow3[!3]*(1<<i2)
- *R*[3] = -$\boldsymbol{D}_l$[4**w*[d]+3]
- Position k=0 :
  - o d=d[0]; *w*[d] = *w*[d] +1
  - ○ *R*[0] = *R*[0]+$\boldsymbol{D}_l$[4*7]- $\boldsymbol{D}_l$[4**w*[*d*]]
  - o *R*[1] = *R*[1]+$\boldsymbol{D}_l$[4*7+1]- $\boldsymbol{D}_l$[4**w*[d]+1]
  - o *R*[2] = *R*[2]+$\boldsymbol{D}_l$[4*7+2]- $\boldsymbol{D}_l$[4**w*[d]+2]
  - ○ *R*[3] = *R*[2]+$\boldsymbol{D}_l$[4*7+3]- $\boldsymbol{D}_l$[4**w*[d]+3]
  - o *S*=0 ; boucle de *j*=0 à *d*-1 : *S* = *S* + *w*[*j*]
  - o Test si *S*>0; si oui :
    - ■ i2= *R*[0]+ $\boldsymbol{D}_l$[4*S]
    - ■ i3= *R*[1]+ $\boldsymbol{D}_l$[4*S+1]
    - ■ i5= *R*[2]+ $\boldsymbol{D}_l$[4*S+2]
    - ■ i7= *R*[3]+ $\boldsymbol{D}_l$[4*S+3]
    - ■ *t*= *t*+ pow7[i7]*pow5[i5]*pow3[i3]*(1<<i2)

**A-21**

$$\boldsymbol{D'}_l = \{\ 0,\ 0,\ 1,\ 8,\ 2,\ 32,\ 9,\ 128,\ 3\}$$

$$\boldsymbol{D'}_{l!} = \{\ 0,\ 0,\ 1,\ 9,\ 11,\ 43,\ 52,\ 180,\ 183\}$$

Pow[12] = {
1, 3, 9, 27,
1, 5, 25, 0,
1, 7, 49, 0};

**A-22**

*Initialisation :*

- $t$=0
- $w[i]$ = 0, $0 \leq i < q$
- eP=0

*Traitement des positions*

- Position k=7 :
  - o d7=d[7]; *w*[d7] = 1
- Position k=6 :
  - o d=d[6] ; *w*[d] = *w*[d] +1
  - o Si (d= d7) alors eP = 1

    sinon si (d > d7) *t*= 1
- Position k=5 :
  - o d=d[5] ; *w[d]* = *w[d]* +1
  - o eP = eP+***D'I***[*w*[d]]
  - o *S*=0 ; boucle de *j*=0 à *d*-1: *S* = *S* + *w*[*j*]
  - o Test si *S*>0 ; si oui :
    - ■ i2= $\boldsymbol{D'_{II}}[2]+\boldsymbol{D'_{I}}[S]$
    - ■ i2= i2-eP
    - ■ *t*= *t*+ (1 <<i2)
- Positions k=4 puis 3 :
  - ○ d=d[k] ; *w[d]* = *w[d]* +1
  - o eP = eP+$\boldsymbol{D'_{I}}[w[d]]$
  - o *S*=0 ; boucle de *j*=0 à *d*-1 : *S* = *S* + *w*[*j*]
  - o Test si *S*>0; si oui :
    - ■ eI = $\boldsymbol{D'_{II}}[(7-k)]+\boldsymbol{D'_{I}}[S]$
    - ■ eI = eI- eP
    - ■ i2 = eI & (0x7)
    - ■ i3 = eI >> 3

- ■ *t*= *t* + pow[i3] *(1<<i2)

- Positions k=2 puis 1 :
  - o d=d[k *w*[d] = *w*[d] +1
  - o eP = eP+$D'_{l}$[*w*[d]]
  - o *S*=0 ; boucle de *j*=0 à *d*-1 : *S* = *S* + *w*[*j*]
  - o Test si *S*>0; si oui :
    - ■ el = $D'_{ll}$[(7-k)]+$D'_{l}$[S]
    - ■ el = el- eP
    - ■ i2 = el & (0x7)
    - ■ el = el >>3
    - ■ i3 = el &(0x3)
    - ■ el = el >>2
    - ■ i5 = el &(0x3)
    - ■ *t*= *t* + pow[4+i5] * pow[i3] *(1 <<i2)

- Position k=0 :
  - o d=d[0]; *w*[d] = *w*[d] +1
  - o eP = eP+$D'_{l}$[*w*[d]]
  - o *S*=0 ; boucle de *j*=0 à *d*-1 : *S* = *S* + *w*[*j*]
  - o Test si *S*>0; si oui :
    - ■ el = $D'_{ll}$[(7)]+$D'_{l}$[S]
    - ■ el = el- eP
    - ■ i2 = el & (Ox7)
    - ■ el = el >>3
    - ■ i3 = el &(0x3)
    - ■ el = el >>2
    - ■ i5 = el &(0x3)
    - ■ el = el >>2
    - ■ i7 = el &(0x3)
    - ■ *t*= *t*+ pow[8+i7] *pow[4+i5] * pow[i3] * (1<<i2)

**A-3**

*Initialisation :*

- o Boucle de i=0 à 3, *P*[i] =$D_{ll}$[4**w*[0]+i]
- o Boucle de d=1 à *q*-1:
  - ■ Boucle de i=0 à 3, *P*[i] =*P*[i] + $D_{ll}$[4**w*[d]+i]

*Traitement des positions*

- Boucle de k=0 à 7 :
  - o Boucle de i=0 à 3: *R*[i] = $D_{ll}$[4*(7-k)+i]-*P*[i]
  - ○ *l*=0
  - o d=0
  - o Répéter tant que *w*[d] = 0, d=d+1
  - ○R[0] = R[0]+$D_{l}$[4*(7-k)]- $D_{l}$[4*w[d]]

o R[1] = R[1]+$\boldsymbol{D_l}$[4*(7-k)+1]- $\boldsymbol{D_l}$[4*w[d]+1]
o R[2] = R[2]+$\boldsymbol{D_l}$[4*(7-k)+2]- $\boldsymbol{D_l}$[4*w[d]+2]
o *S*=0
o Répéter tant que (*t-l> 0*)

- ■ *l'* = l
- ■ *S* = *S* + *w*[*d*]
- ■ i2= *R*[0]+ $\boldsymbol{D_l}$[4*S]
- ■ i3= *R*[1]+ $\boldsymbol{D_l}$[4*S+1]
- ■ i5= *R*[2]+ $\boldsymbol{D_l}$[4*S+2]
- ■ i7= *R*[3]+ $\boldsymbol{D_l}$[4*S+3]
- ■ *l*= pow7[i7]*pow5[i5]*pow3[i3]*(1<<i2)
- ■ d= d+1

○ d = d-1
○ *l* = *l'*
○ *t*= *t-l*
o Boucle de i=0 à 3, *P*[i] =*P*[i] -$\boldsymbol{D_l}$[4**w*[d]+i]
○ *w*[d] = *w*[d]-1
○ x[k] =a[d]

**B-1**

$\boldsymbol{D}'_l$ = { 0, 0, 1, 16, 2, 128, 17, 512, 3, 32, 129, 2048, 18, 8192, 513, 144};

$D'_{l!}$ ={ 0, 0, 1, 17, 19, 147, 164, 676, 679, 711, 840, 2888, 2906, 11098, 11611, 11755};

Pow3[8] = { 1, 3, 9, 27, 81, 243, 729, 2187 }

Pow[4*5] = { 1, 5, 25, 125, 625, 1, 7, 49, 343, 0, 1, 11, 121, 0, 0, 1, 13, 169, 0, 0}

**B-2**

*Initialisation :*

- *t*=0
- *w*[*i*] = 0, $0 \leq i < q$
- eP=0

*Traitement des positions*

- Position *k*=*n*-1:
  - ○ *dn1*=d[*n*-1]; *w*[*dn1*] = 1
- Position k=n-2
  - ○ *d*=d[*n*-2]; *w*[*d*] = *w*[*d*] *+1*
  - ○ Si (*d*= *dn1*) alors eP = 1

- ○ Si(*d* > *dn1*) *t*= 1

- <u>Positions de *k*=*n*-3 à 0 :</u>

  - ○ *d*=d[*k*]
  - ○ *w*[*d*] = *w*[*d*] +1
  - ○ eP = eP+$\boldsymbol{D'_l}$[*w*[*d*]]
  - ○ *S*=0 ; boucle de *j*=0 à d-1: *S* = *S* + *w*[*j*]
  - ○ Test si *S*>0; si oui :

    - ■ *t*' = 1
    - ■ el = $\boldsymbol{D}'_{l!}$[(7-k)]+$D'_l$[S]
    - ■ el = el- eP
    - ■ Test si (el>0); si oui

      - i2 = el & (0xF)
      - Pow[0] = 1;
      - ml = 0
      - i3 = (el>>4) & 0x7
      - si (i3 >0)

        - ○ pow[0] = Pow3[i3]
        - ○ ml = ml +1

      - el = el >>7
      - si el >0

        - ml'= (16-norm_s(el))>>1
        - boucle de j=0 à ml'

          - ■ i = el & 0x3
          - ■ si i >0
          - ■ si i >0

            - pow[ml] = Pow[i+5*j]
            - ml = ml +1

          - ■ el = el >> 2

      - boucle de i=0 à (ml-1): t' = t' x pow[i]
      - t' = t' << i2

    - ■ *t* = *t* +*t*'

**Revendications**

**1.** Procédé de codage/décodage de signaux numériques, utilisant des codes à permutation faisant intervenir un calcul d'expressions combinatoires,
**caractérisé en ce que** lesdites expressions combinatoires sont représentées par des décompositions en puissances de facteurs premiers, et déterminées par une lecture mémoire de représentations préenregistrées de décompositions de nombres entiers choisis,
et **en ce qu'**une au moins desdites expressions combinatoires (t') comporte un quotient d'un numérateur entier (v) par un dénominateur entier (p),
et **en ce que** ledit quotient est représenté par une décomposition de puissances de facteurs premiers, dont chaque puissance est une différence d'exposants $(e_{\mathrm{v}}^{i} - e_{\mathrm{\rho}}^{i})$ respectivement associés au numérateur (v) et au dénominateur (p) et affectés à un même nombre premier ($p_i$).

**2.** Procédé selon la revendication 1, **caractérisé en ce qu'**il comporte, pour le calcul d'une expression combinatoire, les étapes :

- identification, parmi lesdits nombres entiers choisis, de termes (($n$-1-$k$)!, $S_k$, $P_k$) apparaissant dans un produit et/ou un quotient formant ladite expression combinatoire $(I_k^{d_k})$,
- lecture mémoire d'exposants ($e^i_{(n-1-k)!}$, $e^i_{Sk}$, $e^i_{Pk}$) intervenant dans les décompositions en facteurs premiers desdits termes,
- addition et/ou respectivement soustraction des exposants lus ($e^i_{(n-1-k)!}+e^i_{Sk}-e^i_{Pk}$) pour déterminer les exposants $(e^i_{I_k^{d_k}})$ intervenant dans la décomposition en puissances de facteurs premiers de ladite expression combinatoire, et, de là, calculer ladite expression combinatoire à partir de sa décomposition en puissances de facteurs premier.

**3.** Procédé selon la revendication 2, comportant une étape récurrente de calcul d'un produit faisant intervenir à chaque récurrence un terme se multipliant à un produit déterminé à une récurrence antérieure, **caractérisé en ce que :**

- ledit produit déterminé à une récurrence antérieure est conservé en mémoire sous la forme d'une décomposition en puissances de facteurs premiers,
- ledit terme se multipliant au produit est l'un des entiers choisis dont la décomposition est préenregistrée, et
- pour déterminer ledit produit à une récurrence courante, on additionne, un à un par nombre premier, les exposants issus des décompositions respectives dudit produit déterminé à une récurrence antérieure et dudit terme se multipliant au produit.

**4.** Procédé selon la revendication 2, comportant une étape récurrente de calcul d'une division faisant intervenir à chaque récurrence un terme divisant un quotient déterminé à une récurrence antérieure, **caractérisé en ce que :**

- ledit quotient déterminé à une récurrence antérieure est conservé en mémoire sous la forme d'une décomposition en puissances de facteurs premiers,
- ledit terme divisant le quotient est l'un des entiers choisis dont la décomposition est préenregistrée, et
- pour déterminer ladite division à une récurrence courante, on soustrait, un à un par nombre premier, les exposants issus de la décomposition dudit terme aux exposants issus de la décomposition dudit quotient déterminé à une récurrence antérieure.

**5.** Procédé selon l'une des revendications précédentes, **caractérisé en ce que** les codes à permutation font intervenir le calcul d'une quantité représentative d'un rang d'une permutation ($t$) comportant un cumul de rangs partiels $(I_k^{d_k})$, chaque rang partiel correspondant à une desdites expressions combinatoires, **en ce que** le code de permutation utilise une énumération de Schalkwijk, et un rang partiel $I_k^{d_k}$ associé à une troncature ($y_k$,...$y_{n-1}$) d'un vecteur-code ($y_0$,...$y_{n-1}$) s'écrit :

$$I_k^{d_k} = \frac{(n-1-k)!}{\prod_{i=0}^{q-1}(w_k^i!)}\left(\sum_{d=0}^{d_k-1} w_k^d\right),$$

où

- la notation $\prod_{i=0}^{m}$ représente un produit pour un indice entier i allant de 0 à m,
- la notation $\sum_{i=0}^{m}$ représente une somme pour un indice i allant de 0 à m,
- la notation *l*! est la valeur factorielle de l'entier *l* avec *l*! =1x 2x 3x... x (*l*-1) x *l*, pour *l*>0 et avec 0!=1,
- l'entier n est la dimension du code de permutation, correspondant au nombre total de composantes que comporte un vecteur-code,
- l'entier *k*, compris entre 0 et n-1, est l'indice de la $k^{ième}$ composante $y_k$ du vecteur-code,
- l'entier q est le nombre de composantes distinctes que comporte le vecteur-code, et
- un terme $w_k^d$ représente le nombre de composantes d'indices compris entre *k* et n-1 et qui ont une valeur égale à celle d'une même composante d'indice *d* ;et **en ce que** lesdits nombres entiers, identifiés et apparaissant dans un produit et/ou un quotient formant le rang partiel $(I_k^{d_k})$ en tant qu'expression combinatoire, sont :
- les termes factoriels (*n*-1-*k*)! , pour tous les entiers *k* et compris entre 0 et *n*-1,
- la valeur de chaque terme $w_k^i$ et/ou sa valeur factorielle, intervenant dans le produit $P_k = \prod_{i=0}^{q-1}(w_k^i!)$, chaque terme $w_k^i$ étant compris entre 0 et *n*, et
- les termes $S_k = \sum_{d=0}^{d_k-1} w_k^d$, , chacun compris entre 1 et *n*-1, pour tous les entiers *k* compris entre 0 et *n*-1.

**6.** Procédé selon la revendication 5, prise en combinaison avec l'une des revendications 3 et 4, **caractérisé en ce que** la somme des exposants dans la décomposition du terme $P_k = \prod_{i=0}^{q-1}(w_k^i!)$ est stockée temporairement en mémoire pour un indice *k* précédent pour être ajoutée ou soustraite aux exposants de la décomposition d'un terme $w_k^i$ pour un indice *k* courant.

**7.** Programme informatique destiné à être stocké en mémoire d'un dispositif de codage/décodage de signaux numériques, utilisant des codes à permutations, **caractérisé en ce qu'**il comporte des instructions pour la mise en oeuvre des étapes du procédé selon l'une des revendications 1 à 6.

**8.** Dispositif de codage/décodage de signaux numériques, utilisant des codes à permutations, **caractérisé en ce qu'**il comporte :

- une unité mémoire pour stocker les instructions d'un programme informatique selon la revendication 7 et des représentations préenregistrées de décompositions de nombres entiers choisis, et
- un module de calcul accédant à ladite unité mémoire pour la mise en oeuvre du procédé selon l'une des revendications 1 à 6.

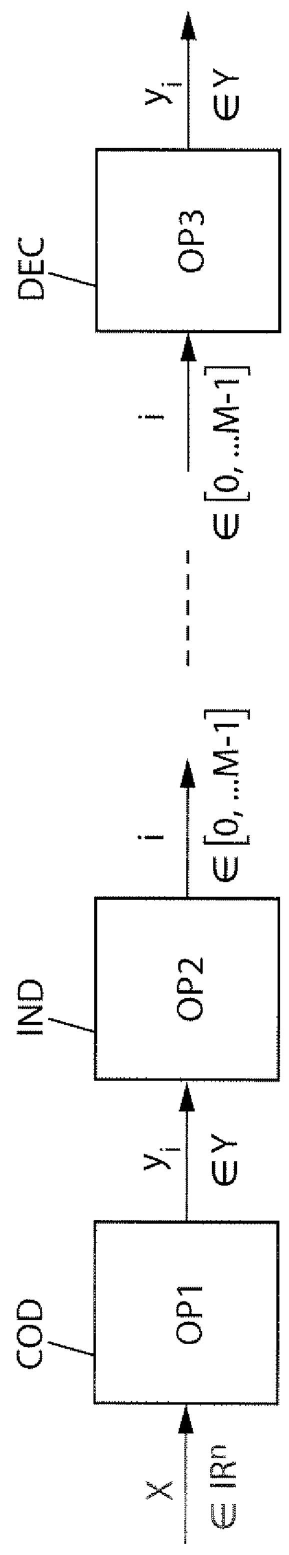
COD
OP1
IND
OP2
DEC
OP3
X
$\in IR^n$
$y_i$
$\in Y$
i
$\in [0, ...M-1]$
$y_i$
$\in Y$

FIG. 1A

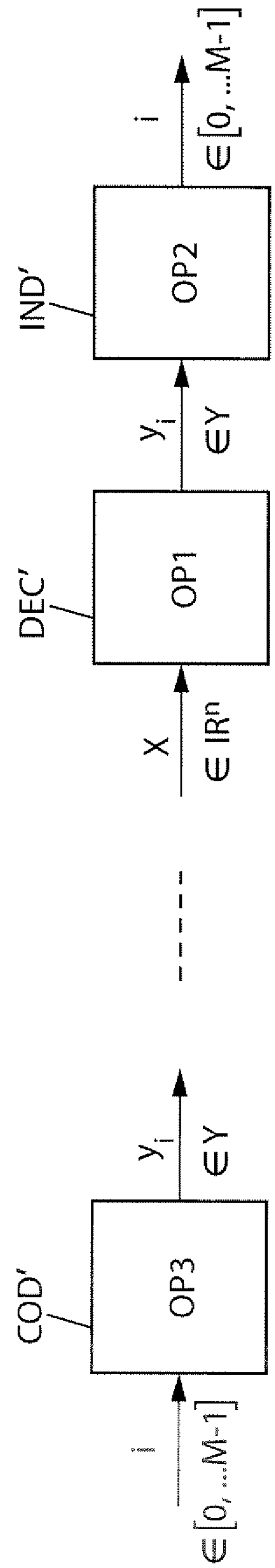
COD'
OP3
DEC'
OP1
IND'
OP2
i
$\in [0, ...M-1]$
$y_i$
$\in Y$
X
$\in IR^n$
$y_i$
$\in Y$
i
$\in [0, ...M-1]$

FIG. 1B

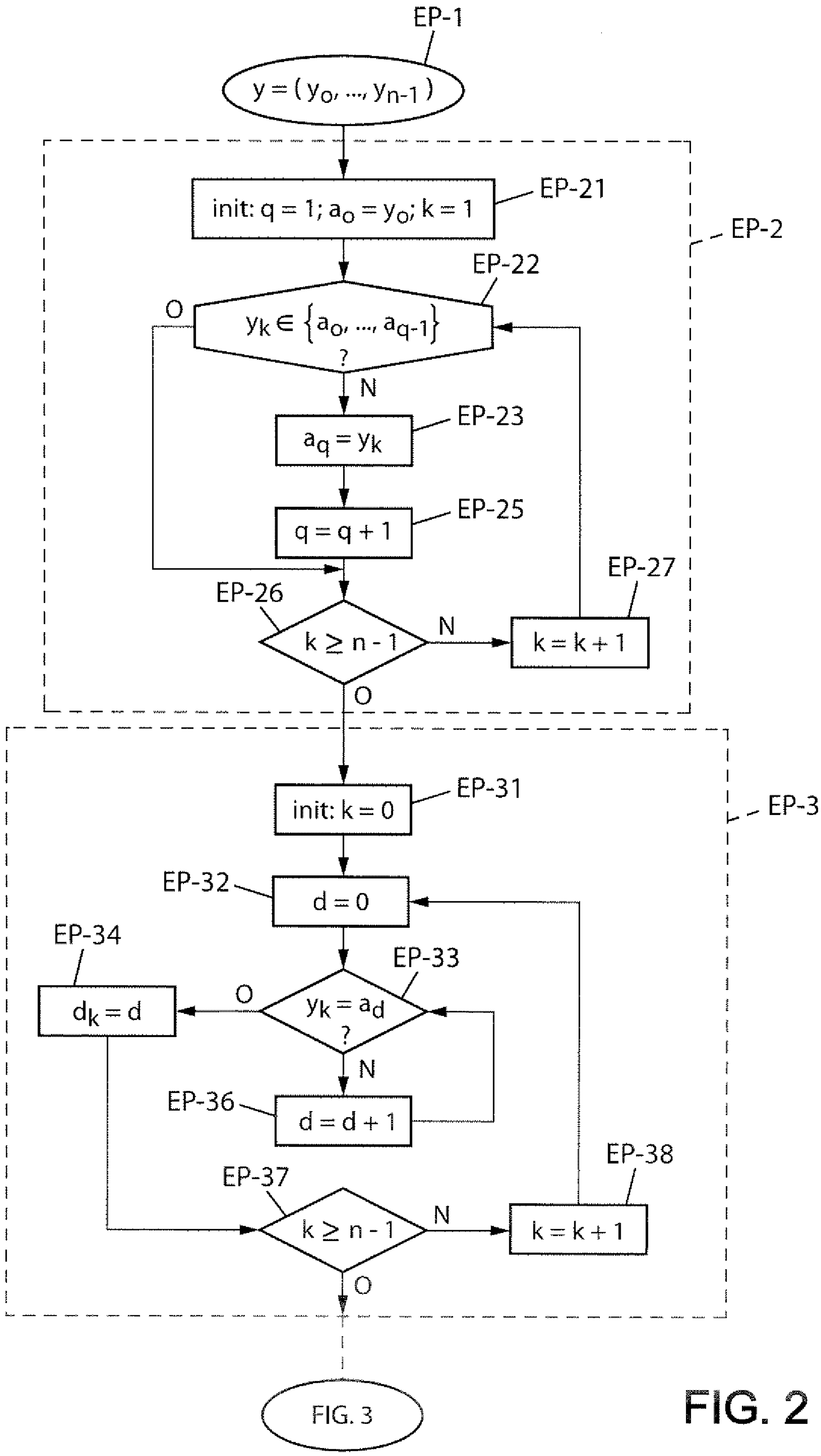
EP-1
y = ( y_o, ..., y_n-1 )
init: q = 1; a_o = y_o; k = 1
EP-21
EP-2
EP-22
O
y_k ∈ {a_o, ..., a_q-1} ?
N
a_q = y_k
EP-23
q = q + 1
EP-25
EP-26
k ≥ n - 1
N
k = k + 1
EP-27
O
init: k = 0
EP-31
EP-3
EP-32
d = 0
EP-34
EP-33
d_k = d
O
y_k = a_d ?
N
EP-36
d = d + 1
EP-37
k ≥ n - 1
N
k = k + 1
EP-38
O
FIG. 3

FIG. 2

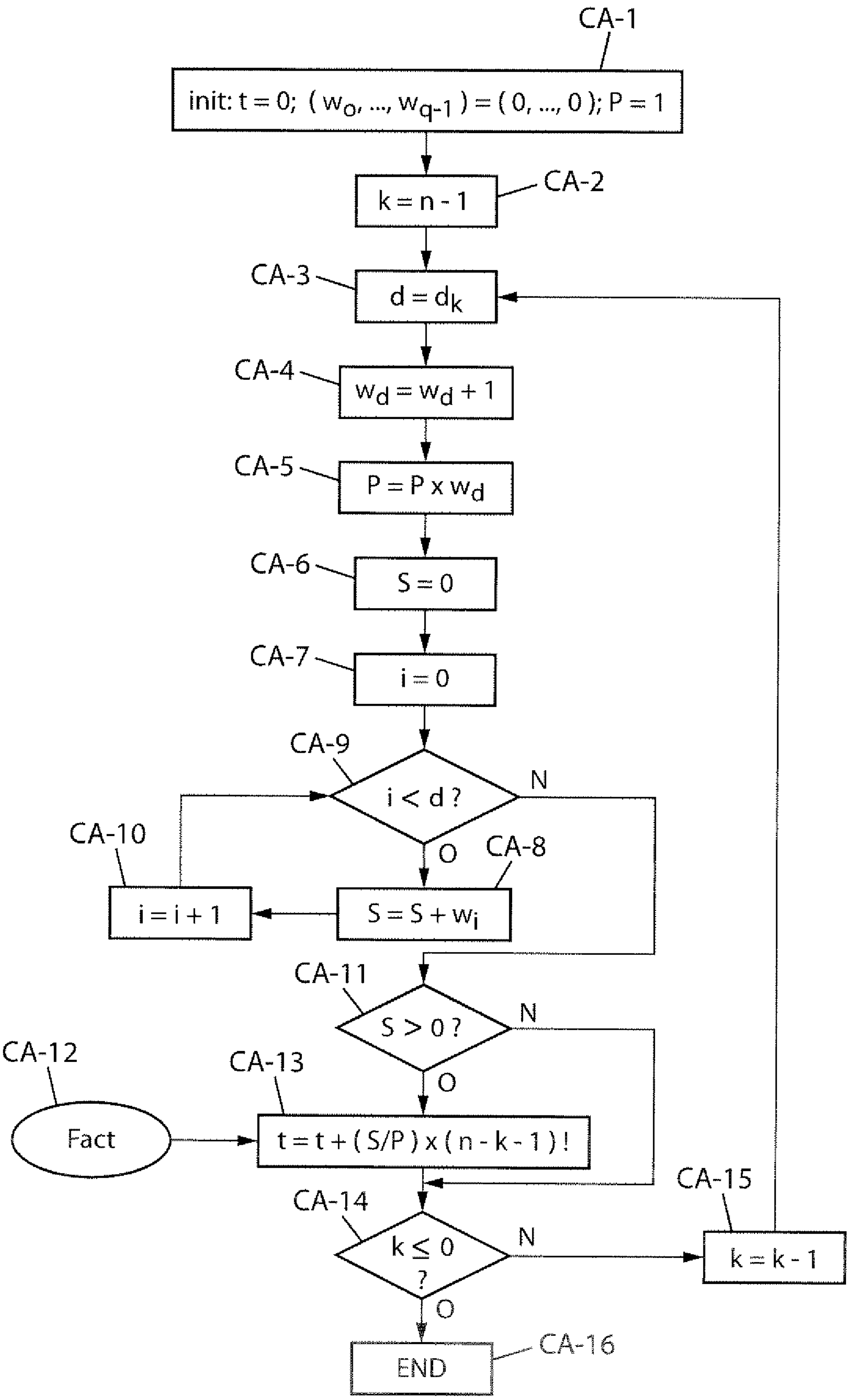
CA-1
init: t = 0; ( w0, ..., wq-1 ) = ( 0, ..., 0 ); P = 1
CA-2
k = n - 1
CA-3
d = dk
CA-4
wd = wd + 1
CA-5
P = P x wd
CA-6
S = 0
CA-7
i = 0
CA-9
i < d ?
N
O
CA-8
S = S + wi
CA-10
i = i + 1
CA-11
S > 0 ?
N
O
CA-12
Fact
CA-13
t = t + ( S/P ) x ( n - k - 1 ) !
CA-14
k ≤ 0 ?
N
O
CA-15
k = k - 1
CA-16
END

FIG. 3

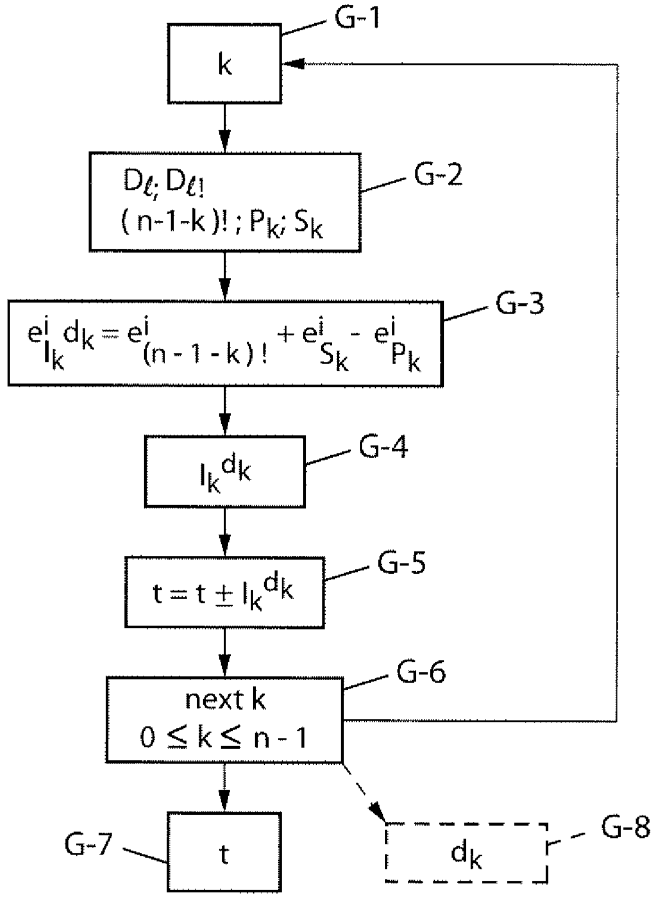
k
G-1
Dℓ; Dℓ!
(n-1-k)! ; Pk; Sk
G-2
$e^i_{I_k} d_k = e^i_{(n-1-k)!} + e^i_{S_k} - e^i_{P_k}$
G-3
$I_k^{d_k}$
G-4
$t = t \pm I_k^{d_k}$
G-5
next k
$0 \leq k \leq n-1$
G-6
G-7
t
$d_k$
G-8

FIG. 4

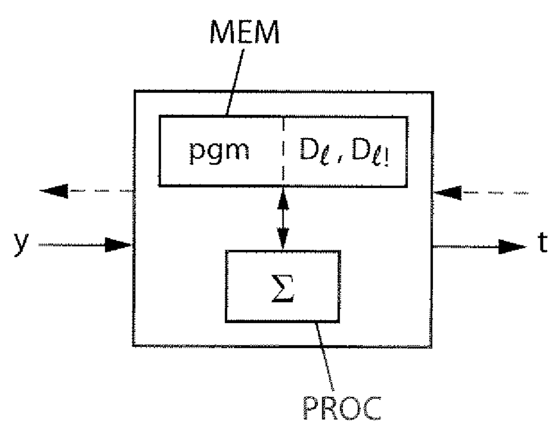
MEM
pgm
Dℓ , Dℓ!
y
t
Σ
PROC

FIG. 9

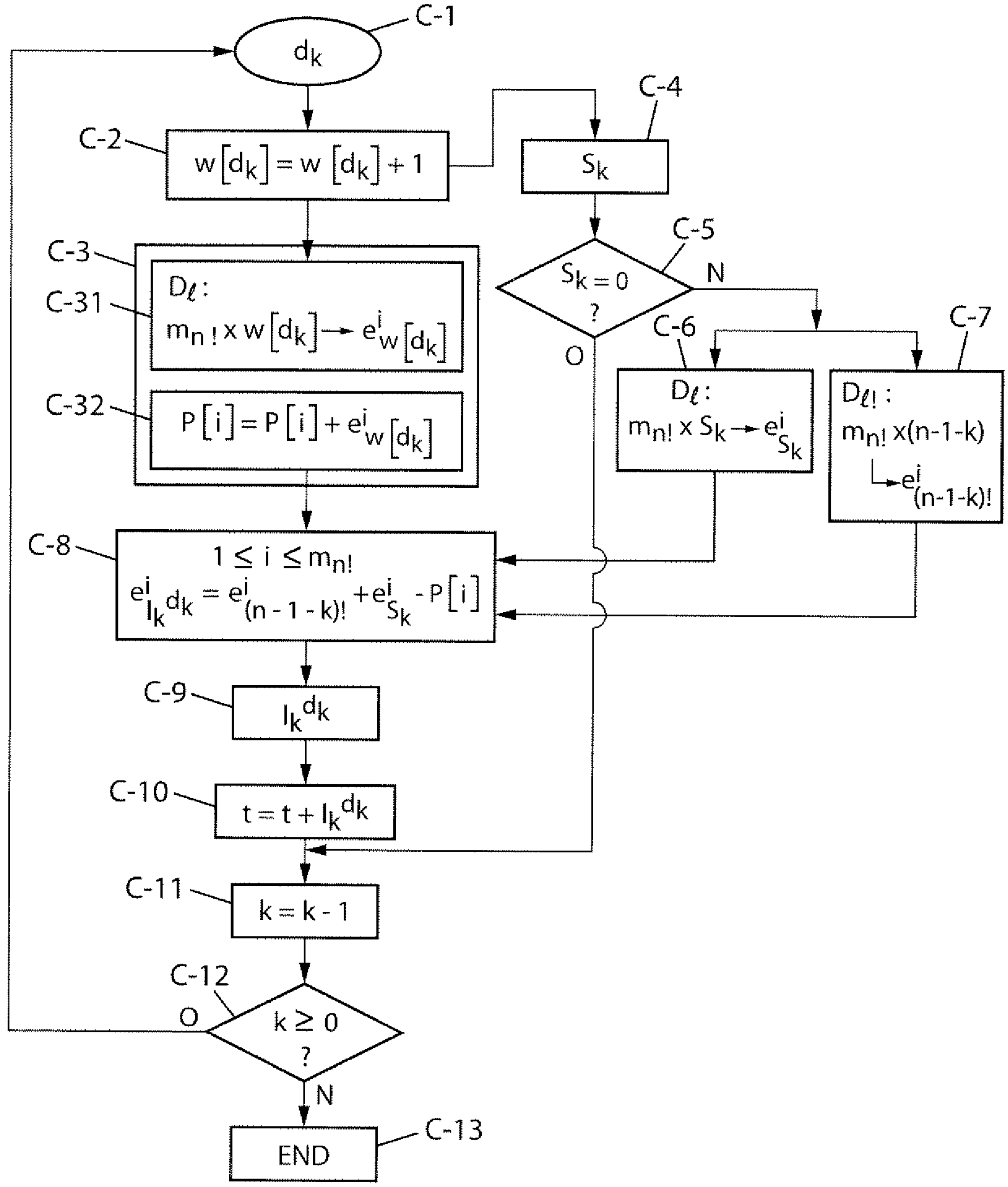
C-1
$d_k$
C-2
$w[d_k] = w[d_k] + 1$
C-3
C-31
$D_\ell$:
$m_{n!} \times w[d_k] \rightarrow e^i_{w[d_k]}$
C-32
$P[i] = P[i] + e^i_{w[d_k]}$
C-4
$S_k$
C-5
$S_k = 0$ ?
N
O
C-6
$D_\ell$:
$m_{n!} \times S_k \rightarrow e^i_{S_k}$
C-7
$D_{\ell!}$:
$m_{n!} \times (n-1-k) \rightarrow e^i_{(n-1-k)!}$
C-8
$1 \leq i \leq m_{n!}$
$e^i_{I_k{}^{d_k}} = e^i_{(n-1-k)!} + e^i_{S_k} - P[i]$
C-9
$I_k{}^{d_k}$
C-10
$t = t + I_k{}^{d_k}$
C-11
$k = k - 1$
C-12
O
$k \geq 0$ ?
N
C-13
END

FIG. 5

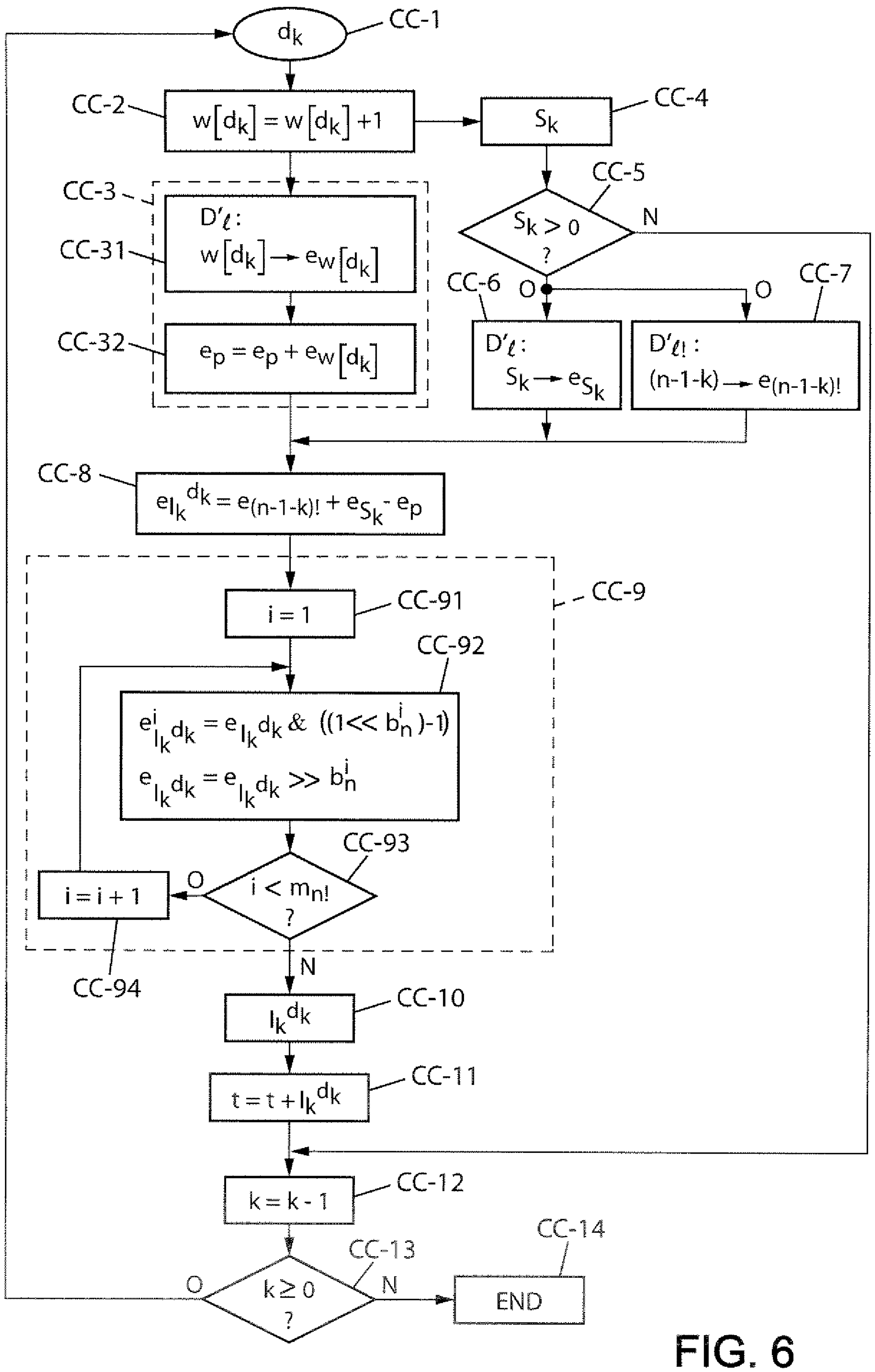

d_k
CC-1
CC-2
w[d_k] = w[d_k] +1
S_k
CC-4
CC-3
CC-5
D'ℓ :
w[d_k] → e_w[d_k]
S_k > 0 ?
N
CC-31
CC-6
O
O
CC-7
CC-32
e_p = e_p + e_w[d_k]
D'ℓ :
S_k → e_Sk
D'ℓ! :
(n-1-k) → e_(n-1-k)!
CC-8
e_lk^dk = e_(n-1-k)! + e_Sk - e_p
CC-91
i = 1
CC-9
CC-92
e^i_lk^dk = e_lk^dk & ((1<< b^i_n )-1)
e_lk^dk = e_lk^dk >> b^i_n
CC-93
i = i + 1
O
i < m_n! ?
N
CC-94
l_k^dk
CC-10
t = t + l_k^dk
CC-11
k = k - 1
CC-12
CC-13
CC-14
O
k ≥ 0 ?
N
END


FIG. 6

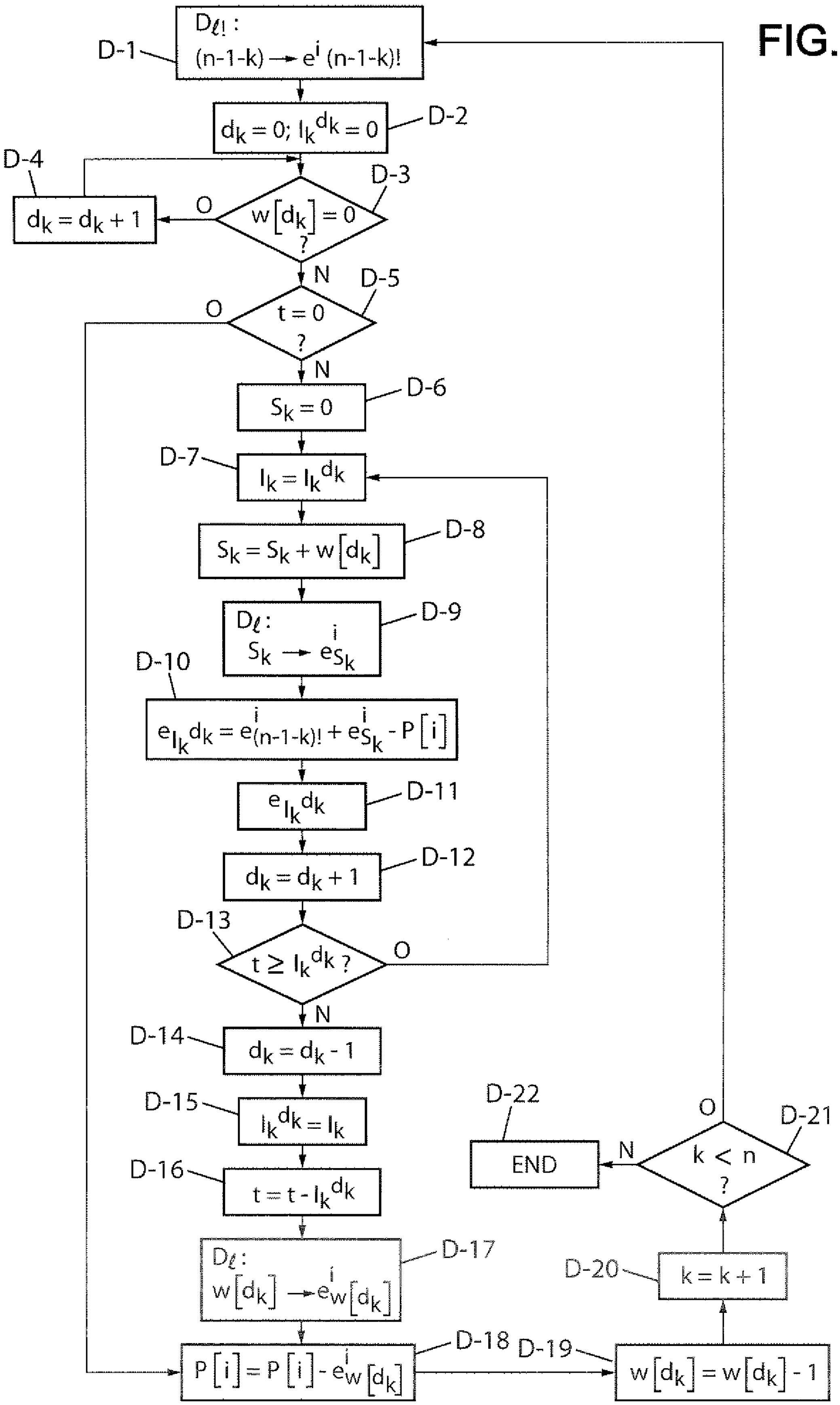
D-1
Dℓ! :
(n-1-k) → e^i (n-1-k)!
D-2
dk = 0; Ik^dk = 0
D-3
w[dk] = 0 ?
D-4
dk = dk + 1
O
N
D-5
t = 0 ?
O
N
D-6
Sk = 0
D-7
Ik = Ik^dk
D-8
Sk = Sk + w[dk]
D-9
Dℓ :
Sk → e^i_Sk
D-10
e_Ik^dk = e^i_(n-1-k)! + e^i_Sk - P[i]
D-11
e_Ik^dk
D-12
dk = dk + 1
D-13
t ≥ Ik^dk ?
O
N
D-14
dk = dk - 1
D-15
Ik^dk = Ik
D-16
t = t - Ik^dk
D-17
Dℓ :
w[dk] → e^i_w[dk]
D-18
P[i] = P[i] - e^i_w[dk]
D-19
w[dk] = w[dk] - 1
D-20
k = k + 1
D-21
k < n ?
O
N
D-22
END

FIG. 7

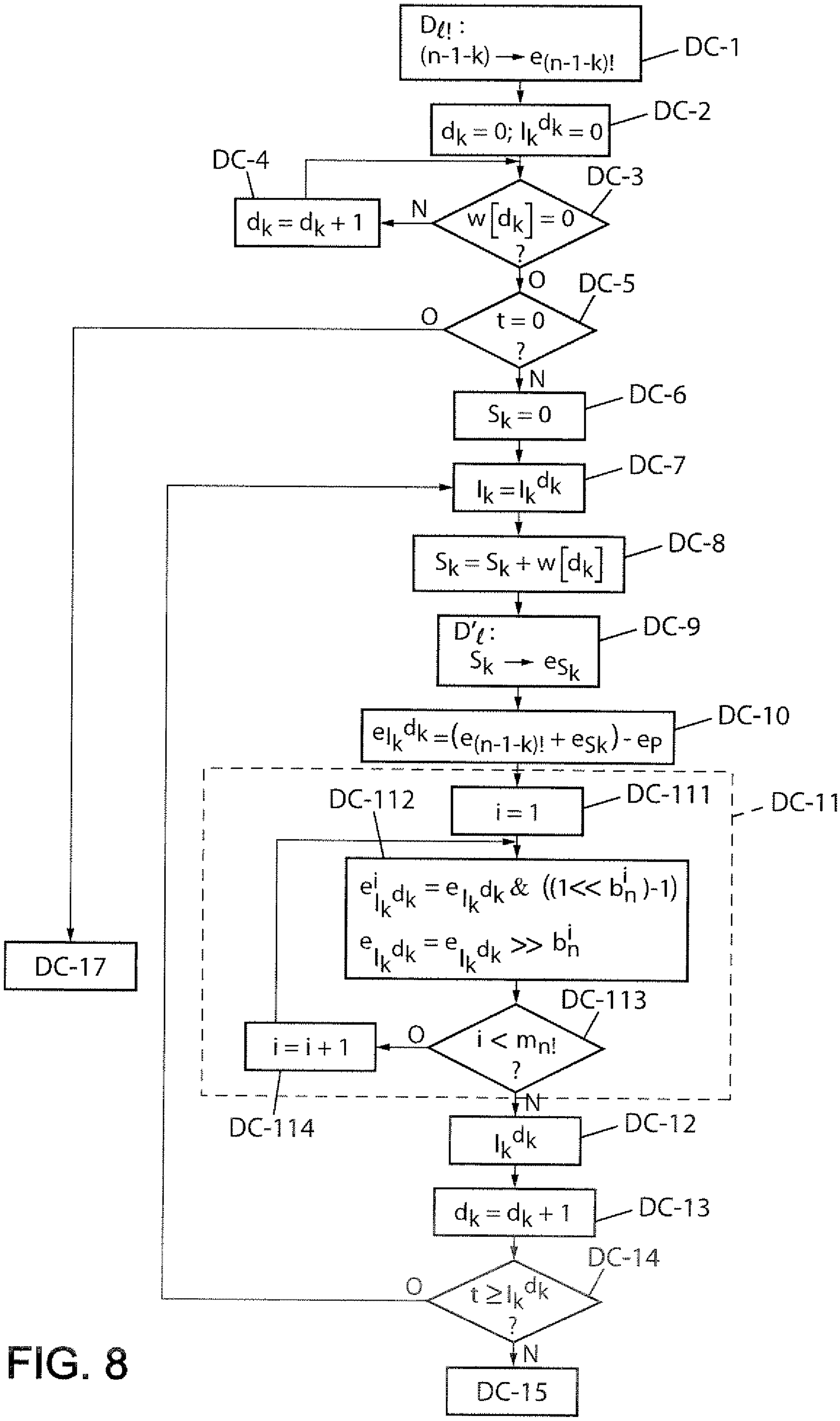
Dℓ! :
(n-1-k) → e(n-1-k)!
DC-1
dk = 0; lk^dk = 0
DC-2
DC-4
dk = dk + 1
N
w[dk] = 0
?
DC-3
O
DC-5
O
t = 0
?
N
Sk = 0
DC-6
lk = lk^dk
DC-7
Sk = Sk + w[dk]
DC-8
D'ℓ :
Sk → eSk
DC-9
elk^dk = (e(n-1-k)! + eSk) - eP
DC-10
DC-112
i = 1
DC-111
DC-11
e^i lk^dk = e lk^dk & ((1<< b^i n)-1)
e lk^dk = e lk^dk >> b^i n
DC-17
i = i + 1
O
i < mn!
?
DC-113
N
DC-114
lk^dk
DC-12
dk = dk + 1
DC-13
DC-14
O
t ≥ lk^dk
?
N
DC-15

FIG. 8

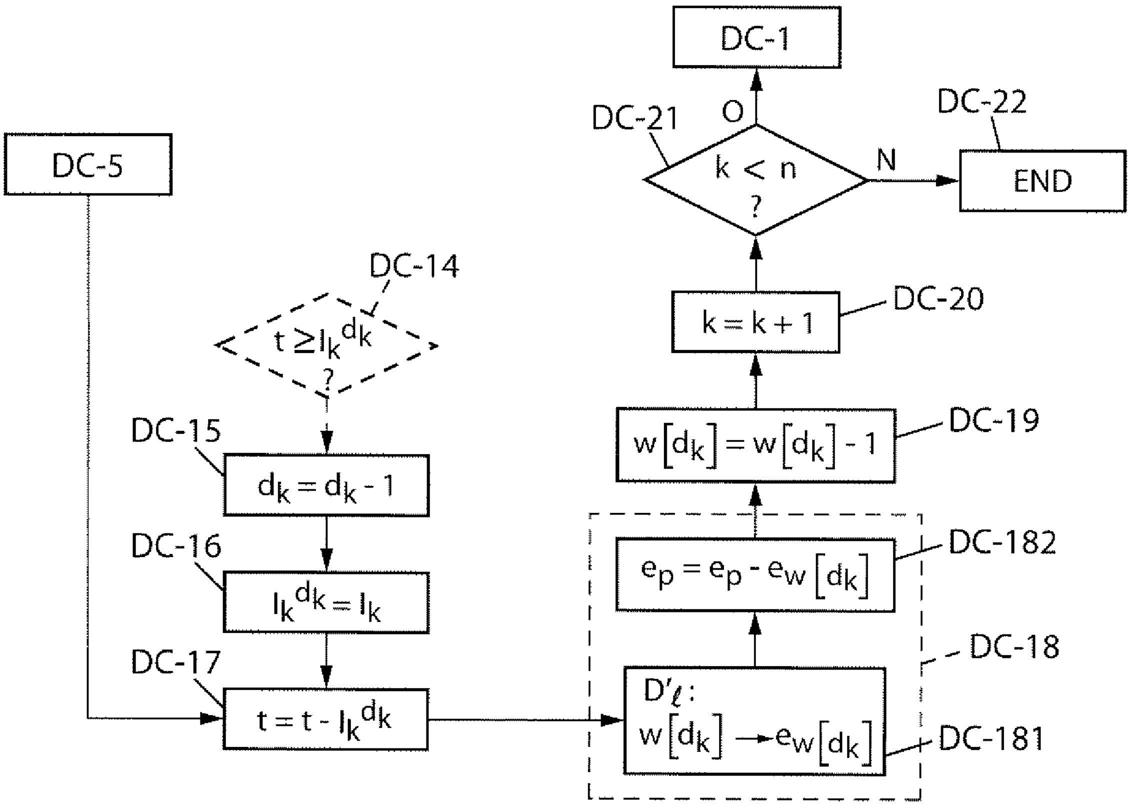
DC-1
DC-21
O
DC-22
k < n
?
N
END
DC-5
DC-14
t ≥ $l_k^{d_k}$
?
DC-20
k = k + 1
DC-15
$d_k = d_k - 1$
DC-19
$w[d_k] = w[d_k] - 1$
DC-16
$l_k^{d_k} = l_k$
DC-182
$e_p = e_p - e_w[d_k]$
DC-17
DC-18
$t = t - l_k^{d_k}$
D'ℓ :
$w[d_k] \rightarrow e_w[d_k]$
DC-181

FIG. 8
(SUITE)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 0400219 A


### Littérature non-brevet citée dans la description


- **SCHALKWIJK J.P.M.** An algorithm for source coding. *IEEE Trans. on Information Theory,* Mai 1972, vol. IT-18 (3), 395-399
- **RAGOT S. ; BESSETTE B. ; LEFEBVRE R.** Low-complexity multi-rate lattice vector quantization with application to wideband TCX speech coding at 32 kbit/s. *Proc. ICASSP,* Mai 2004, vol. 1, 501-4